(19) Europäisches Patentamt
European Patent Office
Office européen des brevets

(11) EP 0 543 613 B1

(12) EUROPEAN PATENT SPECIFICATION

(45) Date of publication and mention of the grant of the patent: **08.04.1998 Bulletin 1998/15**

(51) Int Cl.6: **G11C 11/409**

(21) Application number: **92310466.5**

(22) Date of filing: **17.11.1992**

# (54) Dynamic semiconductor memory device

Dynamische Halbleiterspeicheranordnung

Dispositif de mémoire dynamique à semi-conducteurs

(84) Designated Contracting States:
**DE GB**

(30) Priority: **18.11.1991 JP 329474/91**
**23.03.1992 JP 65122/92**
**10.11.1992 JP 299867/92**

(43) Date of publication of application:
**26.05.1993 Bulletin 1993/21**

(73) Proprietor: **KABUSHIKI KAISHA TOSHIBA**
**Kawasaki-shi, Kanagawa-ken 210 (JP)**

(72) Inventors:
- **Hasegawa, Takehiro, c/o Int. Property Division Minato-ku, Tokyo 105 (JP)**
- **Oowaki, Yukihito, c/o Int. Property Division Minato-ku, Tokyo 105 (JP)**
- **Masuoka, Fujio, c/o Int. Property Division Minato-ku, Tokyo 105 (JP)**
- **Ogiwara, Ryu, c/o Int. Property Division Minato-ku, Tokyo 105 (JP)**
- **Shiratake, Shinichirou, c/o Int. Property Division Minato-ku, Tokyo 105 (JP)**

(74) Representative: **Waldren, Robin Michael et al**
**MARKS & CLERK,**
**57-60 Lincoln's Inn Fields**
**London WC2A 3LS (GB)**

(56) References cited:
**EP-A- 0 453 959** **EP-A- 0 499 256**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 543 613 B1

**Description**

This invention relates to a dynamic semiconductor memory device (DRAM).

A DRAM having a memory cell array which is constructed by forming a plurality of NAND memory cell units each of which is constructed by a plurality of series-connected memory cells and connecting a plurality of memory cell units to bit lines is known in the prior art. In this memory cell array system, the number of bit line contacts can be made small in comparison with a system in which memory cells are individually connected to bit lines and therefore the cell area can be reduced.

With the above NAND cell array system, when data is read out from a memory cell of the memory cell unit which lies at a long distance from the bit line, data of memory cell or cells lying between the readout memory cell and the bit line must be destroyed. Therefore, it becomes necessary to use a register for temporarily holding the data of the memory cell unit and re-write the data (for example, refer to IEEE ISSCC DIGEST OF TECHNICAL PAPERS, VOL. 34, p106, TAM.2, 1991).

As the layout method for the above temporary storing register, a method of commonly using a register for a plurality of memory cell arrays is provided. In this method, a global bit line is arranged to cross a plurality of memory cell arrays, nodes of a plurality of sense amplifiers are connected to the global bit lines via transfer gates and a register is connected to one end of the global bit line.

However, in the above conventional system, it is necessary to charge and discharge the global bit line which has a larger capacitance than the bit line arranged in the memory cell array in order to re-write data which is temporarily stored in the register. Therefore, in the conventional DRAM, the power consumption in the data re-writing operation is large.

In the above NAND cell array system, since the cell area is small, the open bit line system may be effectively used. Therefore, in the cell array system, a pseudo-folded bit line system which is a modification of the open bit line system is proposed. This system is a system in which a dummy cell array arranged at the end portion of the memory block is commonly used by memory cell arrays in the memory block.

However, in this system, it is necessary to construct the dummy cell array by memory cell units each formed of a plurality of series-connected dummy cells in the same manner as in the memory cell array and therefore the area of the dummy cell array becomes large.

In the conventional ordinary DRAM in which each memory cell is connected to a corresponding one of bit line contacts, the operation of writing data into a memory cell from the exterior of the chip is effected at the same time of effecting the active restoring operation in which data is read out from a memory cell to a bit line pair, a potential difference is amplified to Vcc and Vss by a sense amplifier, data is transferred to a DQ line, and then data is re-written into the memory cell.

In the above system, the readout mode and write-in mode of the DRAM are not separated from each other and it is not necessary to provide a circuit for setting the mode. However, in this method, when data is read out from the memory cell to the bit line pair and data set in an inverted relation with respect to data obtained by amplifying a potential difference between Vcc and Vss by use of the sense amplifier is written from the exterior, the operation is active, and since the potentials Vcc and Vss on the two nodes of the sense amplifier for amplifying data from the memory cell to the potential difference between Vcc and Vss must be inverted to Vss and Vcc, respectively, the power consumption becomes large.

In addition, in the DRAM in which a memory cell unit formed of series-connected memory cells is connected to a bit line, the memory cells are serially so that data of the memory cell cannot be read out at random and at a high speed.

As described above, in the conventional DRAM in which a NAND memory cell unit is constructed by serially connecting a plurality of memory cells, it is necessary to charge and discharge the global bit line in order to re-write data and the power consumption becomes large. In the case of using the pseudo-folded bit line system, the cell area of the conventional DRAM is increased by an amount corresponding to the dummy cell array. Further, the memory cells are serially connected in the conventional DRAM, data of the memory cell cannot be read out at random and at a high speed.

In an ordinary DRAM in which each memory cell is connected to a corresponding one of bit line contacts, when data is written into the memory cell and data set in an inverted relation with respect to data obtained by amplifying a potential difference to Vcc and Vss by use of the sense amplifier is written from the exterior, the operation is active, and since the potentials Vcc and Vss on the two nodes of the sense amplifier for amplifying data from the memory cell to the potential difference between Vcc and Vss must be inverted to Vss and Vcc, respectively, the power consumption becomes large.

An object of this invention is to provide a DRAM which has memory cell units each constructed by serially connecting a plurality of memory cells and in which the power consumption is lowered and an erroneous readout operation can be prevented.

Another object of this invention is to provide a DRAM in which the power consumption at the time of writing data can be suppressed by controlling the operation of a first sense amplifier when data is written from the exterior and then writing the data into a memory cell.

This invention provides a dynamic semiconductor memory device comprising: a plurality of memory cell arrays ($1_1$, $1_2$) each constructed by a plurality of memory cell units which are each formed of a plurality of series-connected dynamic memory cells (MC), each memory cell array having a first bit line (BL, $\overline{BL}$) connected there-

to; a first transfer gate connected to each said first bit line (BL, $\overline{BL}$); at least one first sense amplifier arranged between adjacent memory cell arrays ($1_1$, $1_2$), the sense amplifier having a first and second data nodes ($N_1$, $N_2$), each data node being selectively connected via a first transfer gate to a different one of said first bit lines; at least one register arranged between said sense amplifier and said memory cell arrays and connected to at least one of said data nodes directly or via a second transfer gate, for temporarily storing memory cell data read out from a memory cell unit; and gate control means for controlling each said first transfer gates to selectively and electrically separate the first and second data nodes of said sense amplifier from each said first bit line in a case where data read out to one of said first bit lines is stored into said register from said sense amplifier.

According to this invention, when data to be re-written is stored into the register for temporarily storing memory cell data, the sense amplifier can be operated with the first bit line electrically separated therefrom by controlling the transfer gate provided between the register and the first bit line by means of the gate control means. That is, the operation of storing data into the register can be effected without charging or discharging the first bit line so that the power consumption of a NAND type DRAM can be reduced, occurrence of noise which may be caused on the first bit line in the cell array when the sense amplifying operation is effected can be prevented and the readout operation can be stably effected.

The DRAM according to an embodiment of this invention is characterized by further comprising a second bit line pair arranged to extend across said plurality of memory cell arrays and selectively connected to the second data node of said first sense amplifier; a switch connected to said second bit line pair, for controlling the operation of data transfer with respect to the exterior; a buffer for writing exterior data to said second bit line pair, a second sense amplifier for amplifying data read out from said memory cell; and control means for controlling said first sense amplifier, said switch and one of said buffer and said second sense amplifier to write data from said second bit line to said first bit line by use of said buffer and switch before said first sense amplifier is operated when exterior data is written via said second bit line.

According to the above embodiment of this invention, data from the exterior of the chip is amplified by the buffer of the second sense amplifier and transferred to the first bit line via the second bit line before the first sense amplifier is operated in a case where the data from the exterior is written into the memory cell via the second bit line. Therefore, the power consumption caused in a case where the potentials of the input/output nodes of the first sense amplifier which are set to Vcc and Vss must be inverted in the prior art technique can be reduced.

As described above, according to this invention, the temporarily storing registers are arranged adjacent to the sense amplifier disposed between the NAND memory cell arrays, the sense amplifier is operated with the bit line and global bit line electrically separated therefrom by controlling the transfer gate when memory cell data is stored into the register so that data can be stored into the register without charging and discharging the bit line, thereby making it possible to reduce the power consumption of the DRAM and suppress noise occurring at the readout time.

Further, the power consumption can be reduced by transferring data from the global bit line pair to the bit line pair without operating the first sense amplifier by use of the second sense amplifier or write-in buffer when data is written into the memory cell from the I/O register cell.

This invention can be more fully understood from the following detailed description when taken in conjunction with the accompanying drawings, in which:

Figs. 1 and 2 are diagrams showing the construction of a first embodiment of a DRAM according to this invention, that is, the construction of a DRAM of an embodiment in which a register is provided on one side of a sense amplifier;
Figs. 3A and 3B are diagrams respectively showing the constructions of a NAND memory cell unit and a register in the first embodiment;
Figs. 4 and 5 are timing diagrams for illustrating the data readout operation of the first embodiment;
Fig. 6 is a diagram showing the construction of a data transfer system control circuit in the first embodiment;
Fig. 7 is a diagram showing the construction of an I/O register cell in the first embodiment;
Figs. 8 to 12 are diagrams showing the concrete constructions of portions of the data transfer system control circuit shown in Fig. 6;
Figs. 13A and 13B are diagrams respectively showing the concrete constructions of clocked inverters $N_{11}$ and $N_{12}$;
Fig. 14 is a diagram showing the operation waveforms obtained at respective nodes when data is stored on the bit line pair from the I/O register;
Fig. 15 is a diagram showing another example of the construction of the data transfer system control circuit of Fig. 6;
Fig. 16 is a diagram showing another example of the construction of the I/O register cell of Fig. 7;
Fig. 17 is a diagram showing another example of the construction of Fig. 8;
Fig. 18 is a diagram showing another example of the construction of Fig. 12;
Fig. 19 is a diagram showing the operation waveforms obtained at respective nodes in the construction of Figs. 15 and 16;
Fig. 20 is a diagram showing a first modification of Fig. 1;

Fig. 21 is a diagram showing a second modification of Fig. 1;

Figs. 22 and 23 are diagrams showing the construction of a second embodiment of a DRAM according to this invention, that is, the construction of a DRAM of an embodiment in which registers are provided on both sides of a sense amplifier;

Figs. 24 and 25 are timing diagrams for illustrating the data readout operation of the second embodiment;

Figs. 26 and 27 are diagrams showing the construction of a DRAM of a first modification of the second embodiment in which the registers are provided on both sides of the sense amplifier;

Figs. 28 and 29 are timing diagrams for illustrating the data readout operation of the first modification of the second embodiment;

Figs. 30A and 30B are diagrams respectively showing examples of the construction of the memory cell of the register in the first modification of the second embodiment;

Figs. 31 and 32 are diagrams showing the construction of a DRAM of a second modification of the second embodiment in which the registers are provided on both sides of the sense amplifier;

Figs. 33 and 34 are timing diagrams for illustrating the data readout operation of the second modification of the second embodiment;

Figs. 35 and 36 are diagrams showing the construction of a DRAM of a third modification of the second embodiment in which the registers are provided on both sides of the sense amplifier;

Figs. 37 and 38 are timing diagrams for illustrating the data readout operation of the third modification of the second embodiment;

Figs. 39 and 40 are diagrams showing the construction of a DRAM of a fourth modification of the second embodiment in which the registers are provided on both sides of the sense amplifier;

Figs. 41 and 42 are diagrams showing the construction of a DRAM of a fifth modification of the second embodiment in which the registers are provided on both sides of the sense amplifier;

Figs. 45 and 46 are circuit diagrams of a circuit for generating a basic signal used for controlling signals in Figs. 41 and 42;

Fig. 47 is a timing diagram for illustrating the readout operation in the circuit of Figs. 45 and 46;

Fig. 48 is a timing diagram for illustrating the re-writing operation in the circuit of Figs. 45 and 46;

Fig. 49 is a diagram for illustrating the process of determining the readout order of signals in Figs. 41 and 42;

Fig. 50 is a diagram for illustrating the process of determining the write-in order of signals in Figs. 41 and 42;

There will now be described an embodiment of this invention with reference to the accompanying drawings.

Figs. 1 and 2 are diagrams showing the construction of a first embodiment of a DRAM according to this invention, that is, the construction of a DRAM of an embodiment in which a register is provided on one side of a sense amplifier. This embodiment shows an example in which one memory cell unit is constructed by serially connecting four memory cells MC. The concrete construction of the memory cell is shown in Fig. 3A. As shown in Figs. 1 and 2, memory cell arrays $1_1$ and $1_2$ each having a plurality of memory cell units are arranged on both sides of a sense amplifier 3. Dummy cell arrays $2_1$ and $2_2$ are respectively connected to one-side end portions of the memory cell arrays $1_1$ and $1_2$. The dummy cell array may be same construction as the memory cell unit which is constructed by serially connecting four memory cells. The memory cell MC and dummy cell DC are each formed with the one-transistor/one-capacitor structure which is used in an ordinary DRAM.

The sense amplifier 3 includes a CMOS flip-flop which is constructed by nMOS transistors $Q_{51}$ and $Q_{52}$ and pMOS transistors $Q_{53}$ and $Q_{53}$. An equalizer circuit 8 is provided adjacent to the sense amplifier 3. The equalizer circuit 8 includes precharge nMOS transistors $Q_{41}$ and $Q_{42}$ and an equalizing pMOS transistor $Q_{43}$.

A re-writing register 5 is arranged between the memory cell array $1_1$ which is one of the two memory cell arrays and the sense amplifier 3 and equalizer circuit 8. In this embodiment, as shown in Fig. 3B, the register 3 is formed with the same construction as that of the memory cell MC used in the memory cell array. Further, in the register 5, four memory cells which are selected by register word lines $RWL_0$ to $RWL_3$ for respective data nodes $RBL_0$ to $RBL_3$ are arranged in positions corresponding to four memory cells MC selected by word lines $WL_0$ to $WL_3$.

Four bit lines $BL_0$ to $BL_3$ of the memory cell array $l_1$ which is one of the two memory cell arrays are respectively connected to the data nodes $RBL_0$ to $RBL_3$ of the register 5 via four nMOS transistors $Q_{11}$ to $Q_{14}$ of a transfer gate 4. The data nodes $RBL_0$ to $RBL_3$ of the register 5 are connected to a common connection node via respective nMOS transistors $Q_{21}$ to $Q_{24}$ of a transfer gate 6 and the common connection node is connected to a data node N1 which is one of the two data nodes of the sense amplifier 3. Four bit lines $/BL_0$ to $/BL_3$ of the other memory cell array 12 are connected to a common connection node via respective nMOS transistors $Q_{61}$ to $Q_{64}$ of a transfer gate 9 and the common connection node is connected to the other data node $N_2$ of the sense amplifier 3.

The data nodes $N_1$ and $N_2$ of the sense amplifier 3 are respectively connected to global bit lines GBL and /GBL via nMOS transistors $Q_{31}$ and $Q_{32}$ of a transfer gate 7. The global bit lines GBL and /GBL are arranged to extend across the memory cell arrays $1_1$ and $1_2$ and are connected to data input/output lines (not shown). The transfer gate 7 for the global bit lines is shown in Figs. 1 and 2 for easy understanding of the connection relation between circuit portions respectively shown in Figs. 1 and 2 which are connected to each other in practice.

A read/write gate control circuit 10 serves to control the transfer gates 4, 6, 7 and 9 in response to a clock. The gate control circuit 10 basically controls the transfer gates 4 and 6 so that only data of a selected bit line among data items read out from the memory cells to bit lines can be transferred to the data nodes of the sense amplifier 3 and re-written into a corresponding data node of the register 5 with the bit lines electrically separated therefrom.

Figs. 4 and 5 show concrete waveforms for illustrating the data re-write operation for re-writing data read out by the readout operation of the first embodiment into the re-writing register 5. In this example, the explanation is made with much attention paid to the first bit of the memory cell unit to be selected by the word line $WL_0$.

Before data readout, transfer gate control signal lines $\phi_{t0}$ to $\phi_{t3}$ and $\phi_{tR0}$ to $\phi_{tR3}$ are all set to the "H" level and an equalization control signal line $V_{BLEQ}$ is set to the "H" level, and as a result, the bit lines, the node of the register 5 and the nodes of the sense amplifier 3 are precharged to (1/2)Vcc, for example, by means of the equalizing circuit 8. After this, the control signal lines $\phi_{tR1}$, $\phi_{tR2}$, $\phi_{tR3}$, $\phi_{tR5}$, $\phi_{tR6}$ and $\phi_{tR7}$ are set to the "L" level, and only the bit lines $BL_0$ and $/BL_0$ are respectively connected to the nodes $N_1$ and $N_2$ of the sense amplifier 3.

In this condition, the word line is selectively driven. In this case, the potential of the word line $WL_0$ on the side of the memory cell array 11 rises and data items of memory cells arranged along the word line $WL_0$ are read out to the bit lines $BL_0$ to $BL_3$. At this time, the potential of the dummy word line DWL1 of the dummy cell array $2_1$ falls. This is because coupling noises caused on the bit lines by the fall of the potential of the word line $WL_0$ are canceled. Since the dummy cell line $DWL_2$ of the dummy cell array 22 on the side of the other memory cell array $1_2$ is kept at the "H" level, data of the dummy cell array $2_2$ is read out to the bit lines $/BL_0$ to $/BL_3$.

Only the data items of the bit lines $BL_0$ and $/BL_0$ among the data items of the bit lines $BL_0$ to $BL_3$ and $/BL_0$ to $/BL_3$ are transferred to the nodes $N_1$ and $N_2$ of the sense amplifier 3. After this, the control signal lines $\phi_{tR0}$, $\phi_{t4}$ and $\phi_{t0}$ are sequentially set to the "L" level to electrically separate the bit lines which have been connected to the sense amplifier 3 and electrically separate the register 5 from the bit lines and sense amplifier 3. In this condition, the amplifying operation of the sense amplifier 3 is effected.

After this, the control signal line $\phi_{tR0}$ is set to the "H" level again to connect the node $N_1$ of the sense amplifier 3 to the node $RBL_0$ of the register 5 so as to permit data read out from the bit line $BL_0$ to be written into a selected memory cell of the register 5. At this time, the control signal line $RWL_0$ among the control signal lines $RWL_0$ to $RWL_3$ is set at the "H" level and data is re-written into the memory cell selected by the control signal line.

The same operation is repeatedly effected to permit data items selected by the word line $WL_0$ and read out to the bit lines $BL_0$, $BL_1$, $BL_2$ and $BL_3$ to be sequentially transferred to the sense amplifier 3 and re-written into the four memory cells of the register 4 which are controlled by the control signal line $RWL_0$.

Re-writing into the memory cell from the re-writing register 5 performs that the data are written into memory cell block 1 by opening the transfer gate 4, after the sense amplifier 3 is operated by opening transfer gate 6 arranged on the bit line and connected the memory cell to be re-written to amplify the data of the register cell 5. The transfer gate connected the memory cell to be re-written can be opened after operating the sense amplifier 3.

Although not indicated by the above operation waveforms, if the word line $WL_1$ is selected, data items of the memory cells arranged along the word line $WL_0$ are first read out and re-written into the memory cells of the register arranged along the control signal line $RWL_0$, and then data items of the memory cells arranged along the word line $WL_1$ are re-written into the memory cells of the register arranged along the control signal line $RWL_1$.

During the operation of reading out the data items from the memory cell array to the re-writing register, the global bit lines GBL and /GBL are electrically separated from the data nodes $N_1$ and $N_2$ of the sense amplifier 3, and while the sense amplifier 3 is operated to write data into the register 5 as described above, the bit lines BL and /BL are electrically separated from the data nodes $N_1$ and $N_2$ of the sense amplifier 3. Therefore, according to this embodiment, it is not necessary to charge and discharge the bit lines and global bit lines during the operation of writing data into the register and the power consumption can be reduced.

Fig. 6 is a diagram showing the construction of the data transfer system circuit of the first embodiment, and the data transfer system circuit for latching data read out from the bit line into the I/O register and writing data from the I/O register to a bit line pair. Fig. 7 is a diagram showing the construction of the I/O register cell of the first embodiment and a diagram showing data transfer control circuit 58. Each of the data transfer system circuit and an I/O register cell is provided one for each global bit line pair and a preset number of sense amplifiers 3.

The data transfer system includes a read gate 51 constructed by nMOS transistors $Q_{71}$ and $Q_{72}$, a register sense amplifier 52 constructed by pMOS transistors $Q_{81}$, $Q_{91}$ and $Q_{92}$ and nMOS transistors $Q_{93}$, $Q_{94}$ and $Q_{82}$, a global bit line equalizing circuit 53 constructed by nMOS transistors $Q_{10,1}$, $Q_{10,2}$, and $Q_{10,3}$, a write-in buffer 54 constructed by clocked inverters $N_{11}$ and $N_{12}$, and an I/O data register $\phi_t$ gate circuit 55 constructed by nMOS transistors $Q_{11,1}$ and $Q_{11,2}$.

An I/O register cell includes a latch circuit 56 constructed by inverters $N_{22}$ and $N_{23}$. A transfer gate con-

structured by nMOS transistors $Q_{12,1}$ and $Q_{12,2}$ controls data to transfer to an I/O via a DQ line pair of the I/O register cell 56.

A control circuit 58 serves to control the transfer gates 51 to 55 according to data transfer control circuit driving signals BCEND and VWRACP, and the concrete construction thereof is shown in Figs. 8 to 12. The data transfer system control circuit 58 generally serves to control the gate GNLEQ of the global bit line pair equalizing circuit 53 so as to release the paired global bit lines from the equalized state at the readout time, and when data of the memory cell is read out to the global bit line pair, it controls the read gate RGATE of the read gate control circuit 51 to turn off the transistors $Q_{71}$ and $Q_{72}$, controls RSEP and RSEN of the register sense amplifier 52 to amplify the potential difference between the paired global bit lines, and controls PHITR of the I/O register $\phi_t$ gate circuit 55 to turn on the transistors $Q_{11,1}$ and $Q_{11,2}$ so as to cause data to be written into the I/O register cell 56. At this time, the operation of the write-in buffer 54 is kept interrupted by controlling WBUFE and BWBUFE.

On the other hand, when data is written from the I/O register into the memory cell, data of the I/O register cell 56 is read out to $GBL_1$ and $/GBL_1$ by controlling PHITR of the I/O register $\phi_t$ gate circuit 55, and then the readout data is transferred to the succeeding stage by controlling WBUFE and BWBUFE of the write-in buffer 54 and written into the bit line pair via the global bit line pair (GBL and /GBL). At this time, the read gate circuit 51, register sense amplifier circuit 52 and global bit line equalizing circuit 53 are kept deactivated by controlling the respective gates.

A difference between the above embodiment and the conventional DRAM in the operation of writing data from the I/O register cell 56 into the memory cell is that the sense amplifier 3 of Fig. 2 is not operated and the power consumption is reduced when inverted potentials of the potentials of the nodes $N_1$ and $N_2$ are written unlike the case wherein the sense amplifier 3 is operated.

Figs. 13A and 13B show the clocked inverters of $N_{11}$ and $N_{12}$ used as the buffer circuit 54. Figs. 13A and 13B respectively correspond to the inverters $N_{11}$ and $N_{12}$.

Fig. 14 shows the operation waveforms obtained at respective nodes when data is stored on the bit line pair from the I/O register. More specifically, Fig. 14 shows the operation waveforms obtained when potentials Vcc and Vss are respectively held on nodes $N_5$ and $N_6$ of the I/O register cell 56 and the potentials are stored on the nodes $N_1$ and $N_2$ of the sense amplifier 3.

First, WBUFE and BWBUFE are respectively set to the "H" and "L" potential levels so as to write data from the I/O register onto the global bit line pair. That is, the write mode is set.

Secondly, it is assumed that the write-in operation effected at this time utilizes the active restore effected at the time of the readout operation. That is, $N_1$ and $N_2$ are equalized and set to (1/2)Vcc, and the potential of the register word line RWLn (n = 0, 1, 2, 3) rises to permit data of the register cell to be read out onto the bit line. If the active restore is the operation effected at the readout time, data on the bit line pair is amplified since the sense amplifier is operated, but since the operation of the sense amplifier 3 is interrupted in this case, the data is not amplified.

Thirdly, the potential of the I/O register is transmitted to the global bit line pair by applying the potential "H" to PHITR. Further, data is transmitted to the bit line pair from the global bit line pair by setting $\phi_{tGBL}$ to the "H" level and is written into the nodes $N_1$ and $N_2$.

Fourthly, when $\phi_{tn}$ (n = 0, 1, 2, 3) of the transfer gate 4 is set to "H", data of $N_1$ and $N_2$ is written into the memory cell $I_1$. At this time, potentials Vcc and Vss are not applied from the exterior to the nodes SAP and /SAN of the sense amplifier 3 and the sense amplifier 3 is not operated. Therefore, unlike the conventional DRAM, since the sense amplifier 3 is not operated and the potentials Vcc and Vss of the nodes are not changed to Vss and Vcc when data is written into the odes $N_1$ and $N_2$, the power consumption can be reduced.

Another example of the data transfer system and I/O register is explained. The basic construction of the DRAM is the same as that of the former embodiment, but this embodiment is different from the former embodiment in the following respects. In the former embodiment, the write-in buffer 54 is used when data is written from the I/O register into the memory cell, but in this embodiment, the register sense amplifier 52 is used to effect the write-in operation. For this purpose, the data transfer system and I/O register cell are constructed as shown in Figs. 15 and 16. In Figs. 15 and 16, this embodiment is different from the former embodiment in that the buffer 14 is omitted. Further, the data transfer system control circuit 58' controls the gates PHITR, RGATE, RSEN, RSEP and GBLEQ in addition to the control process described above.

The construction of the data transfer system control circuit 58' is basically the same as that shown in Figs. 8 to 12, but a circuit for creating WBUFE and BWBUFE in the portion of Fig. 8 is omitted as shown in Fig. 17 and the portion of Fig. 12 is modified as shown in Fig. 18.

In this embodiment, the operation of reading out data from the memory cell into the I/O register is effected in exactly the same manner as in the former embodiment. When data is written into the memory cell from the I/O register, PHITR is first set to the "H" potential so as to permit the potentials of the I/O register to be transmitted to GBL and /GBL.

Secondly, RSEP and RSEN are respectively set to the "L" and "H" potentials so as to permit the potential difference between GBL and /GBL to be amplified. Thirdly, $\phi_{tGBL}$ is set to the "H" potential to permit data to be transmitted from the global bit line pair to the bit line pair and written into the nodes $N_1$ and $N_2$. At this time, like the former embodiment, the sense amplifier 3 is not operated in this embodiment and the power consumption can be reduced in comparison with the conventional DRAM.

Fig. 19 shows the operation waveforms obtained at respective nodes in the construction of Figs. 15 and 16. Unlike the construction of Figs. 6 and 7, in this embodiment, RSEP and RSEN are respectively set to the "L" and "H" potentials so as to permit data from the I/O register to be amplified by a register sense amplifier 52. The other portion is the same as the corresponding portion of the construction of Figs. 6 and 7. In this case, RGATE is applied with the "H" potential.

Fig. 20 shows a first modification in which the construction of the register 5 in the embodiment of Fig. 1 is made by two series-connected memory cells instead of two parallel-connected memory cells. Fig. 21 shows a second modification in which the register 5 is constructed by four series-connected memory cells like the memory cell array.

In the above embodiment, the re-writing register is provided only on one side of the sense amplifier, that is, on the side of the bit line BL, but it is possible to symmetrically arrange re-writing registers on the sides of both of the bit lines BL and /BL. With this arrangement, data having an inverted relation with respect to data written into the register on the bit line BL side is written into the register on the bit line /BL side. In this case, the potential of (1/2)Vcc can be created by equalizing the re-writing registers on the bit line BL side and on the bit line /BL side in the precharge/equalize operation of the re-writing registers.

Figs. 22 and 23 are diagrams showing the construction of a second embodiment of a DRAM according to this invention, that is, the construction of a DRAM of an embodiment in which registers are provided on both sides of the sense amplifier. Portions corresponding to those of the first embodiment in Figs. 1 and 2 are denoted by the same reference numerals used in Figs. 1 and 2. In this embodiment, the number of bit lines of a re-writing register section is 2 and re-writing registers $5_1$ and $5_2$ are symmetrically arranged on both sides of the sense amplifier 3. In Fig. 23, a dummy cell array on the side of the memory cell array $1_2$ is omitted.

In the first embodiment, the register 5 is arranged only on one side of the sense amplifier 3 and data of each of the memory cell arrays $1_1$ and $1_2$ is written into the register 5. However, in this embodiment, data of the memory cell array $1_1$ may be written into the register $5_1$ and data of the memory cell array $1_2$ be written into the register $5_2$. That is, data read out onto the bit lines $BL_0$ to $BL_3$ via the word line $WL_0$ of the memory cell array $1_1$ is written into four memory cells arranged along the register word lines $RWL_0$ and $RWL_1$ of the register $5_1$. Data read out onto the bit lines $BL_0$ to $BL_3$ via the word line $WL_1$ is written into four memory cells arranged along the register word lines $RWL_2$ and $RWL_3$ of the register $5_1$. Likewise, the register word lines $RWL_4$ and $RWL_5$ and the register word lines $RWL_6$ and $RWL_7$ are selected according to the word lines $WL_2$ and $WL_3$ used for data readout. The relation between the memory cell array $1_2$ and the register $5_2$ is the same as that between the memory cell array $1_1$ and the register $5_1$.

As an another method, a cell data may be stored to both side of the registered with a manner of a complementary signals. That is, a datum is stored by using each one bit of both side of the registers. In this arrangement, since capacities of signal nodes $N_1$ and $N_2$ of a sense amplifier and the register word lines $RBL_1$ and $/RBL_1$, stable operation can be attained.

In the case of this embodiment, the transfer gate control operation by the gate control circuit 10 is basically the same as in the former embodiment. That is, the control operation of setting the control signal lines $\phi_{t0}$ to $\phi_{t7}$, $\phi_{tR0}$ and $\phi_{tR1}$ to the low potential level when memory cell data is read out to the bit line, raising the potentials of the transfer gate control signal lines (one of $\phi_{t0}$ to $\phi_{t3}$ and one of $\phi_{t4}$ to $\phi_{t7}$) of the bit line pair for readout and lowering the potentials of the transfer gate control signal lines of the bit line pair for readout before the sense amplifier 3 is operated and the control operation of raising the potential of the control signal line (one of $\phi_{tR0}$ and $\phi_{tR1}$) of the register for write-in after the sense amplifier 3 is operated and a potential difference between the paired bit lines BL and /BL becomes sufficiently large and lowering the same after data is written into the memory cell of the register are effected.

Figs. 24 and 25 show an example of operation waveforms of the second embodiment. Also, in this embodiment, an example in which the first one-bit data of four memory cells series-connected in the same manner as in the first embodiment is read out is explained, but the other bit can be read out by changing the address.

Figs. 26 and 27 are diagrams showing the construction of a DRAM of a first modification of the second embodiment in which the registers are provided on both sides of the sense amplifier. In this modification, the transfer gates arranged between the register 51 and 52 on one hand and the nodes $N_1$ and $N_2$ of the sense amplifier 3 on the other in Figs. 22 and 23 are removed.

Memory cell data items selected by the word line $WL_0$ and read out to the bit lines $BL_0$ to $BL_3$ are sequentially re-written into memory cells in the register 51 by use of the register word lines $RWL_{15}$, $RWL_{14}$, $RWL_{13}$ and $RWL_{12}$. The operation waveforms of this modification are shown in Figs. 28 and 29. The transfer gate control operation by he gate control circuit 10 is effected in basically the same manner as in the second embodiment, and when data is written into the register, the bit lines and global bit lines are electrically separated from the data nodes of the sense amplifier.

Figs. 30A and 30B show examples of the construction of the memory cell of the register used in the first modification of the first embodiment. The memory cell of the register may be a charge storage type memory cell having the same construction as the memory cell in the memory cell array as shown in Fig. 30A or as a memory cell constructed by three transistors as shown in Fig.

30B. Further, an SRAM cell can be used as the memory cell of the register. When the SRAM cell is used as the memory cell of the register, a stable write-in operation can be attained if the write-in circuit is constructed to write data items which are set in the inverted relation from both of the bit lines BL and /BL into the nodes D and /D of the DRAM cell.

Figs. 31 and 32 are diagrams showing the construction of a DRAM of a second modification of the second embodiment in which the registers are provided on both sides of the sense amplifier. In this modification, the capacity of the registers $5_1$ and $5_2$ is set to half of the capacity in the embodiment of Figs. 22 and 23. In the case of this modification, data items of the bit lines $BL_0$ and $BL_1$ among the data items read out to the bit lines $BL_0$ to $BL_3$ by means of the word line $WL_0$ are written into memory cells arranged along the register word line $RWL_0$ of the register $5_1$ arranged on the same side and data items of the bit lines $BL_3$ and $BL_4$ are written into memory cells arranged along the register word line $RWL_4$ of the register $5_2$ arranged on the opposite side. The waveforms obtained in this case are shown in Figs. 33 and 34. Also, in this modification, the basic transfer gate control operation effected by the gate control circuit 10 is the same as in the case shown in Figs. 22 and 23, and when data is written into the register 5, the bit lines and global bit lines are electrically separated from the sense amplifier nodes.

With the construction in which the bit lines BL and /BL are connected to bit lines in the re-writing register having the same capacity as in this modification, the (1/2)Vcc precharge operation after data is written into the re-writing register can be easily attained by directly connecting the bit lines $RBL_0$ and $RBL_1$ in the register to the respective bit lines $/RBL_0$ and $/RBL_1$.

Figs. 35 and 36 are diagrams showing the construction of a DRAM of a third modification of the second embodiment in which the registers are provided on both sides of the sense amplifier and shows an embodiment in which the capacity of the registers $5_1$ and $5_2$ is set to half of the original capacity. In the case of this modification, data items of the bit lines $BL_0$ and $BL_1$ among the data items read out to the bit lines $BL_0$ to $BL_3$ by means of the word line $WL_0$ are written into memory cells arranged along the along the register word lines $RWL_{15}$ and $RWL_{14}$ of the register $5_2$ arranged on the opposite side and data items of the bit lines $BL_3$ and $BL_4$ are written into memory cells arranged along the register word lines $RWL_7$ and $RWL_8$ of the register $5_1$ arranged on the same side. The operation waveforms obtained at this time are shown in Figs. 37 and 38. Also, in this modification, the transfer gate control operation by the gate control circuit 10 is effected in the same manner as in the case shown in Figs. 22 and 23, and the bit lines and the global bit lines are electrically separated from the sense amplifier nodes at the time of writing data into the register 5.

Figs. 39 and 40 are diagrams showing the construction of a DRAM of a fourth modification of the second embodiment in which the registers are provided on both sides of the sense amplifier. In the third modification shown in Figs. 35 and 36, the data nodes of the registers $5_1$ and $5_2$ are commonly connected to the respective nodes $N_1$ and $N_2$ of the sense amplifier 3, but in this modification, two data nodes of the register $5_1$ are respectively connected to the two nodes $N_1$ and $N_2$ of the sense amplifier 3 and two data nodes of the register $5_2$ are respectively connected to the two nodes $N_1$ and $N_2$ of the sense amplifier 3.

Also, in this modification, the control operation of separately writing data items read out to the bit lines $BL_0$ to $BL_3$ by means of the word line $WL_0$, for example, into the register 51 arranged on the same side and into the register $5_2$ arranged on the opposite side. In this case, noises induced on the nodes $N_1$ and $N_2$ via the nodes of the register can be canceled.

Figs. 41 and 42 are diagrams showing the construction of a DRAM of a fifth modification of the second embodiment in which the registers are provided on both sides of the sense amplifier.

Figs. 45 and 46 are circuit diagrams of the read/write gate control circuit shown in Fig. 41. Figs. 47 and 48 are timing diagrams showing the readout and re-write timings. Fig. 47 shows basic timings of various signals in the readout operation and Fig. 48 shows basic timings of various signals in the re-writing operation. The timings are determined based on the basic clock CK for reading one bit. Further, the order of reading 16 bits may be determined by counting CK and decoding to-be-selected word lines (WLi), $\phi_{tk}$ and RWLi according to the counting state as shown in Fig. 49. Fig. 50 shows the writing order in the same manner as shown in Fig. 49. 16-bit data can be read out by use of a combination of timing signals of one cycle shown in Figs. 47 and 48 and the orders shown in Figs. 49 and 50.

In the read/write gate control circuits 10 shown in Figs. 1, 20, 21, 22, 26, 31, 35 and 39, the control terminals thereof are slightly different from one another.

This invention is not limited to the above embodiments and can be variously modified without departing from the technical scope thereof.

**Claims**

1. A dynamic semiconductor memory device comprising:

   a plurality of memory cell arrays ($1_1$, $1_2$) each constructed by a plurality of memory cell units which are each formed of a plurality of series-connected dynamic memory cells (MC), each memory cell array having a first bit line (BL, $\overline{BL}$) connected thereto;

   a first transfer gate (4, 9) connected to each said first bit line (BL, $\overline{BL}$);

at least one first sense amplifier (3) arranged between adjacent memory cell arrays ($1_1$, $1_2$), the sense amplifier (3) having first and second data nodes ($N_1$, $N_2$), each data node being selectively connected via a first transfer gate (4, 9) to one of said first bit lines;

at least one register (5) arranged between said sense amplifier and said memory cell arrays and connected to at least one of said data nodes directly or via a second transfer gate (6), for temporarily storing memory cell data read out from a memory cell unit; and

gate control means (10) for controlling each said first transfer gate (4, 9) to selectively and electrically separate the first and second data nodes ($N_1$, $N_2$) of said sense amplifier (3) from each said first bit line in a case where data read out to one of said first bit lines is stored into said register (5) from said sense amplifier (3).

2. A dynamic semiconductor memory device according to claim 1, characterized in that the or each said register (5) is constructed by memory cells same as a plurality of memory cells connected to said first bit line.

3. A dynamic semiconductor memory device according to claim 1, characterized in that the or each said register (5) is constructed by memory cells same as memory cells connected in a serial form and connected to said first bit line.

4. A dynamic semiconductor memory device according to claim 1, characterized by further comprising:

a third transfer gate (7) connected to each of said data nodes of said sense amplifier;

a second bit line pair (GBL, /GBL) connected to said third transfer gate; and

a second register (60) for storing said memory cell data via said second bit line pair.

5. A dynamic semiconductor memory device according to claim 4, characterized by further comprising a data transfer circuit (58, 58') connected between said second register and said second bit line.

6. A dynamic semiconductor memory device according to claim 1, characterized by further comprising:

a second bit line pair (GBL, /GBL) arranged to extend across said plurality of memory cell arrays and selectively connected to the second data node of said first sense amplifier;

a switch (7) connected to said second bit line pair (GBL, $\overline{GBL}$), for controlling the operation of data transfer with respect to the exterior;

a buffer (54) for writing exterior data to said second bit line pair;

a second sense amplifier (52) for amplifying data read out from said memory cell; and

control means (58) for controlling said first sense amplifier, said switch and one of said buffer and said second sense amplifier to write data from said second bit line to said first bit line by use of said buffer and switch before said first sense amplifier is operated when exterior data is written via said second bit line.

7. A dynamic semiconductor memory device according to claim 1, characterized by further comprising:

a second bit line pair (GBL, /GBL) arranged to extend across said plurality of memory cell arrays and selectively connected to the second data node of said first sense amplifier;

a switch (7) connected to said second bit line, for controlling the operation of data transfer with respect to the exterior of this device;

a second sense amplifier (52) for amplifying exterior data and writing the data into said second bit line; and

control means (58) for controlling said first sense amplifier, said switch and said second sense amplifier to write data from said second bit line to said first bit line by use of said amplifier means and switch before said first sense amplifier is operated when exterior data is written via said second bit line.

**Patentansprüche**

1. Dynamische Halbleiterspeichervorrichtung mit:

einer Vielzahl von Speicherzellenarrays ($1_1$, $1_2$), die jeweils durch eine Vielzahl von Speicherzelleneinheiten gebildet werden, welche jeweils aus einer Vielzahl von in Reihe verbundenen dynamischen Speicherzellen (MC) gebildet sind, wobei jedes Speicherzellenarray eine erste Bitleitung (BL, /BL) aufweist, die damit verbunden ist;

einem ersten Transfer- bzw. Übertragungsgate (4, 9), das mit jeder ersten Bitleitung (BL, /BL) verbunden ist;
zumindest einem ersten Leseverstärker (3), der zwischen benachbarten Speicherzellenarrays ($1_1$, $1_2$) angeordnet ist, wobei der Leseverstärker (3) erste und zweite Datenknoten ($N_1$, $N_2$) aufweist, wobei jeder Datenknoten über ein erstes Übertragungsgate (4, 9) mit einer der ersten Bitleitungen selektiv verbunden ist;
zumindest einem Register (5), das zwischen dem Leseverstärker und den Speicherzellenarrays angeordnet und mit zumindest einem der Datenknoten direkt oder über ein zweites Übertragungsgate (6) verbunden ist, zum vorübergehenden Speichern von aus einer Speicherzelleneinheit ausgelesenen Speicherzellendaten; und
einer Gate-Steuereinrichtung (10) zum Steuern jedes ersten Übertragungsgates (4, 9), um die ersten und zweiten Datenknoten ($N_1$, $N_2$) des Leseverstärkers (3) von jeder ersten Bitleitung in einem Fall selektiv und elektrisch zu trennen, in dem auf eine der ersten Bitleitungen ausgelesene Daten vom Leseverstärker (3) in das Register (5) gespeichert werden.

**2.** Dynamische Halbleiterspeichervorrichtung nach Anspruch 1, dadurch gekennzeichnet, daß das oder jedes Register (5) durch Speicherzellen aufgebaut ist, die die gleichen wie eine Vielzahl von mit der ersten Bitleitung verbundenen Speicherzellen sind.

**3.** Dynamische Halbleiterspeichervorrichtung nach Anspruch 1, dadurch gekennzeichnet, daß das oder jedes Register (5) durch Speicherzellen aufgebaut ist, die die gleichen wie in einer seriellen Form verbundene und mit der ersten Bitleitung verbundene Speicherzellen sind.

**4.** Dynamische Halbleiterspeichervorrichtung nach Anspruch 1, gekennzeichnet, indem ferner aufweisend:

ein drittes Übertragungsgate (7), das mit jedem der Datenknoten des Leseverstärkers verbunden ist;
ein zweites Bitleitungspaar (GBL, /GBL), das mit dem dritten Übertragungsgate verbunden ist; und
ein zweites Register (60) zum Speichern der Speicherzellendaten über das zweite Bitleitungspaar.

**5.** Dynamische Halbleiterspeichervorrichtung nach Anspruch 4 gekennzeichnet, indem ferner eine zwischen das zweite Register und die zweite Bitleitung gekoppelte Datenübertragungsschaltung (58, 58') aufweisend.

**6.** Dynamische Halbleiterspeichervorrichtung nach Anspruch 1, gekennzeichnet, indem ferner aufweisend:

ein zweites Bitleitungspaar (GBL, /GBL), das so angeordnet ist, daß es über die Vielzahl von Speicherzellenarrays verläuft, und mit dem zweiten Datenknoten des ersten Leseverstärkers selektiv verbunden ist;
einen Schalter (7), der mit dem zweiten Bitleitungspaar (GBL, /GBL) verbunden ist, zum Steuern der Operation einer Datenübertragung bezüglich der Außenwelt;
einen Puffer (54) zum Schreiben von äußeren bzw. externen Daten in das zweite Bitleitungspaar;
einen zweiten Leseverstärker (52) zum Verstärken von aus der Speicherzelle ausgelesenen Daten; und
eine Steuereinrichtung (58) zum Steuern des ersten Leseverstärkers, des Schalters und entweder des Puffers oder des zweiten Leseverstärkers, um Daten von der zweiten Bitleitung zur ersten Bitleitung unter Verwendung des Puffers und Schalters zu schreiben, bevor der erste Leseverstärker betrieben wird, wenn externe Daten über die zweite Bitleitung geschrieben werden.

**7.** Dynamische Halbleiterspeichervorrichtung nach Anspruch 1, gekennzeichnet, indem ferner aufweisend:

ein zweites Bitleitungspaar (GBL, /GBL), das so angeordnet ist, daß es über die Vielzahl von Speicherzellenarrays verläuft, und mit dem zweiten Datenknoten des ersten Leseverstärkers selektiv verbunden ist;
einen Schalter (7), der mit der zweiten Bitleitung verbunden ist, zum Steuern der Operation einer Datenübertragung bezüglich der Außenwelt dieser Vorrichtung;
einen zweiten Leseverstärker (52) zum Verstärken von externen Daten und Schreiben der Daten in die zweite Bitleitung; und
eine Steuereinrichtung (58) zum Steuern des ersten Leseverstärkers, des Schalters und des zweiten Leseverstärkers, um Daten von der zweiten Bitleitung zur ersten Bitleitung unter Verwendung der Verstärkereinrichtung und des Schalters zu schreiben, bevor der erste Leseverstärker betätigt wird, wenn externe Daten über die zweite Bitleitung geschrieben werden.

**Revendications**

1. Dispositif de mémoire à semiconducteur dynamique comprenant:

   une pluralité de réseaux de cellules de mémoire ($1_1$, $1_2$) dont chacun est construit au moyen d'une pluralité d'unités de cellules de mémoire qui sont chacune formées par une pluralité de cellules de mémoire dynamique connectées série (MC), chaque réseau de cellules de mémoire comportant une première ligne de bit (BL, $\overline{BL}$) qui lui est connectée;
   une première porte de transfert (4, 9) connectée à chaque dite première ligne de bit (BL, $\overline{BL}$);
   au moins un premier amplificateur de détection (3) agencé entre des réseaux de cellules de mémoire adjacents ($1_1$, $1_2$), l'amplificateur de détection (3) comportant des premier et second noeuds de données ($N_1$, $N_2$), chaque noeud de données étant connecté sélectivement via une première porte de transfert (4, 9) à l'une desdites premières lignes de bit;
   au moins un registre (5) agencé entre ledit amplificateur de détection et lesdits réseaux de cellules de mémoire et connecté à au moins l'un desdits noeuds de données directement ou via une seconde porte de transfert (6), pour stocker temporairement des données de cellule de mémoire lues à partir d'une unité de cellules de mémoire; et
   des moyens de commande de porte (10) pour commander chaque dite porte de transfert (4, 9) afin de séparer sélectivement et électriquement les premier et second noeuds de données ($N_1$, $N_2$) dudit amplificateur de détection (3) de chaque dite première ligne de bit dans le cas où des données lues sur l'une desdites premières lignes de bit sont stockées dans ledit registre (5) depuis ledit amplificateur de détection (3).

2. Dispositif de mémoire à semiconducteur dynamique selon la revendication 1, caractérisé en ce que ledit ou chaque dit registre (5) est construit au moyen de cellules de mémoire qui sont les mêmes qu'une pluralité de cellules de mémoire connectées à ladite première ligne de bit.

3. Dispositif de mémoire à semiconducteur dynamique selon la revendication 1, caractérisé en ce que ledit ou chaque dit registre (5) est construit au moyen de cellules de mémoire qui sont les mêmes que les cellules de mémoires connectées sous forme série et connectées à ladite première ligne de bit.

4. Dispositif de mémoire à semiconducteur dynamique selon la revendication 1, caractérisé en ce qu'il comprend en outre:

   une troisième porte de transfert (7) connectée à chacun desdits noeuds de données dudit amplificateur de détection;
   une seconde paire de lignes de bit (GBL, $\overline{GBL}$) connectées à ladite troisième porte de transfert; et
   un second registre (60) pour stocker lesdites données de cellule de mémoire via ladite seconde paire de lignes de bit.

5. Dispositif de mémoire à semiconducteur dynamique selon la revendication 4, caractérisé en ce qu'il comprend en outre un circuit de transfert de données (58, 58') connecté entre ledit second registre et ladite seconde ligne de bit.

6. Dispositif de mémoire à semiconducteur dynamique selon la revendication 1, caractérisé en ce qu'il comprend en outre:

   une seconde paire de lignes de bit (GBL, $\overline{GBL}$) agencées pour s'étendre au travers de ladite pluralité de réseaux de cellules de mémoire et connectées sélectivement au second noeud de données dudit premier amplificateur de détection;
   un commutateur (7) connecté à ladite seconde paire de lignes de bit (GBL, $\overline{GBL}$) pour commander l'opération de transfert de données par rapport à l'extérieur;
   un tampon (54) pour écrire des données externes sur ladite seconde paire de lignes de bit;
   un second amplificateur de détection (52) pour amplifier des données lues dans ladite cellule de mémoire; et
   des moyens de commande (58) pour commander ledit premier amplificateur de détection, ledit commutateur et un élément pris parmi ledit tampon et ledit second amplificateur de détection afin d'écrire des données depuis ladite seconde ligne de bit sur ladite première ligne de bit en utilisant ledit tampon et ledit commutateur avant que ledit premier amplificateur de détection ne soit activé lorsque des données externes sont écrites via ladite seconde ligne de bit.

7. Dispositif de mémoire à semiconducteur dynamique selon la revendication 1, caractérisé en ce qu'il comprend en outre:

   une seconde paire de lignes de bit (GBL, $\overline{GBL}$) agencées de manière à s'étendre au travers de ladite pluralité de réseaux de cellules de mémoire et connectées sélectivement au second noeud de données dudit premier amplificateur de détection;
un commutateur (7) connecté à ladite seconde ligne de bit pour commander l'opération de transfert de données par rapport à l'extérieur de ce dispositif;
un second amplificateur de détection (52) pour amplifier des données externes et pour écrire les données dans ladite seconde ligne de bit; et
des moyens de commande (58) pour commander ledit premier amplificateur de détection, ledit commutateur et ledit second amplificateur de détection afin d'écrire des données depuis ladite seconde ligne de bit sur ladite première ligne de bit en utilisant lesdits moyens d'amplificateur et ledit commutateur avant que ledit premier amplificateur de détection ne soit activé lorsque des données externes sont écrites via ladite seconde ligne de bit.

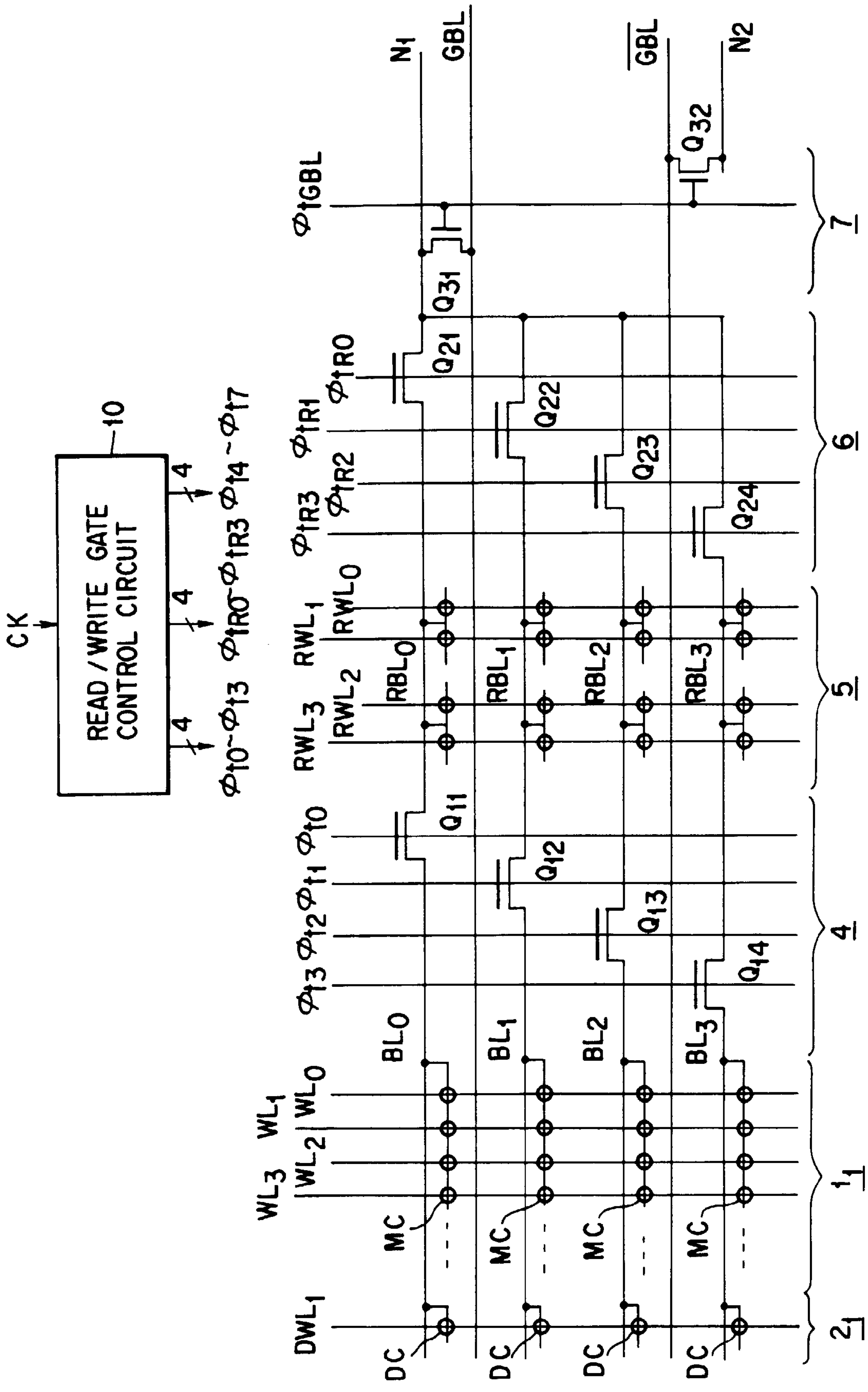
CK
READ / WRITE GATE CONTROL CIRCUIT
10
4
4
4
Φ10~Φ13
ΦTR0~ΦTR3
Φ14~Φ17
N1
GBL
GBL
N2
ΦTGBL
Q31
Q32
ΦTR0
ΦTR1
ΦTR2
ΦTR3
Q21
Q22
Q23
Q24
RWL0
RWL1
RWL2
RWL3
RBL0
RBL1
RBL2
RBL3
Φ10
Φ11
Φ12
Φ13
Q11
Q12
Q13
Q14
BL0
BL1
BL2
BL3
WL0
WL1
WL2
WL3
MC
DWL1
DC
1_1
2_1
4
5
6
7

F I G. 1

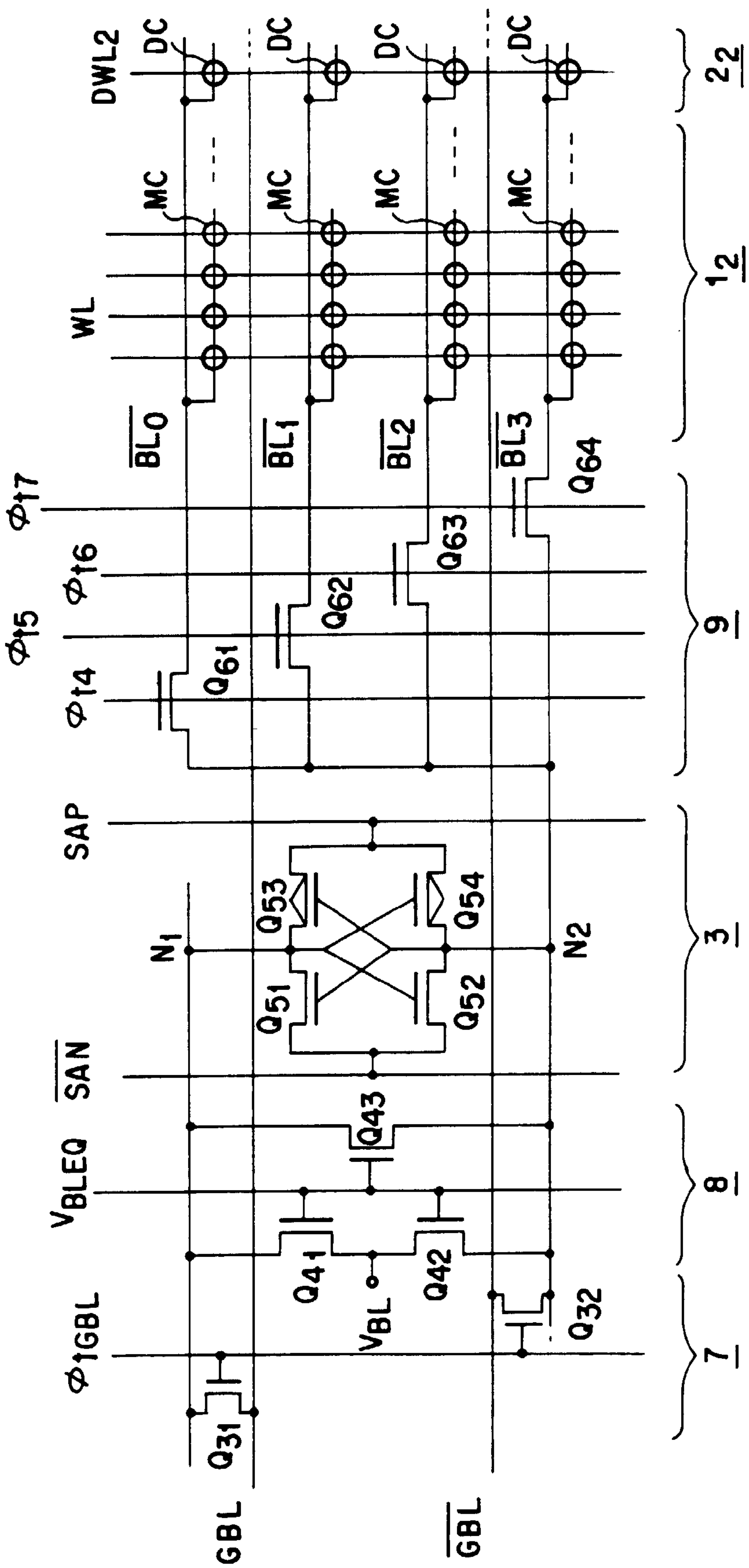
DWL2
DC
MC
WL
$\overline{BL0}$
$\overline{BL1}$
$\overline{BL2}$
$\overline{BL3}$
$\phi_{17}$
$\phi_{16}$
$\phi_{15}$
$\phi_{14}$
Q61
Q62
Q63
Q64
SAP
N1
N2
Q53
Q54
Q51
Q52
$\overline{SAN}$
Q43
VBLEQ
Q41
Q42
VBL
$\phi_{1GBL}$
Q31
Q32
GBL
$\overline{GBL}$
22
12
9
3
8
7

FIG. 2

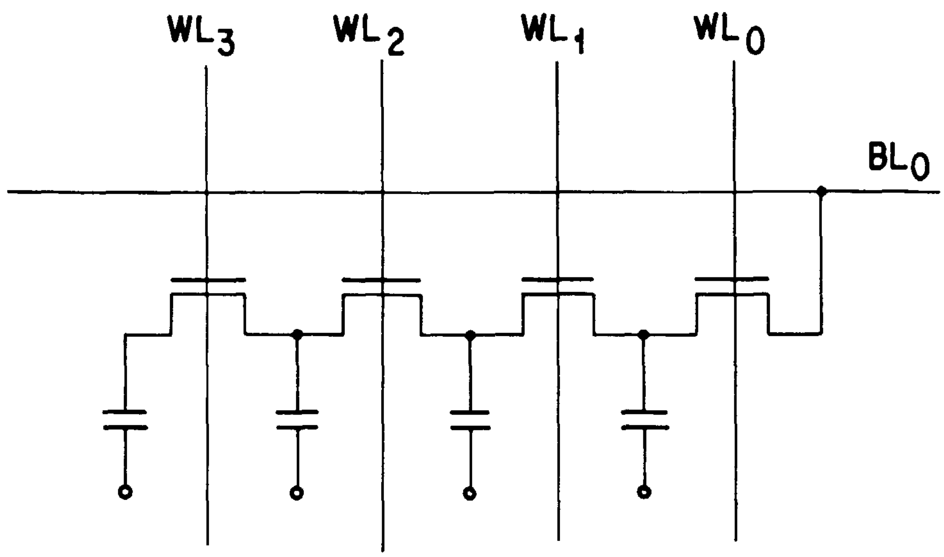


FIG. 3A

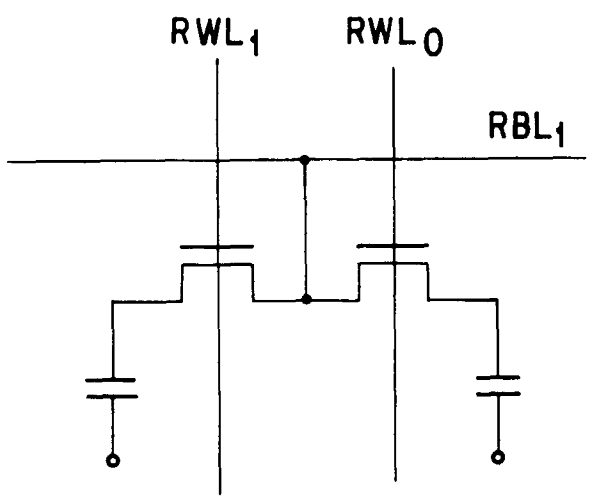


FIG. 3B

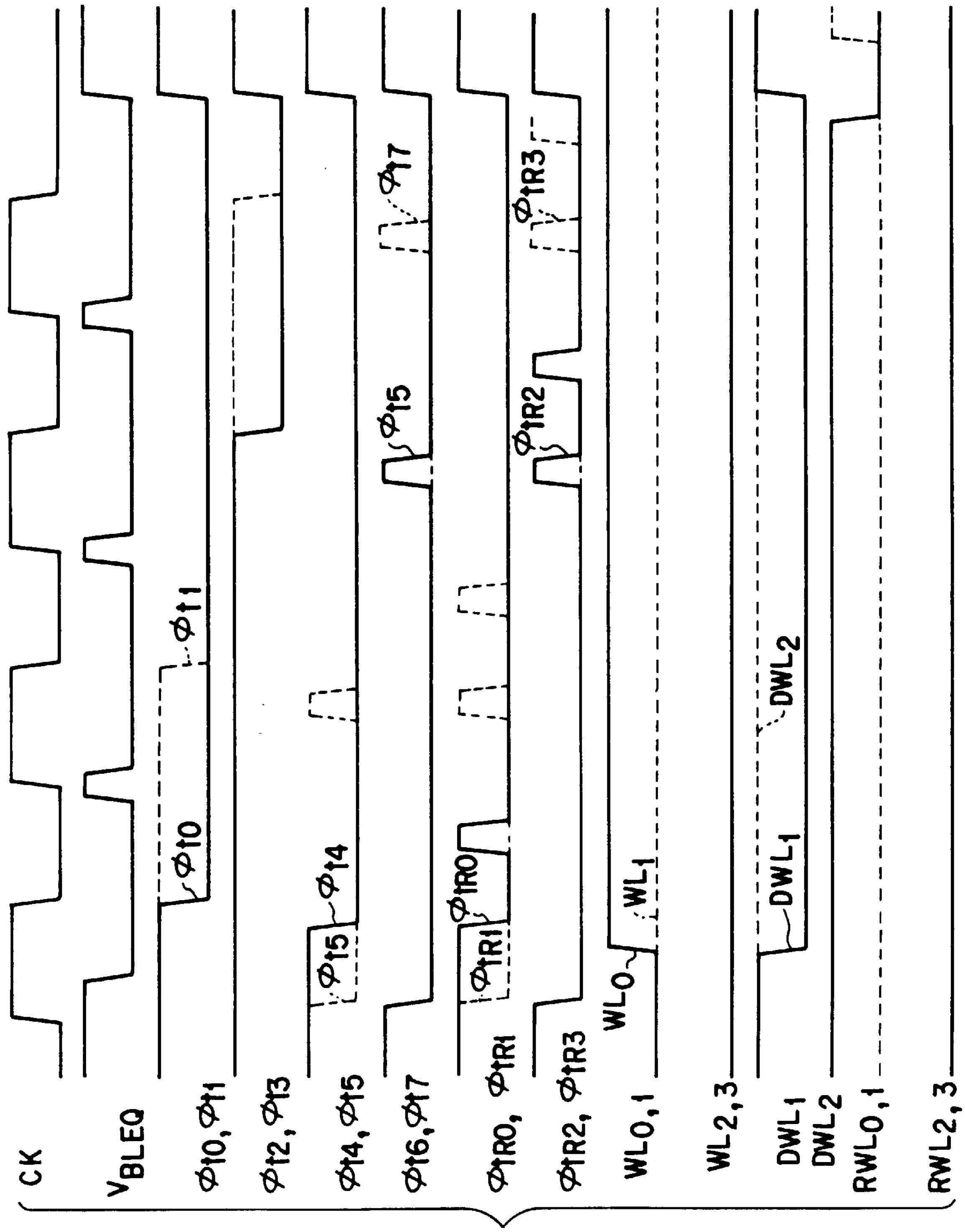
CK
VBLEQ
φt0, φt1
φt2, φt3
φt4, φt5
φt6, φt7
φtR0, φtR1
φtR2, φtR3
WL0, 1
WL2, 3
DWL1
DWL2
RWL0, 1
RWL2, 3
φt0
φt1
φt5
φt4
φt7
φtR0
φtR1
φtR2
φtR3
WL0
WL1
DWL1
DWL2

FIG. 4

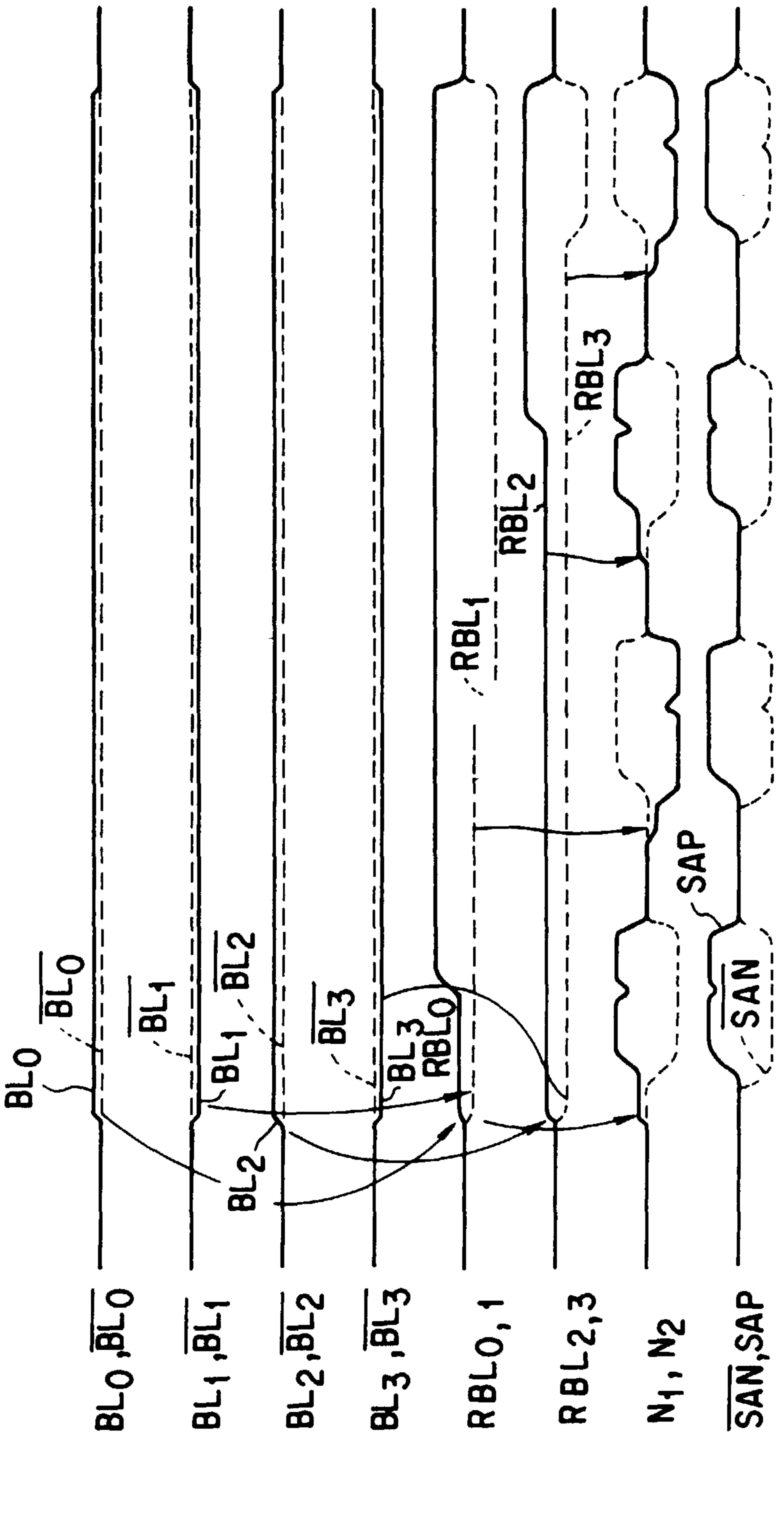
$BL_0,\overline{BL_0}$
$BL_1,\overline{BL_1}$
$BL_2,\overline{BL_2}$
$BL_3,\overline{BL_3}$
$RBL_{0,1}$
$RBL_{2,3}$
$N_1, N_2$
$\overline{SAN},SAP$
$BL_0$
$\overline{BL_0}$
$\overline{BL_1}$
$BL_1$
$\overline{BL_2}$
$\overline{BL_3}$
$BL_3$
$\overline{RBL_0}$
$BL_2$
$BL_2$
$\overline{RBL_1}$
$\overline{RBL_2}$
$RBL_3$
SAP
$\overline{SAN}$

FIG. 5

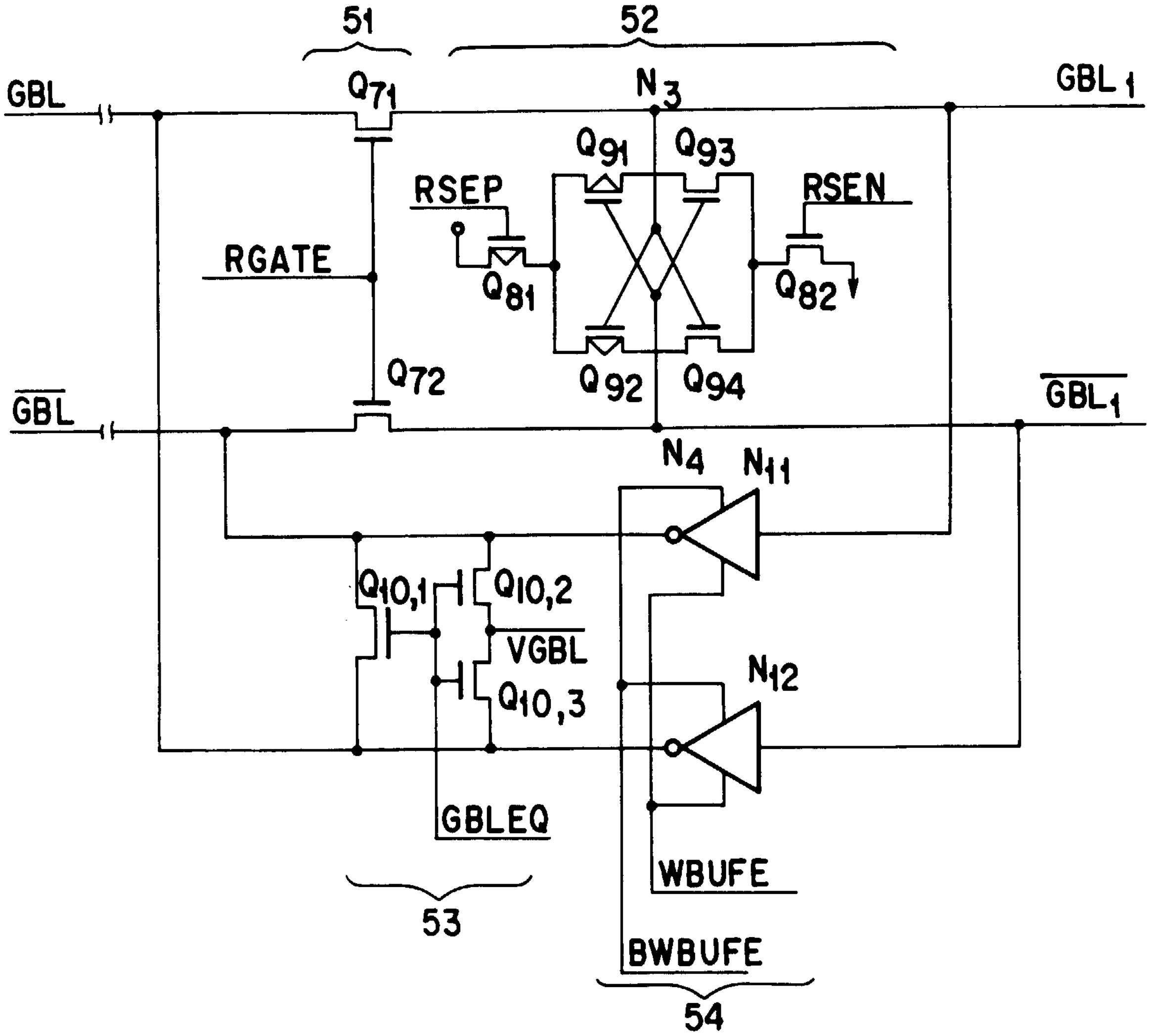
51
52
GBL
Q71
N3
GBL1
Q91
Q93
RSEP
RSEN
RGATE
Q81
Q82
Q72
Q92
Q94
GBL
GBL1
N4
N11
Q10,1
Q10,2
VGBL
Q10,3
N12
GBLEQ
WBUFE
53
BWBUFE
54

F I G. 6

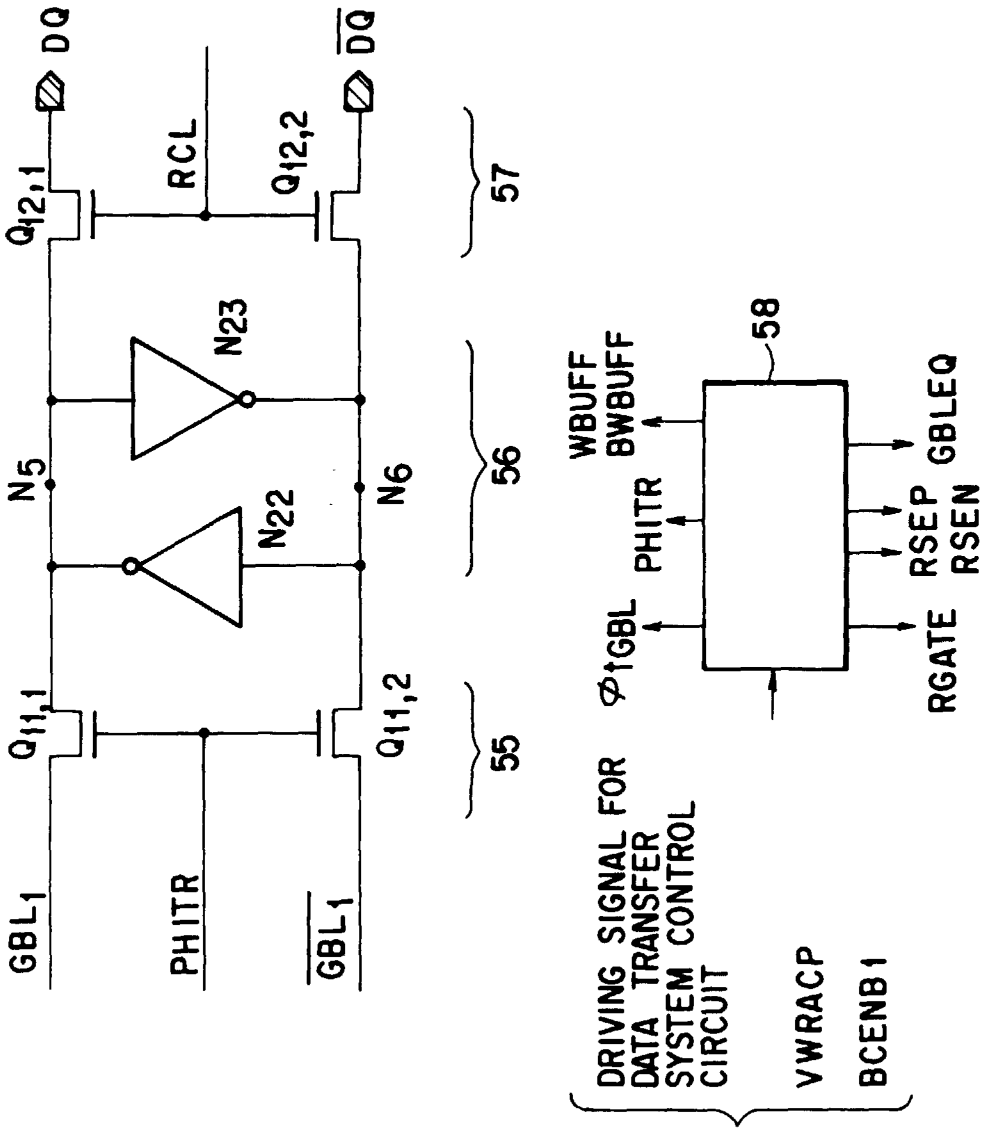
DQ
DQ
RCL
Q12,1
Q12,2
57
N23
N5
N6
N22
56
58
WBUFF
BWBUFF
GBLEQ
PHITR
RSEP
RSEN
φ1GBL
RGATE
Q11,1
Q11,2
55
GBL1
PHITR
GBL1
DRIVING SIGNAL FOR DATA TRANSFER SYSTEM CONTROL CIRCUIT
VWRACP
BCENB1

FIG. 7

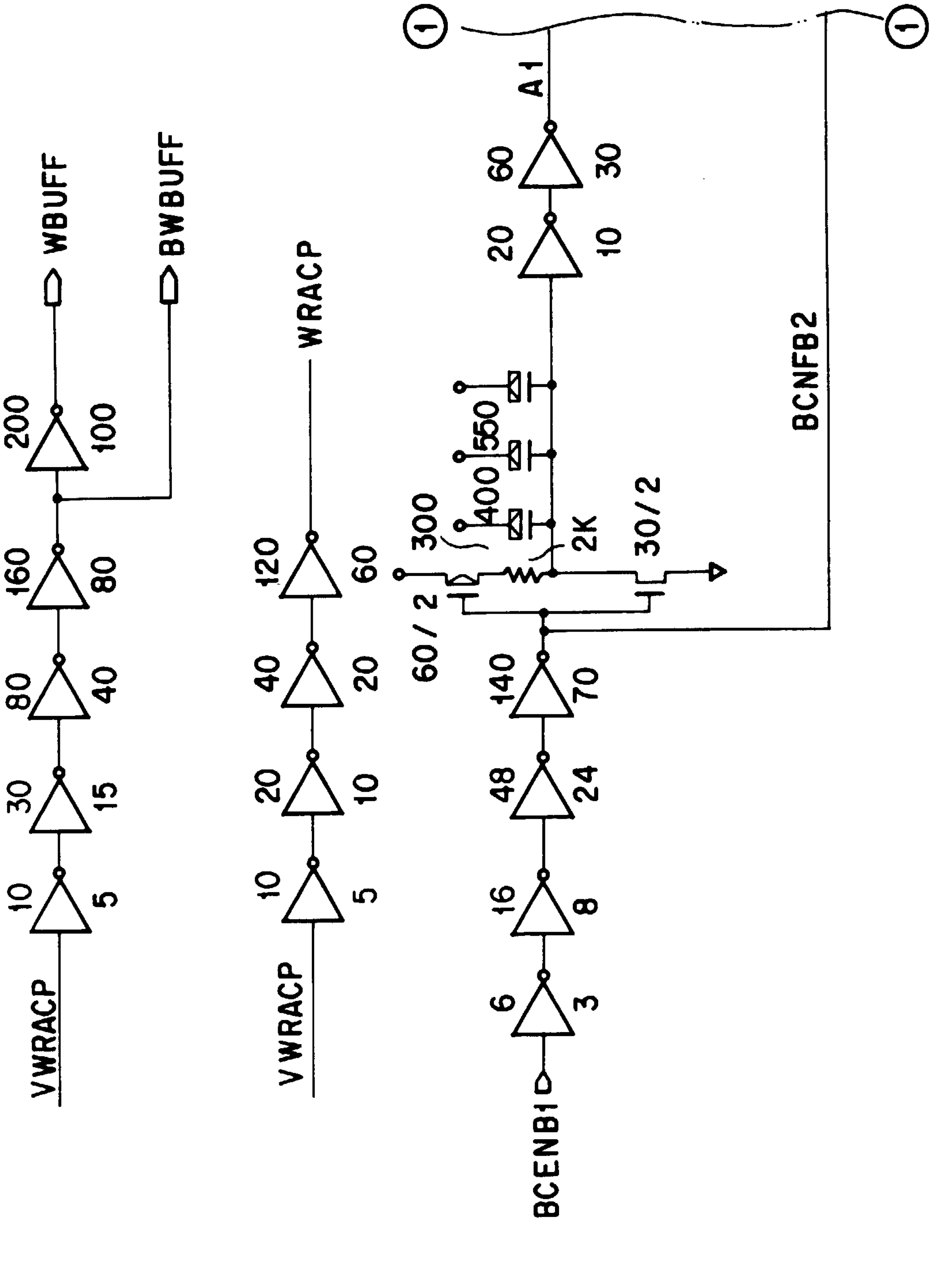
VWRACP
10
5
30
15
80
40
160
80
200
100
WBUFF
BWBUFF
V WRACP
10
5
20
10
40
20
120
60
WRACP
BCENB1
6
3
16
8
48
24
140
70
60 / 2
300
400
550
2K
30/2
20
10
60
30
A1
BCNFB2
1
1

F I G. 8

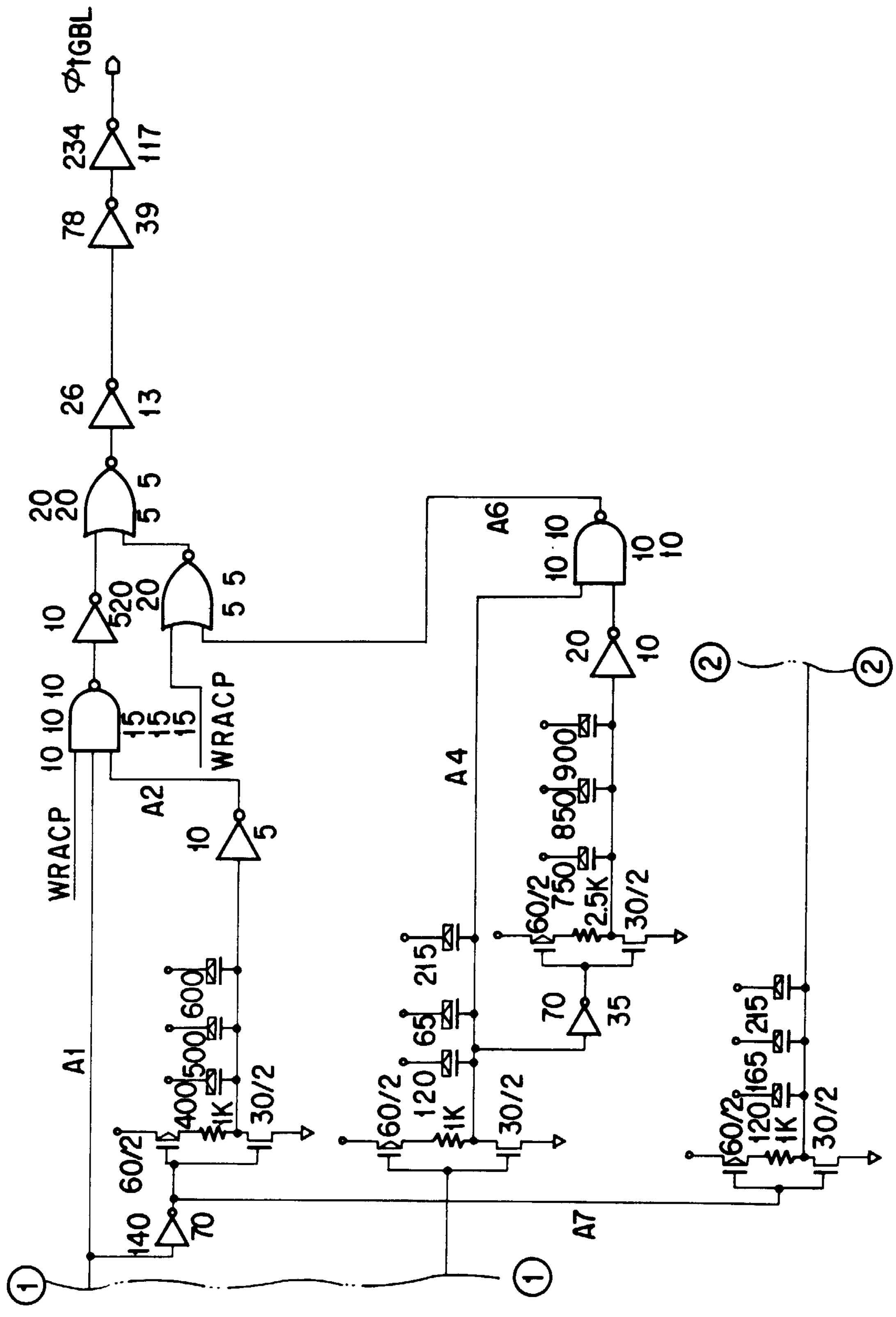


FIG. 9

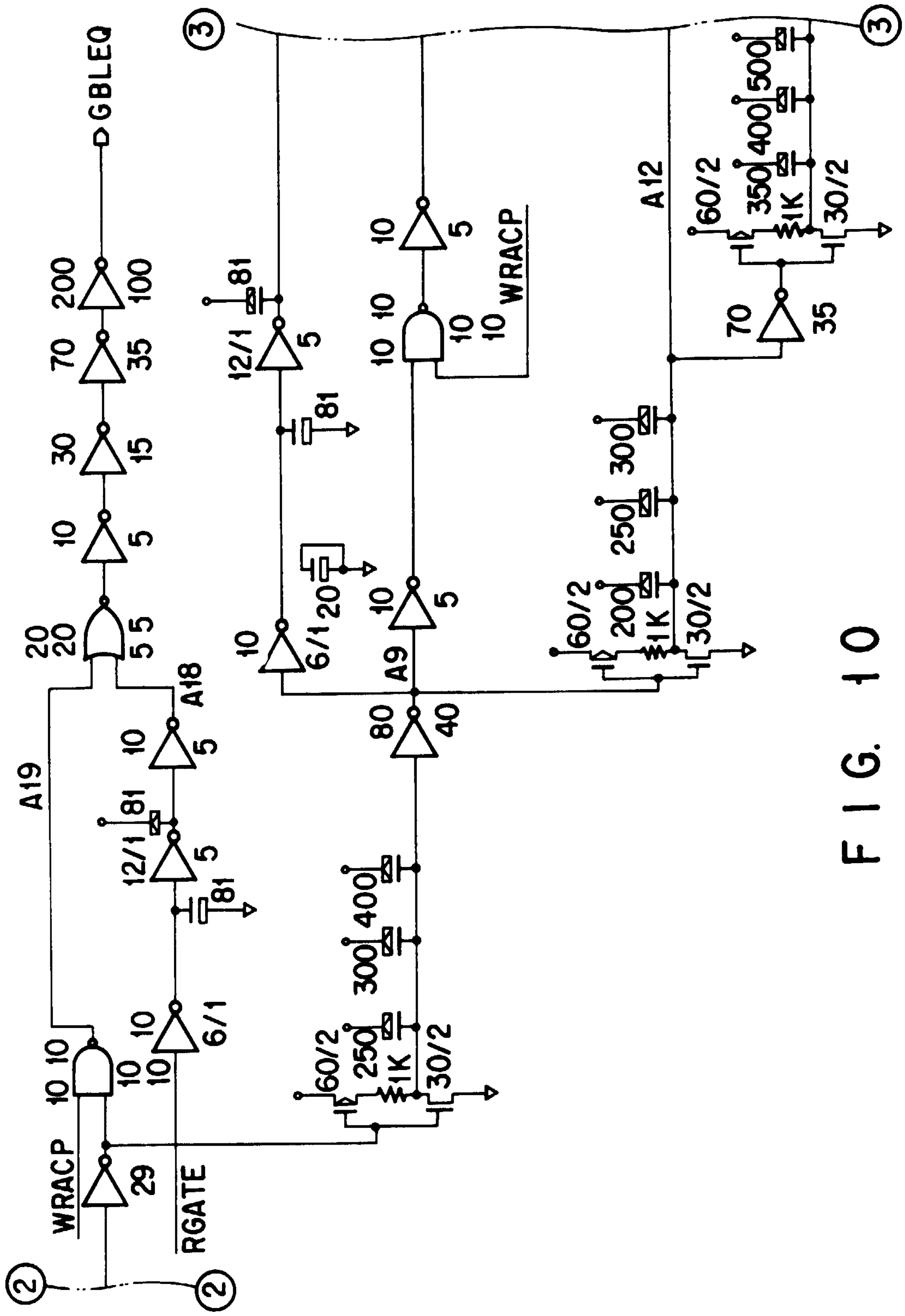


F I G. 10

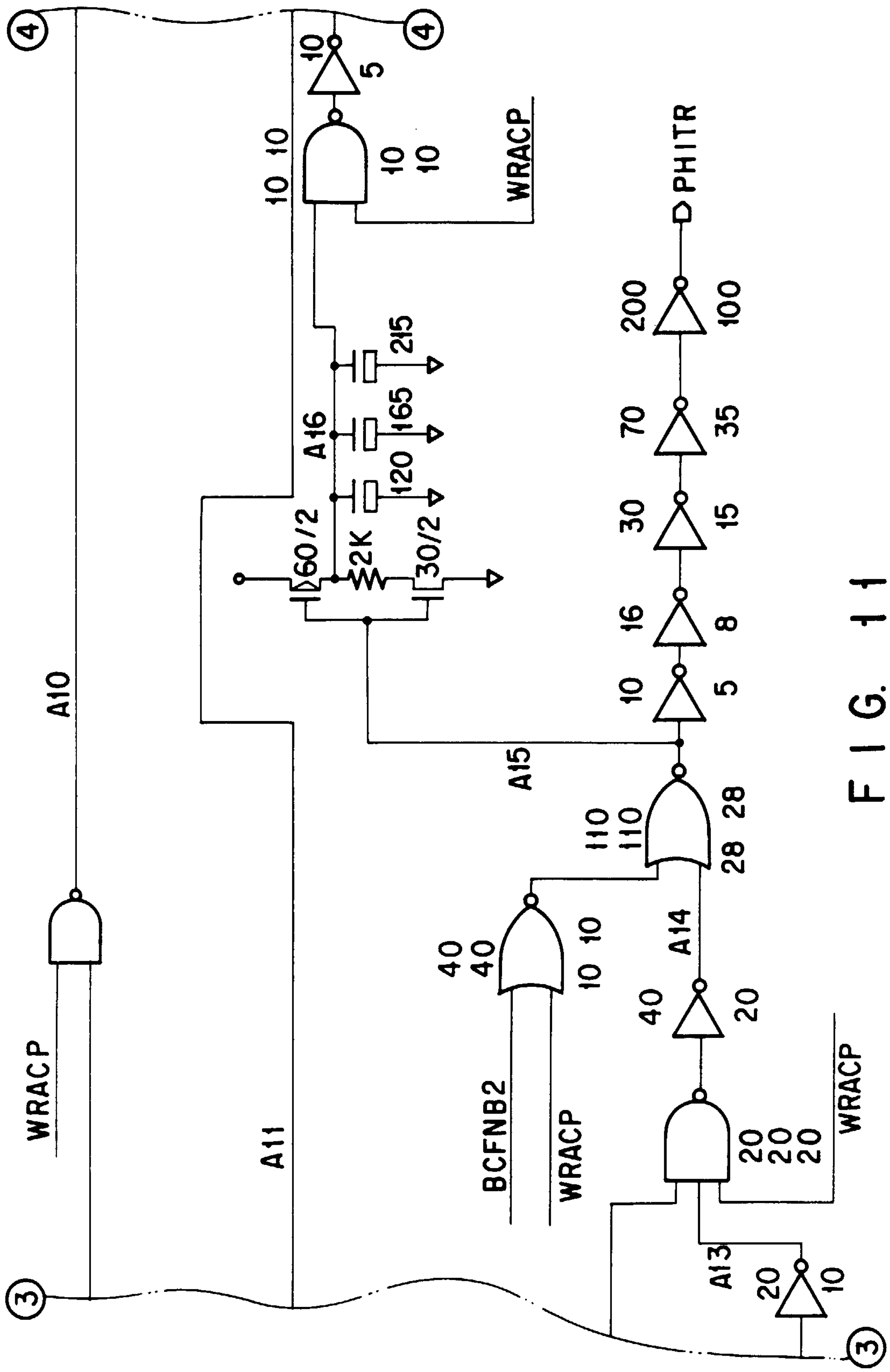

4
4
3
3
A10
A11
A13
A14
A15
A16
WRACP
WRACP
WRACP
WRACP
BCFNB2
PHITR
60/2
2K
30/2
120
165
215
10 10
10 10
10
5
40
40
10 10
110
110
28 28
28 28
40
20
20
20
20
20
10
10
5
16
8
30
15
70
35
200
100


F I G. 11

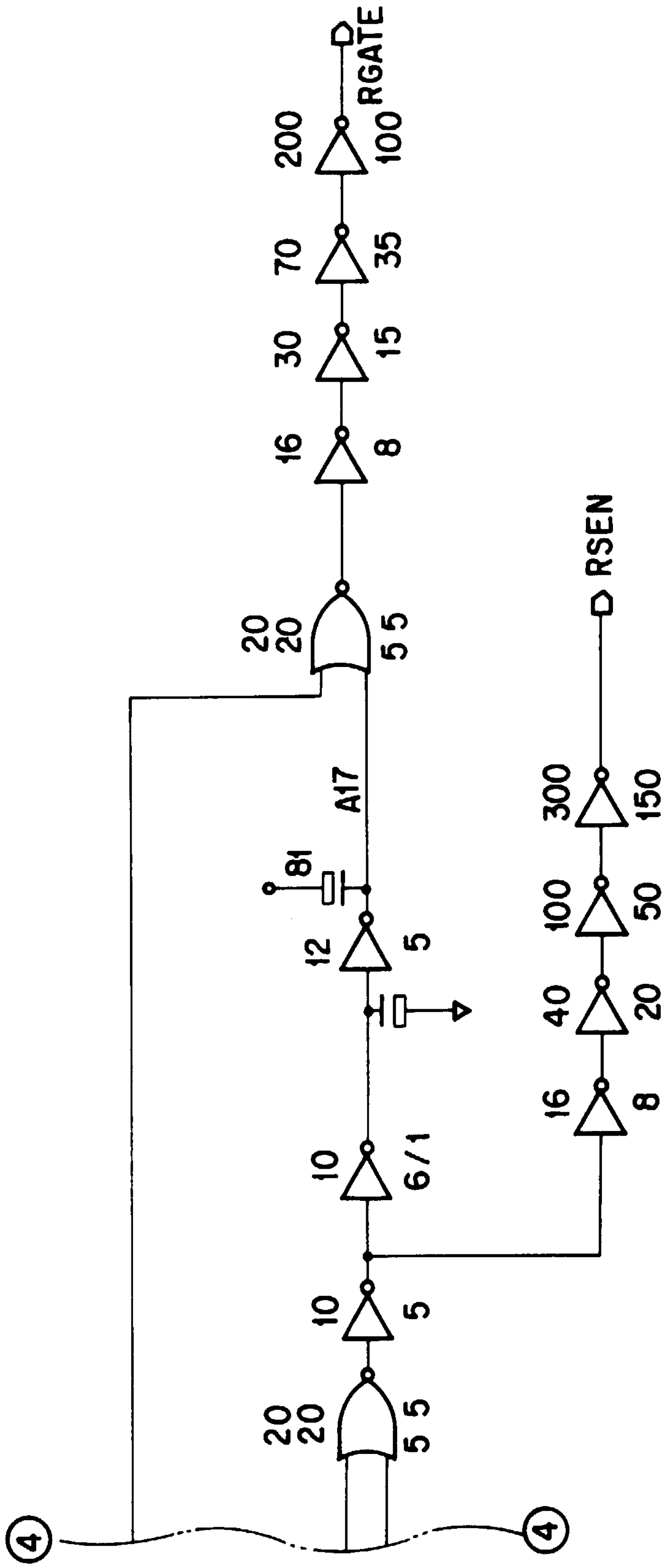
RGATE
RSEN
A17
81
200
100
70
35
30
15
16
8
20
20
5 5
12
5
10
6/1
10
5
20
20
5 5
300
150
100
50
40
20
16
8
4
4

FIG. 12

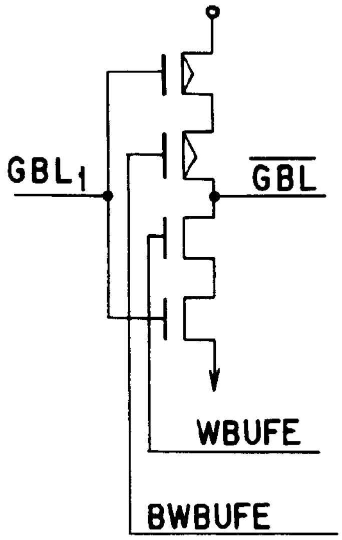


FIG. 13A

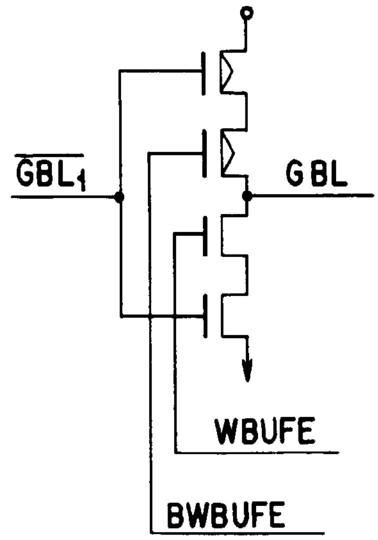


FIG. 13B

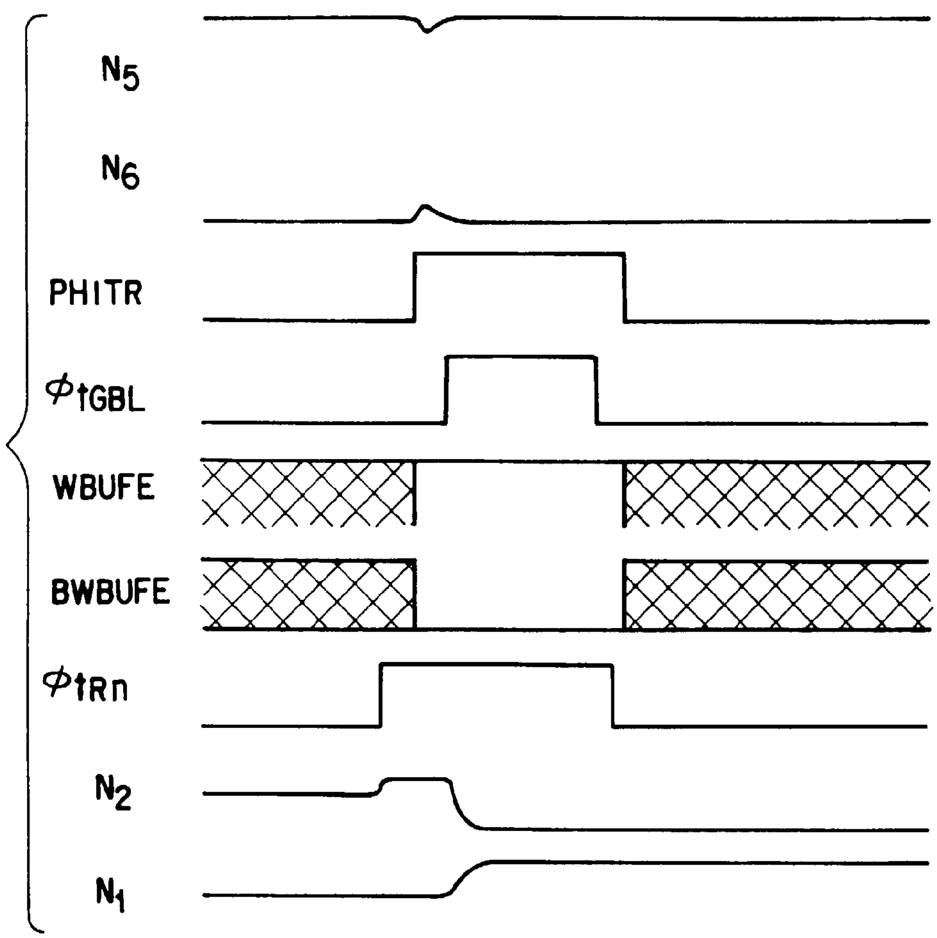


FIG. 14

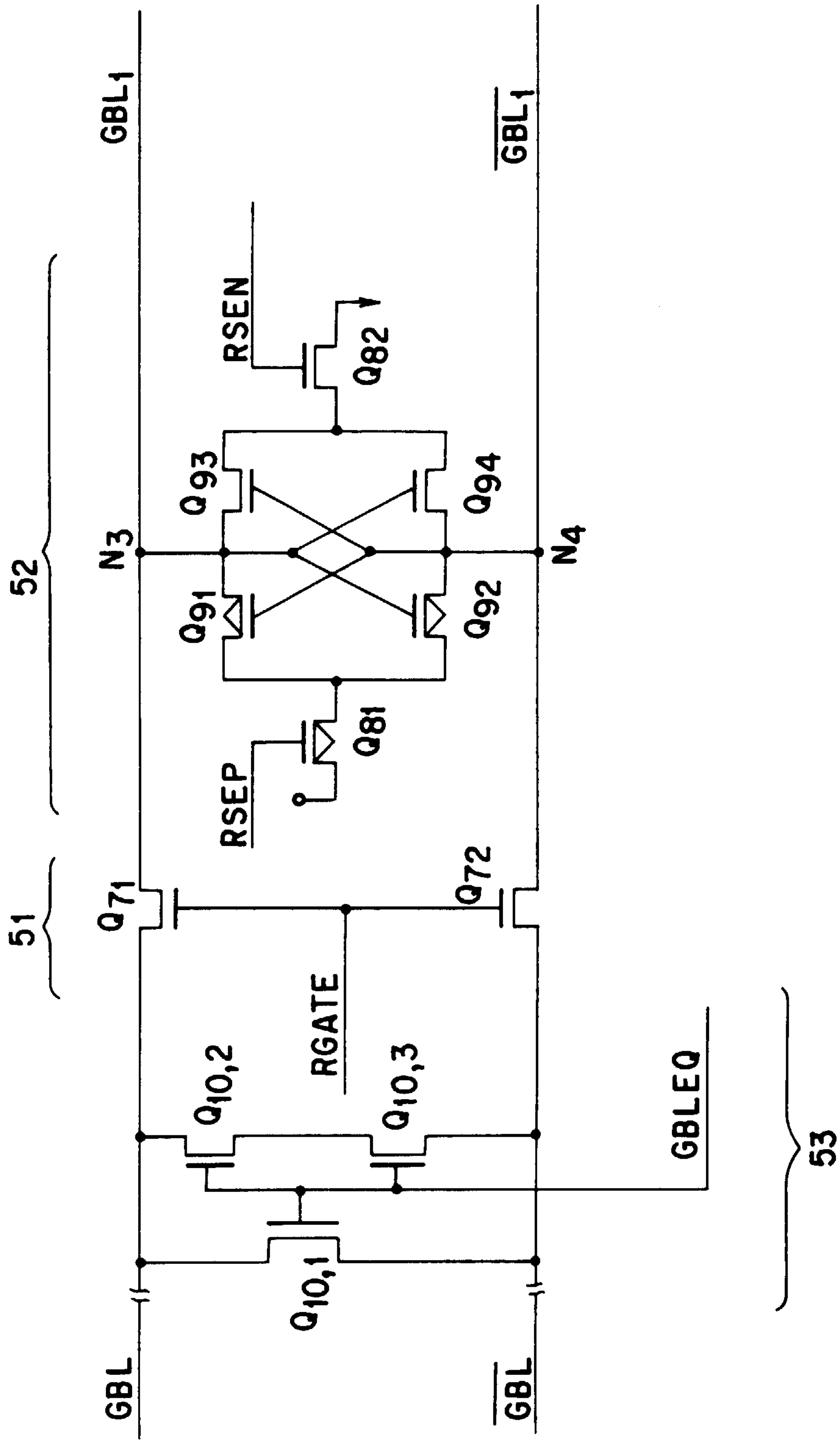
GBL1
GBL1
52
N3
N4
RSEN
Q82
Q93
Q94
Q91
Q92
Q81
RSEP
51
Q71
Q72
RGATE
Q10,2
Q10,3
GBLEQ
53
Q10,1
GBL
GBL

F I G. 15

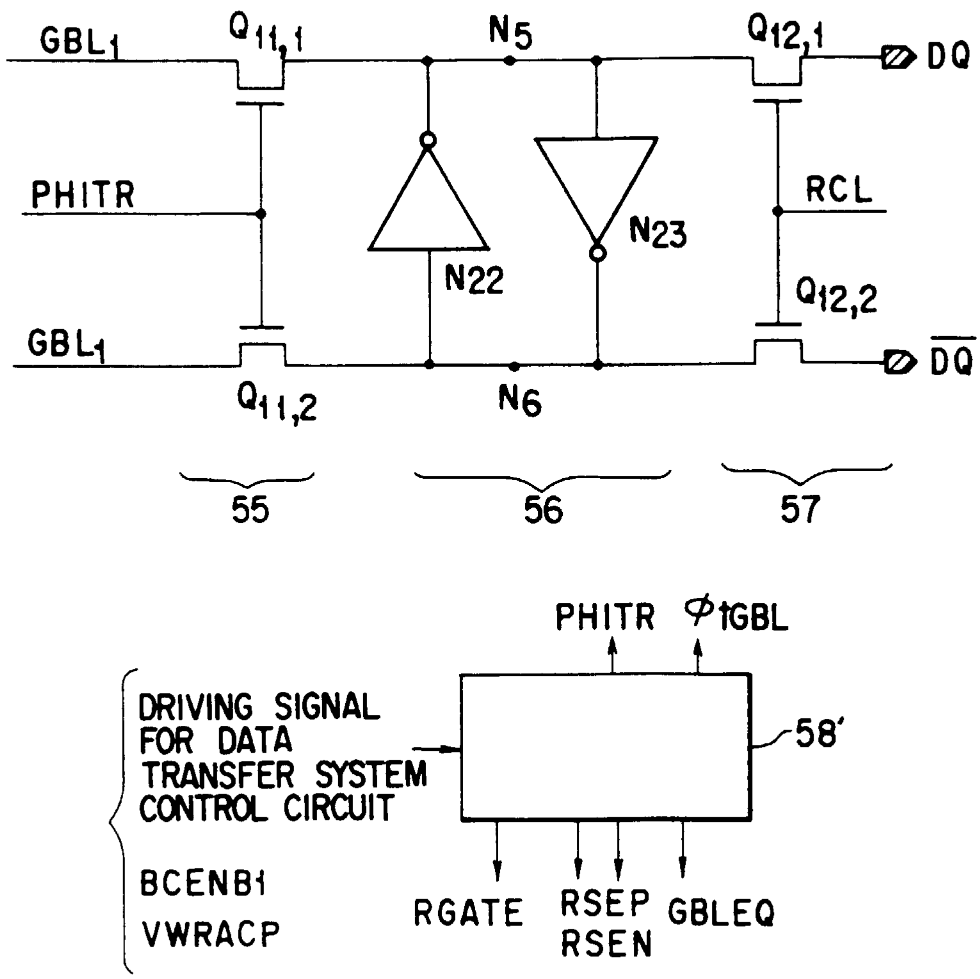
GBL1
Q11,1
N5
Q12,1
DQ
PHITR
RCL
N23
N22
Q12,2
GBL1
DQ
Q11,2
N6
55
56
57
PHITR
φ1GBL
DRIVING SIGNAL
FOR DATA
TRANSFER SYSTEM
CONTROL CIRCUIT
BCENB1
VWRACP
58'
RGATE
RSEP
RSEN
GBLEQ

F I G. 16

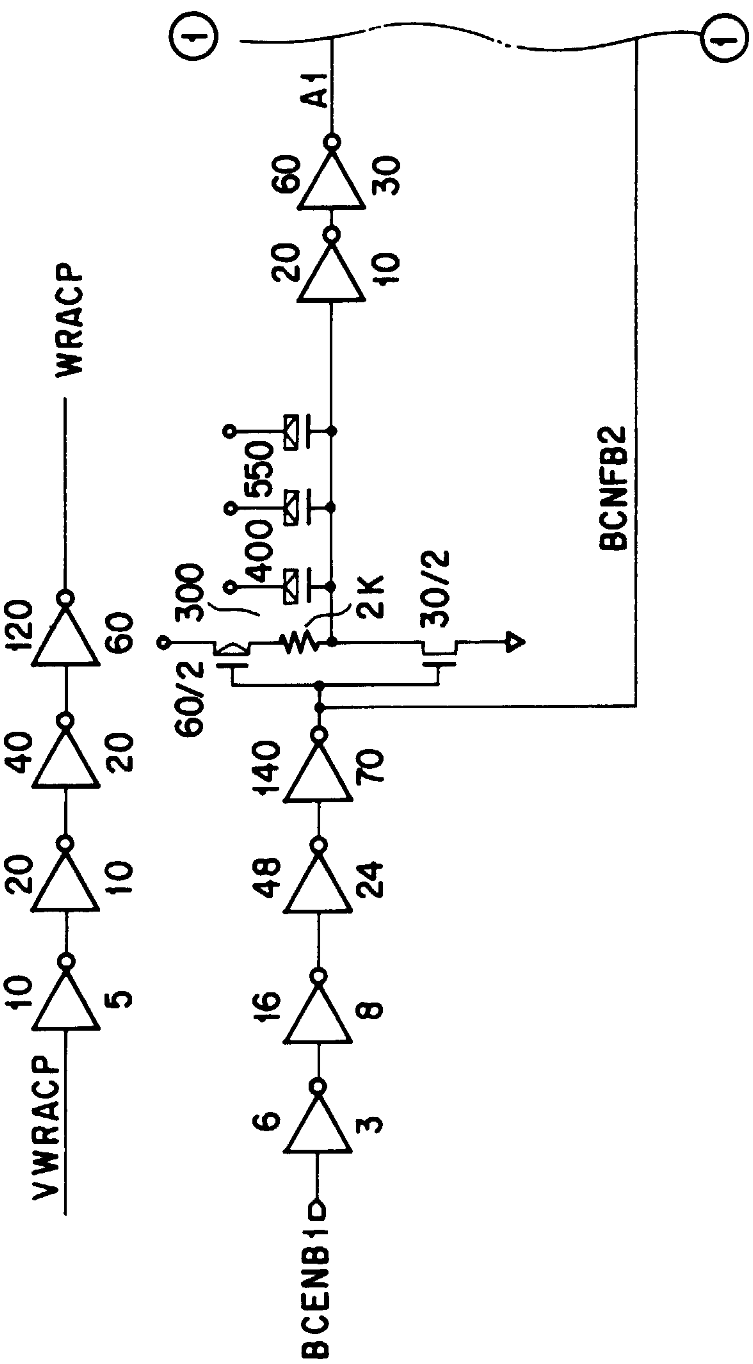
VWRACP
WRACP
BCENB1
BCNFB2
A1
1
1
10
5
20
10
40
20
120
60
6
3
16
8
48
24
140
70
60/2
300
400
550
2K
30/2
20
10
60
30

F I G. 17

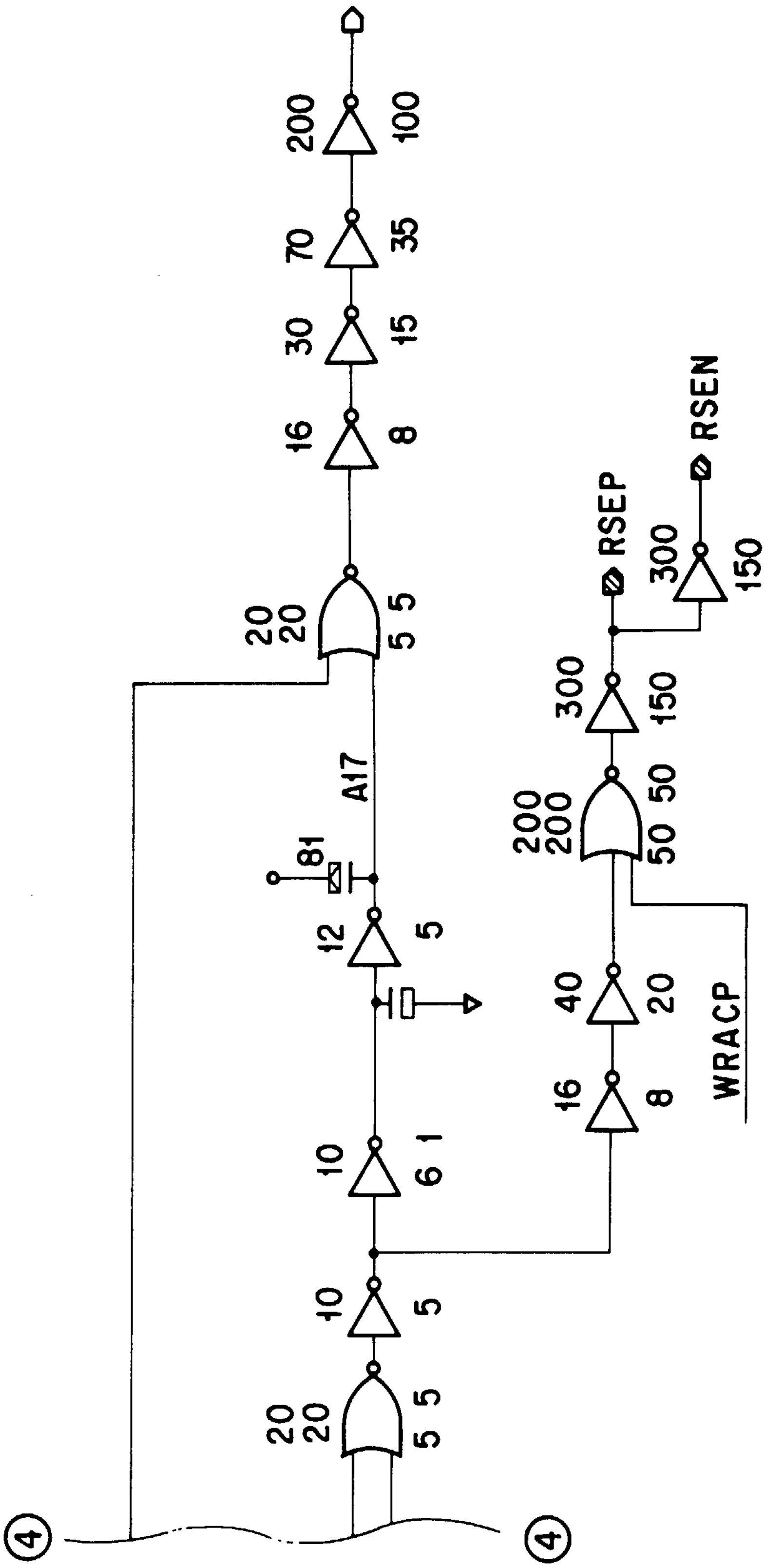


FIG. 18

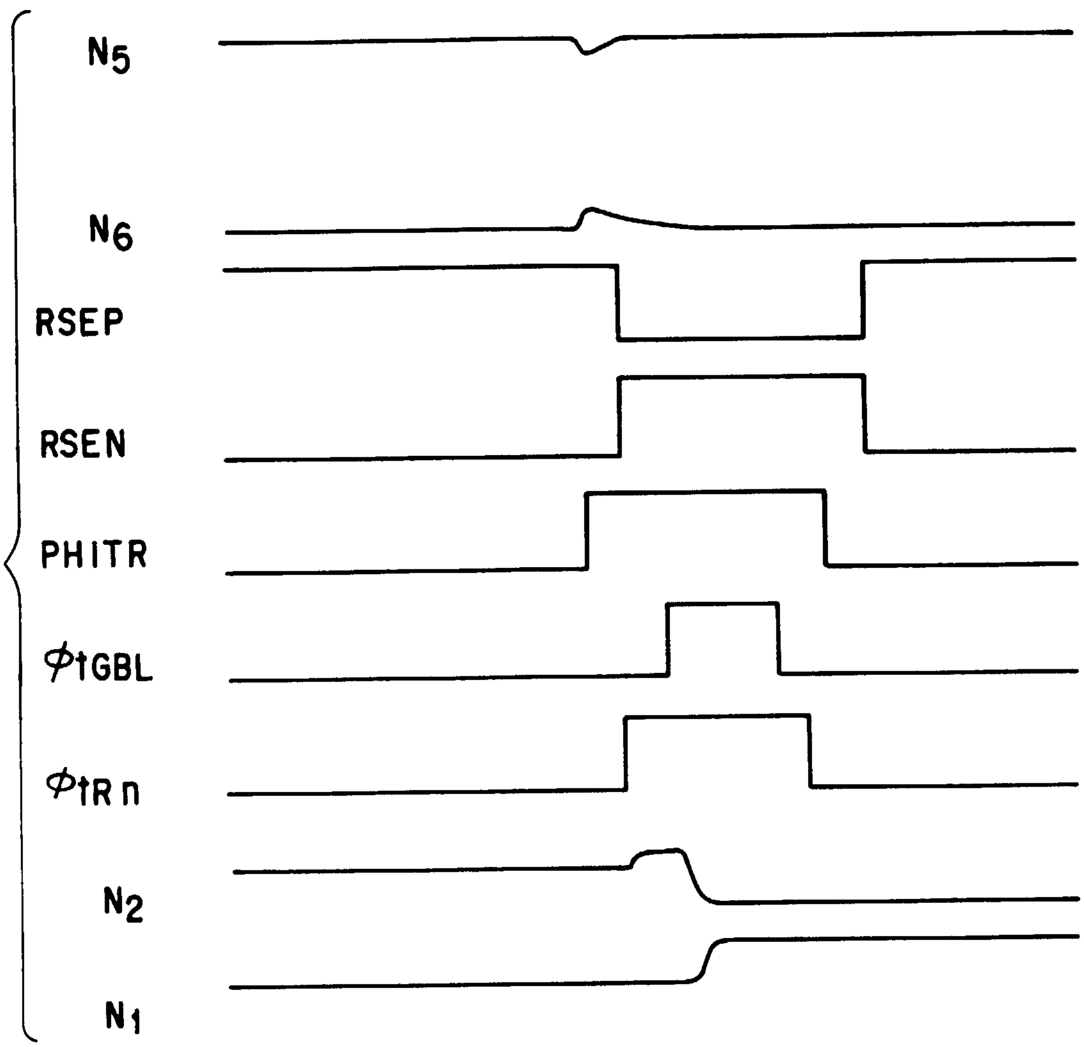


FIG. 19

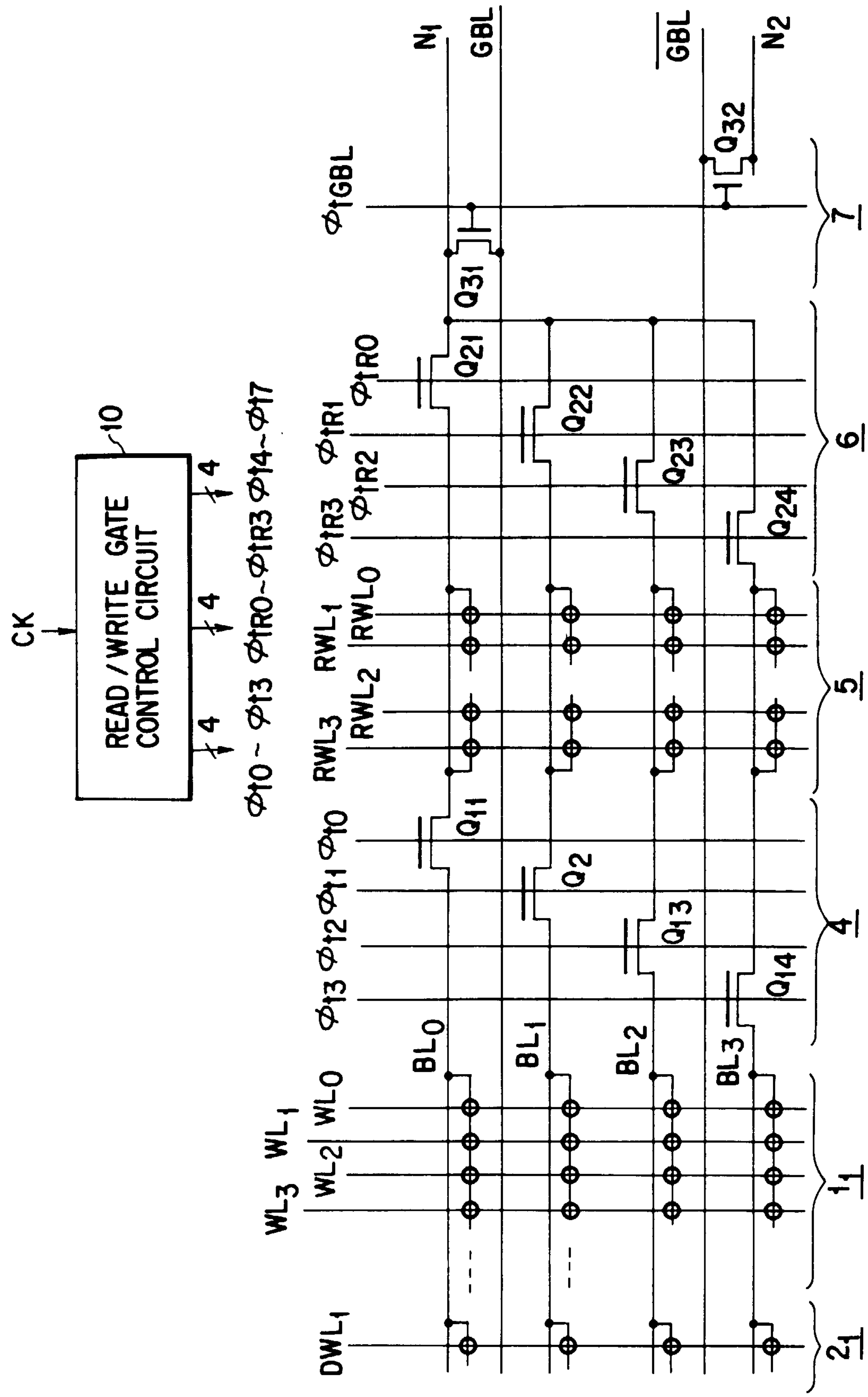
CK
READ / WRITE GATE CONTROL CIRCUIT
10
4
4
4
$\phi_{t0}$ ~ $\phi_{t3}$ $\phi_{tR0}$ ~ $\phi_{tR3}$ $\phi_{t4}$ ~ $\phi_{t7}$
$N_1$
GBL
$\overline{GBL}$
$N_2$
$\phi_{tGBL}$
$Q_{32}$
$Q_{31}$
$\phi_{tR0}$ $\phi_{tR1}$ $\phi_{tR2}$ $\phi_{tR3}$
$Q_{21}$ $Q_{22}$ $Q_{23}$ $Q_{24}$
$RWL_0$ $RWL_1$ $RWL_2$ $RWL_3$
$\phi_{t0}$ $\phi_{t1}$ $\phi_{t2}$ $\phi_{t3}$
$Q_{11}$ $Q_2$ $Q_{13}$ $Q_{14}$
$BL_0$ $BL_1$ $BL_2$ $BL_3$
$WL_0$ $WL_1$ $WL_2$ $WL_3$
$DWL_1$
7
6
5
4
$1_1$
$2_1$

F I G. 20

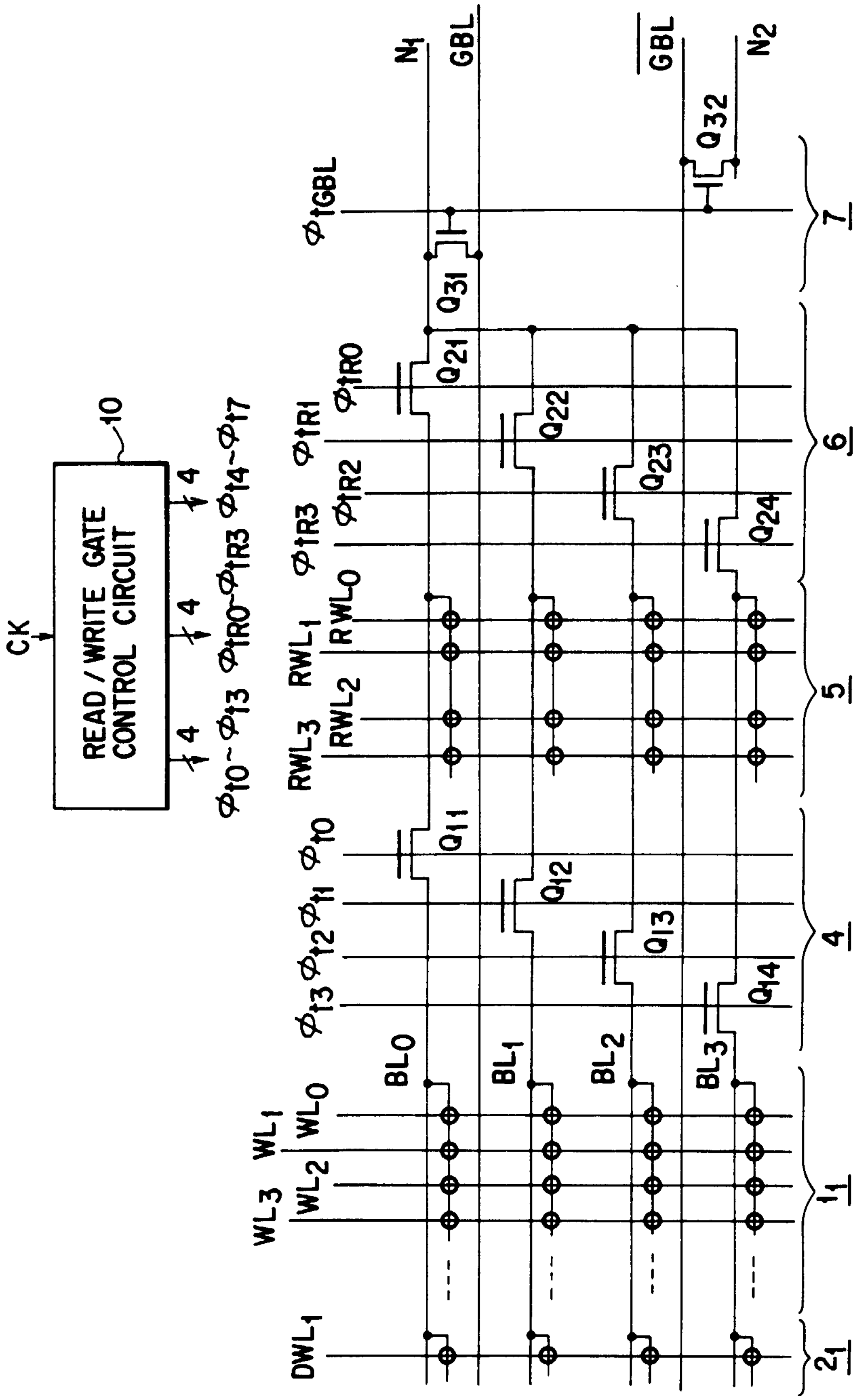
CK
READ / WRITE GATE CONTROL CIRCUIT
10
4
4
4
$\phi_{T0}$~$\phi_{T3}$
$\phi_{TR0}$~$\phi_{TR3}$
$\phi_{T4}$~$\phi_{T7}$
$\phi_{TGBL}$
$N_1$
GBL
$\overline{GBL}$
$N_2$
$Q_{32}$
$Q_{31}$
$Q_{21}$
$Q_{22}$
$Q_{23}$
$Q_{24}$
$\phi_{TR0}$
$\phi_{TR1}$
$\phi_{TR2}$
$\phi_{TR3}$
$RWL_0$
$RWL_1$
$RWL_2$
$RWL_3$
$\phi_{T0}$
$\phi_{T1}$
$\phi_{T2}$
$\phi_{T3}$
$Q_{11}$
$Q_{12}$
$Q_{13}$
$Q_{14}$
$BL_0$
$BL_1$
$BL_2$
$BL_3$
$WL_0$
$WL_1$
$WL_2$
$WL_3$
$DWL_1$
7
6
5
4
$1_1$
$2_1$

FIG. 21

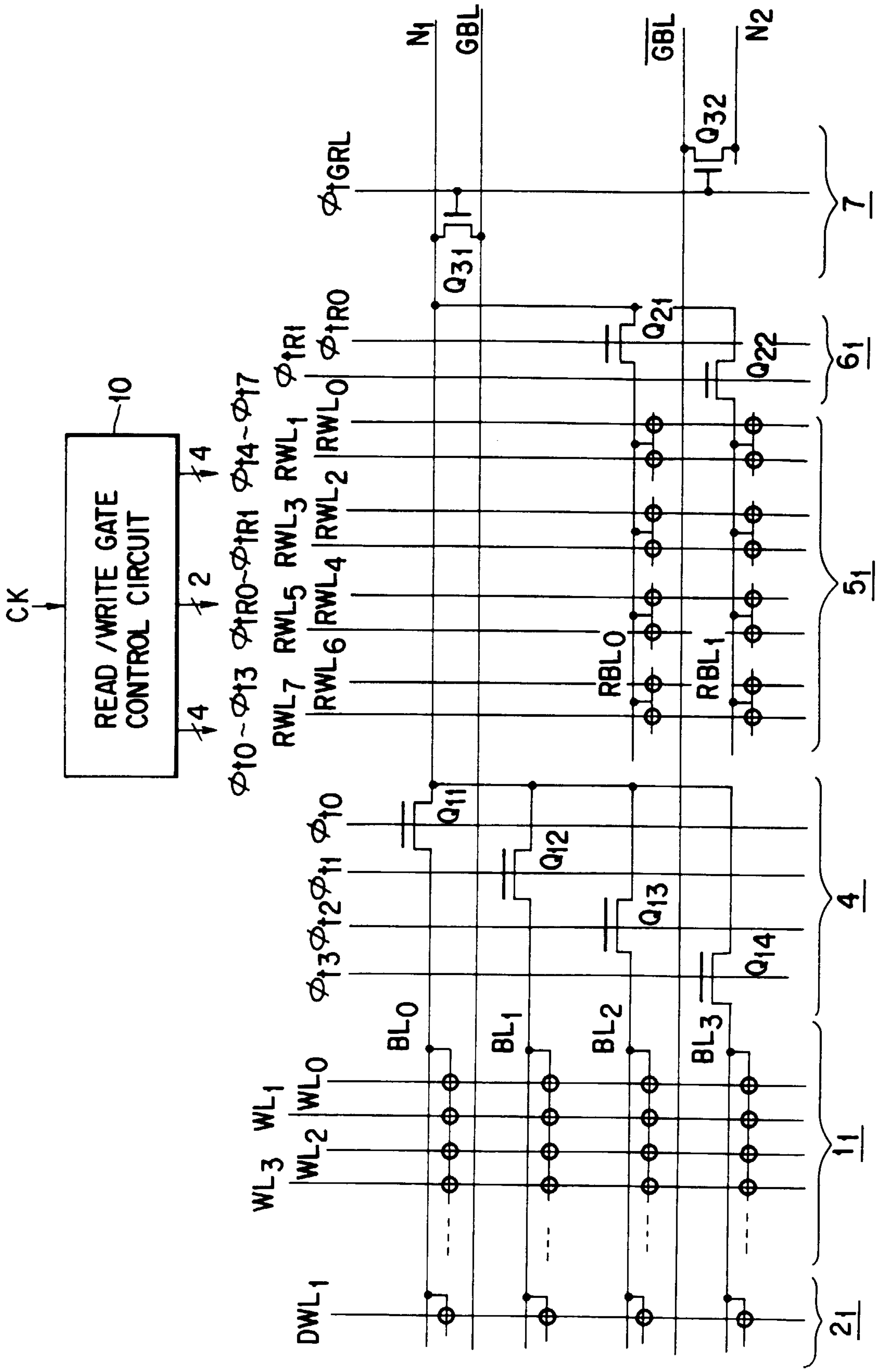
CK
READ /WRITE GATE CONTROL CIRCUIT
10
4
2
4
Φ10~Φ13
ΦTR0~ΦTR1
Φ14~Φ17
N1
GBL
GBL
N2
ΦTGRL
Q31
Q32
7
ΦTR0
ΦTR1
Q21
Q22
61
RWL0
RWL1
RWL2
RWL3
RWL4
RWL5
RWL6
RWL7
RBL0
RBL1
51
Φ10
Φ11
Φ12
Φ13
Q11
Q12
Q13
Q14
4
BL0
BL1
BL2
BL3
WL0
WL1
WL2
WL3
11
DWL1
21

F I G. 22

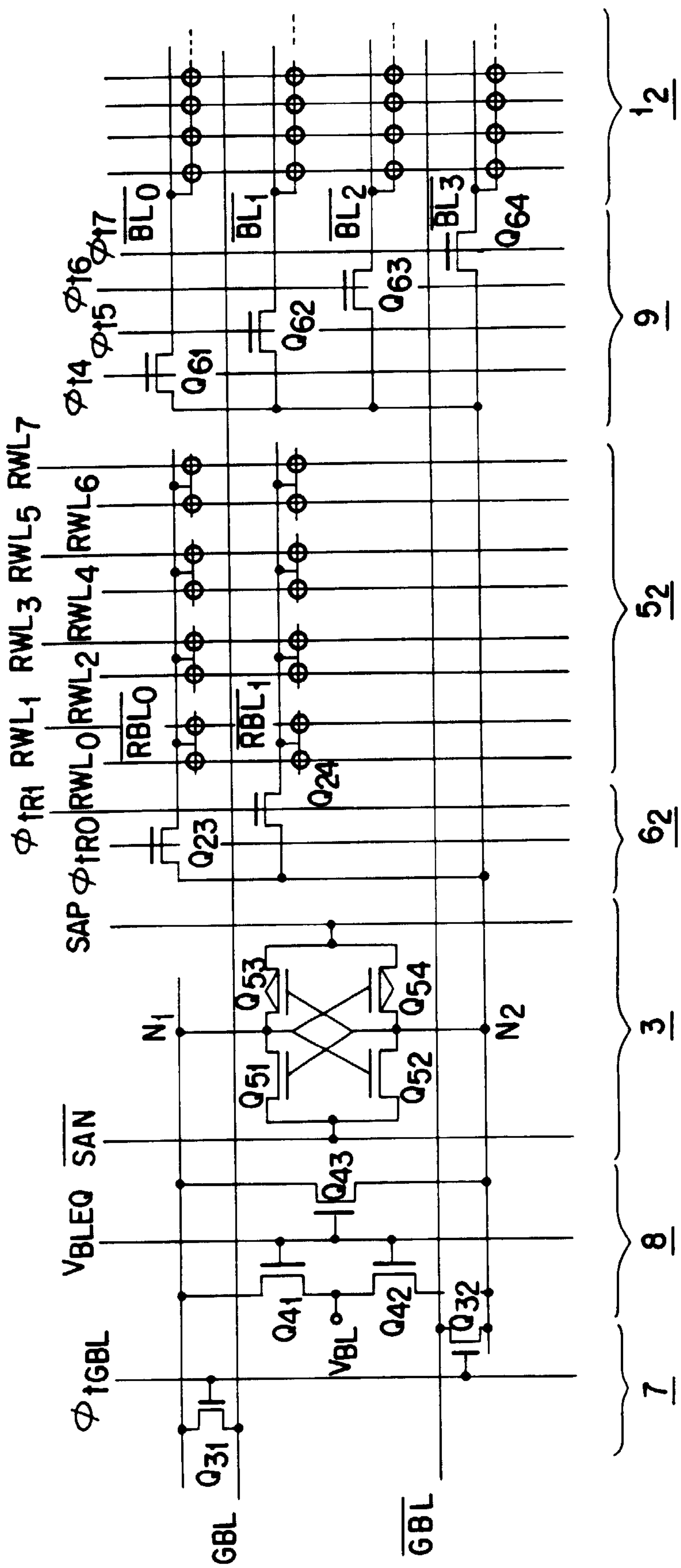

GBL
$\overline{GBL}$
Q31
Q32
Q41
Q42
Q43
Q51
Q52
Q53
Q54
Q23
Q24
Q61
Q62
Q63
Q64
$\phi_{tGBL}$
$V_{BL}$
$V_{BLEQ}$
$\overline{SAN}$
SAP
N1
N2
$\phi_{tR0}$
$\phi_{tR1}$
RWL0
RWL1
RWL2
RWL3
RWL4
RWL5
RWL6
RWL7
$\overline{RBL_0}$
$\overline{RBL_1}$
$\phi_{14}$
$\phi_{15}$
$\phi_{16}$
$\phi_{17}$
$\overline{BL_0}$
$\overline{BL_1}$
$\overline{BL_2}$
$\overline{BL_3}$
7
8
3
62
52
9
12


FIG. 23

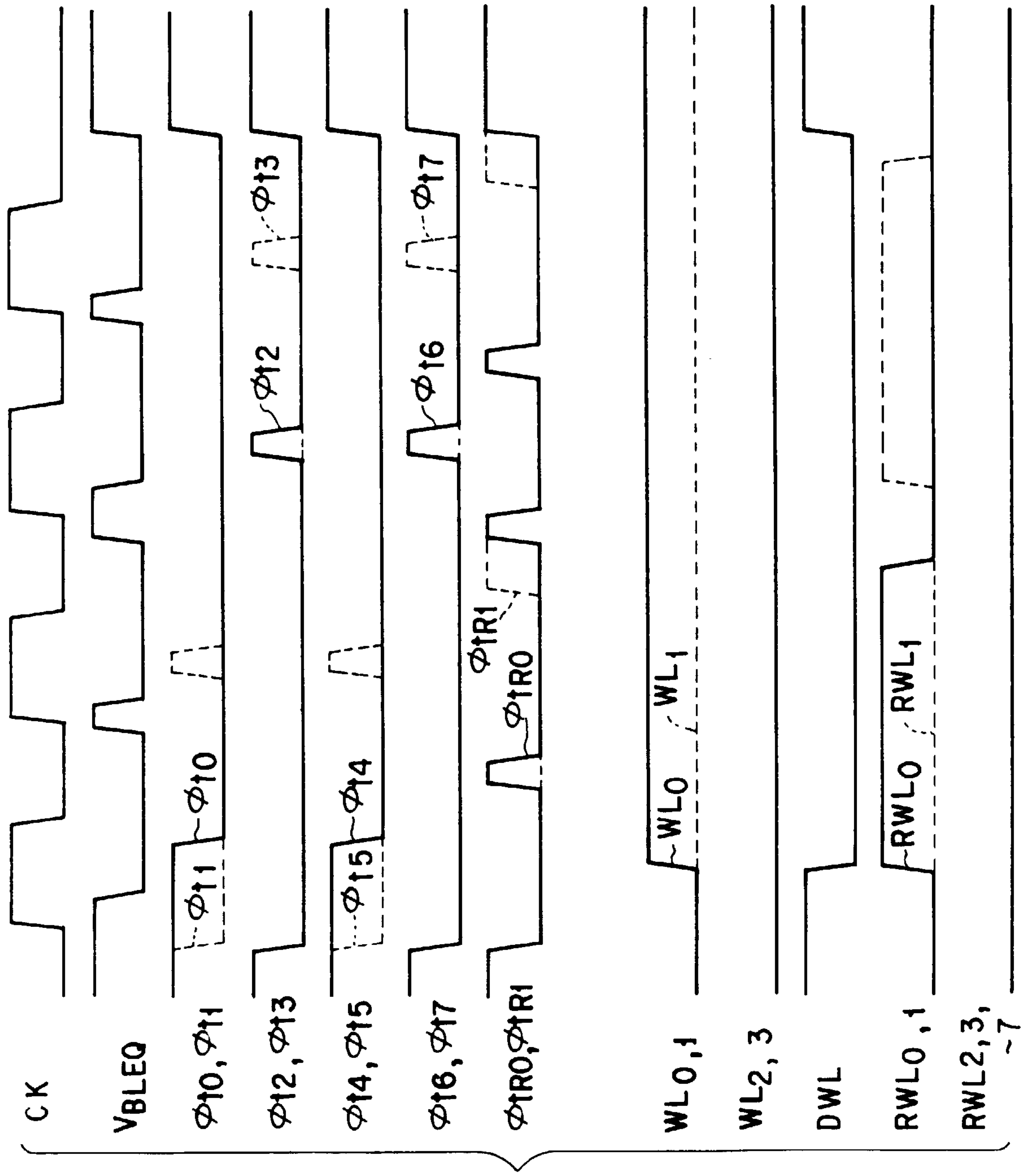

CK
$V_{BLEQ}$
φt10, φt11
φt12, φt13
φt14, φt15
φt16, φt17
φtR0, φtR1
$WL_{0,1}$
$WL_{2,3}$
DWL
$RWL_{0,1}$
$RWL_{2,3,\sim7}$
φt10
φt11
φt12
φt13
φt14
φt15
φt16
φt17
φtR0
φtR1
$WL_0$
$WL_1$
$RWL_0$
$RWL_1$


FIG. 24

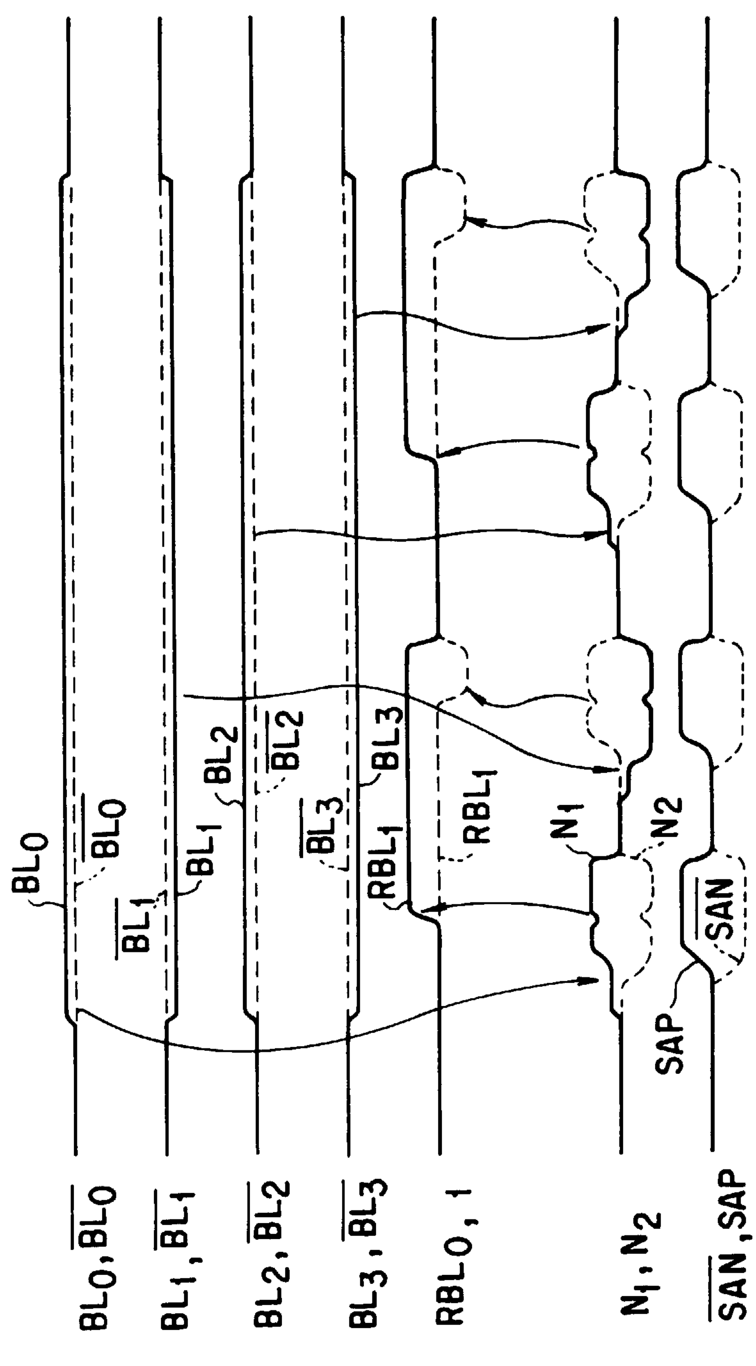
BL0, BL0
BL1, BL1
BL2, BL2
BL3, BL3
RBL0, 1
N1, N2
SAN, SAP
BL0
BL0
BL1
BL1
BL2
BL2
BL3
BL3
RBL1
RBL1
N1
N2
SAP
SAN

FIG. 25

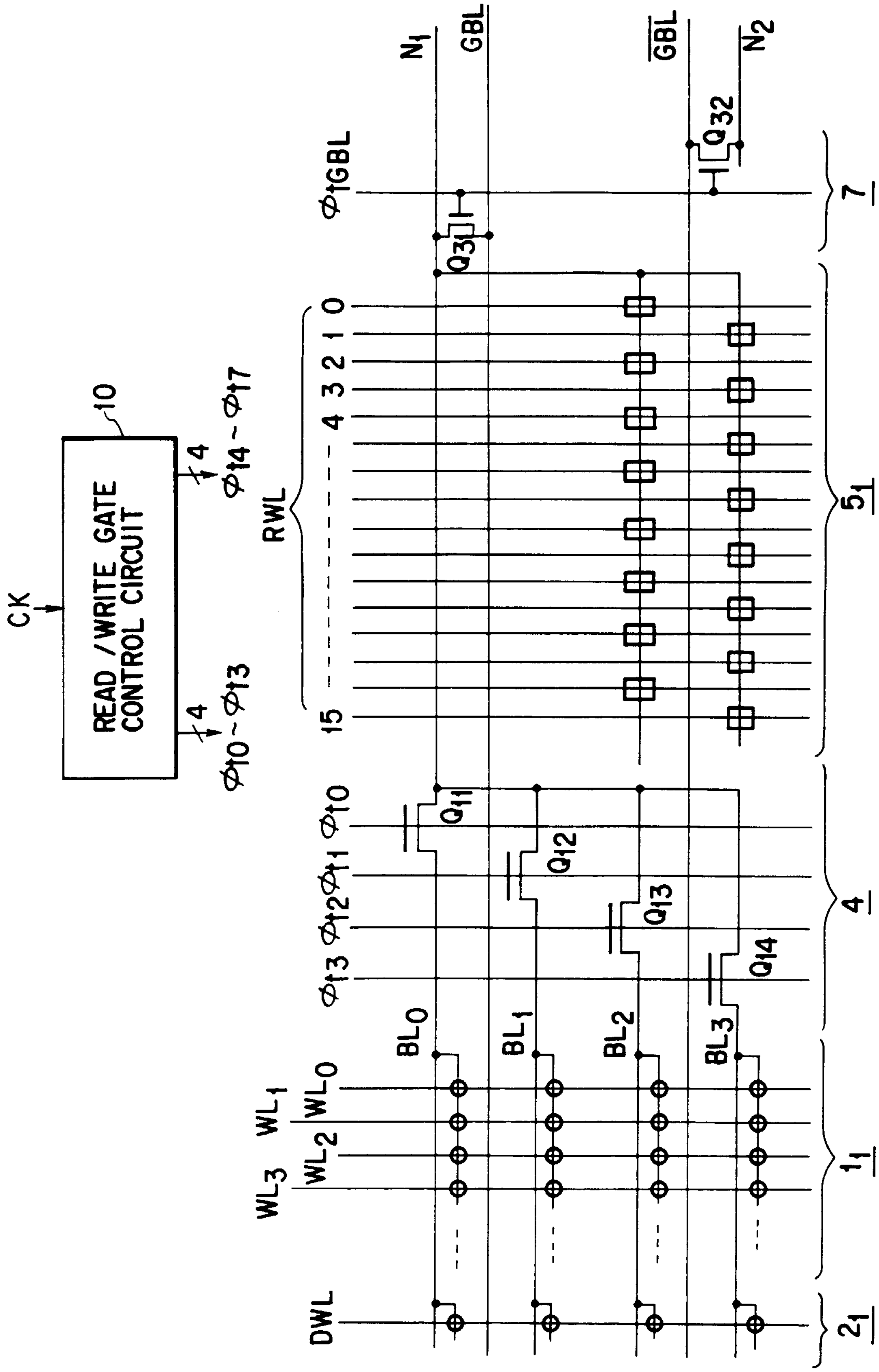

READ /WRITE GATE CONTROL CIRCUIT
10
CK
4
4
ϕ10~ϕ13
ϕ14~ϕ17
RWL
15
4 3 2 1 0
ϕ1GBL
N1
GBL
GBL
N2
Q31
Q32
ϕ10
ϕ11
ϕ12
ϕ13
Q11
Q12
Q13
Q14
BL0
BL1
BL2
BL3
WL0
WL1
WL2
WL3
DWL
7
51
4
11
21


F I G. 26

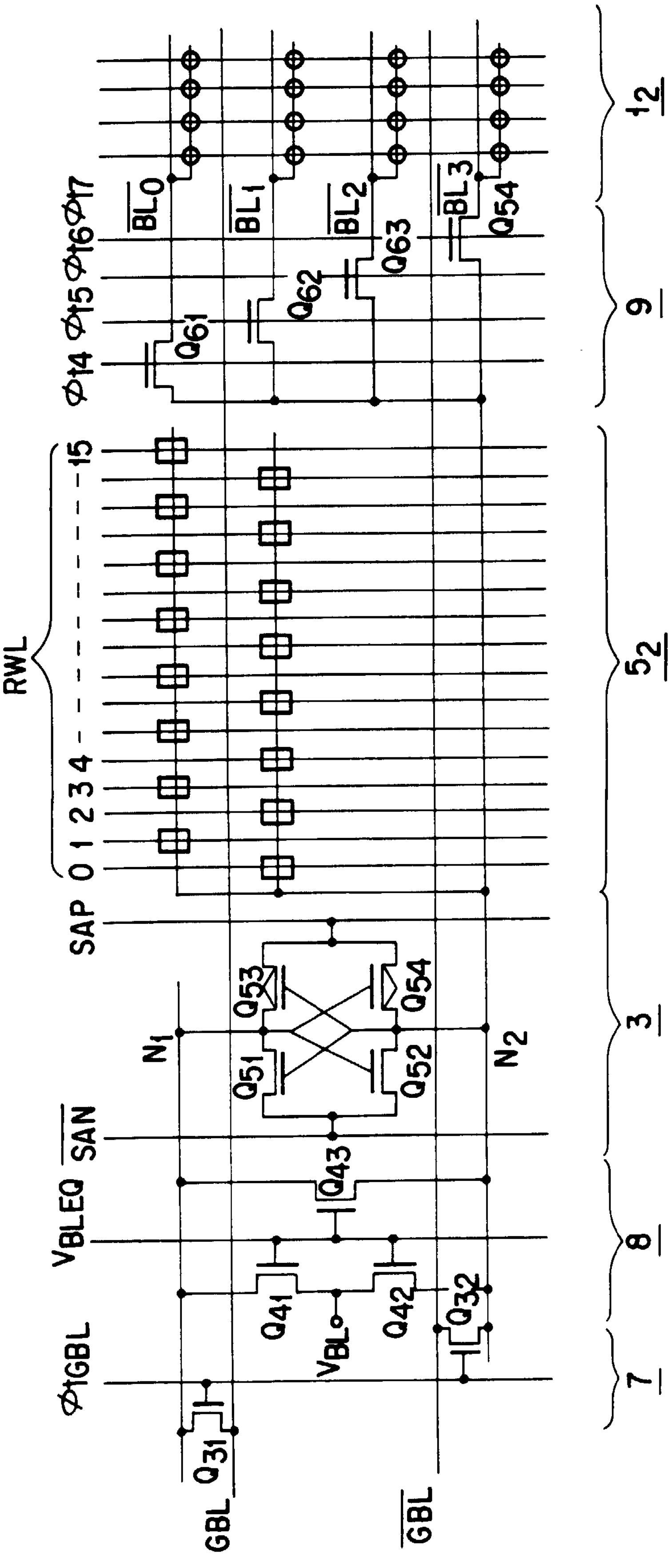

GBL
$\overline{GBL}$
Q31
Φ1GBL
Q32
Q41
Q42
$V_{BL}$
$V_{BLEQ}$
Q43
$\overline{SAN}$
Q51
Q52
Q53
Q54
N1
N2
SAP
RWL
0 1 2 3 4 15
Φ14 Φ15 Φ16 Φ17
Q61
Q62
Q63
Q54
$\overline{BL0}$
$\overline{BL1}$
$\overline{BL2}$
$\overline{BL3}$
7
8
3
52
9
12


F I G. 27

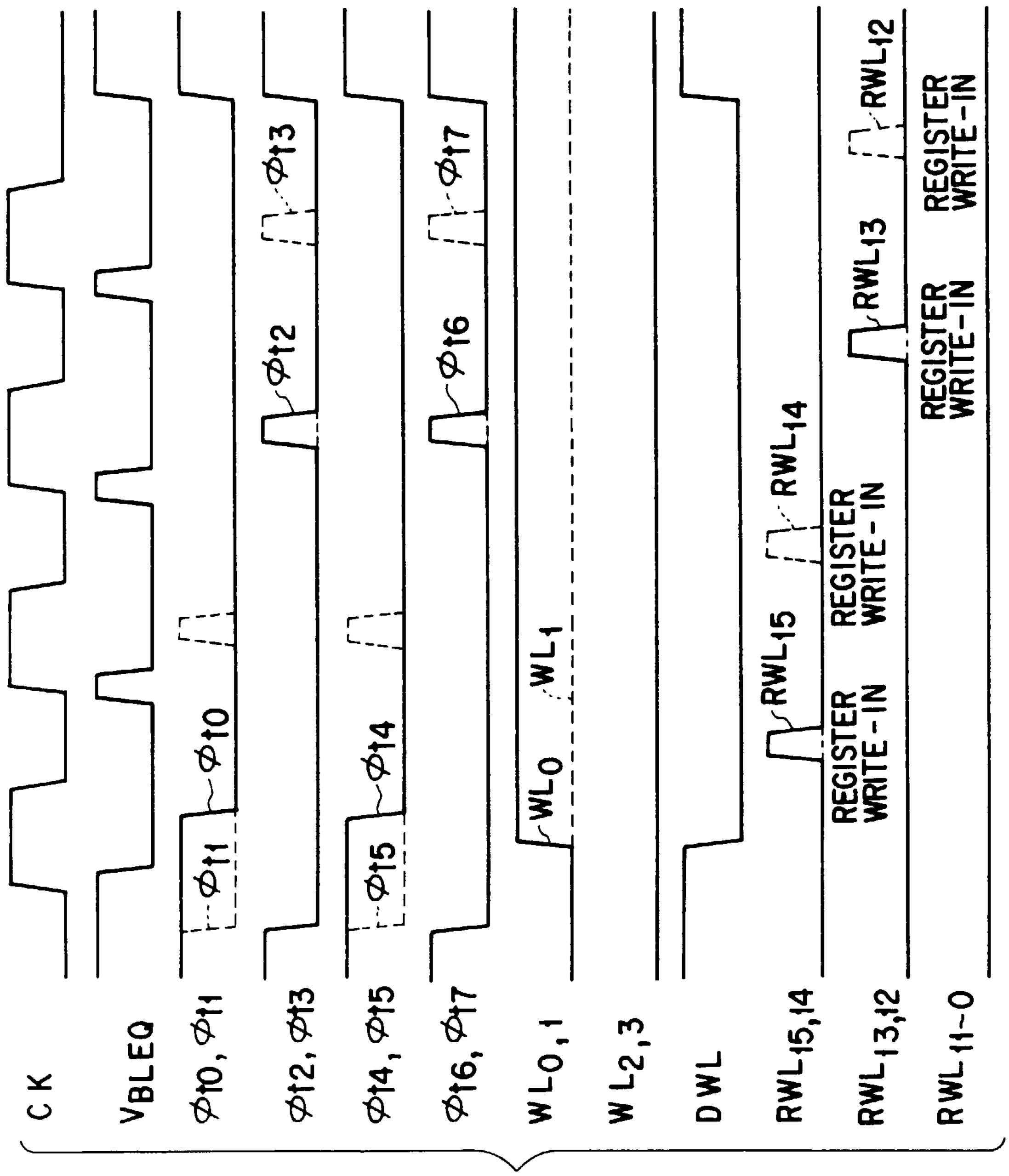
CK
$V_{BLEQ}$
$\phi t0, \phi t1$
$\phi t2, \phi t3$
$\phi t4, \phi t5$
$\phi t6, \phi t7$
$WL_{0,1}$
$WL_{2,3}$
DWL
$RWL_{15,14}$
$RWL_{13,12}$
$RWL_{11-0}$
$\phi t0$
$\phi t1$
$\phi t2$
$\phi t3$
$\phi t4$
$\phi t5$
$\phi t6$
$\phi t7$
$WL_0$
$WL_1$
$RWL_{15}$
$RWL_{14}$
$RWL_{13}$
$RWL_{12}$
REGISTER WRITE-IN
REGISTER WRITE-IN
REGISTER WRITE-IN
REGISTER WRITE-IN

FIG. 28

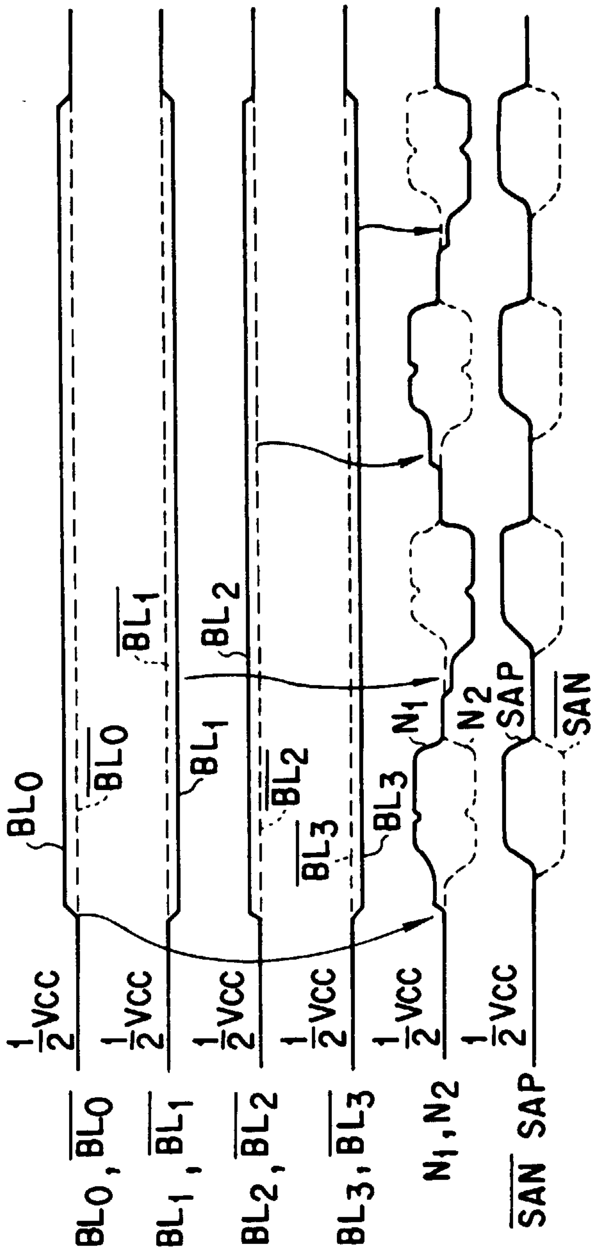
BL0, $\overline{BL0}$
BL1, $\overline{BL1}$
BL2, $\overline{BL2}$
BL3, $\overline{BL3}$
N1, N2
$\overline{SAN}$ SAP
$\frac{1}{2}$VCC
BL0
$\overline{BL0}$
BL1
$\overline{BL1}$
BL2
$\overline{BL2}$
BL3
$\overline{BL3}$
N1
N2
SAP
$\overline{SAN}$

FIG. 29

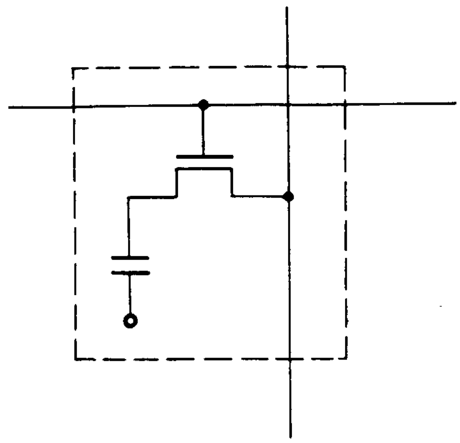

FIG. 30A

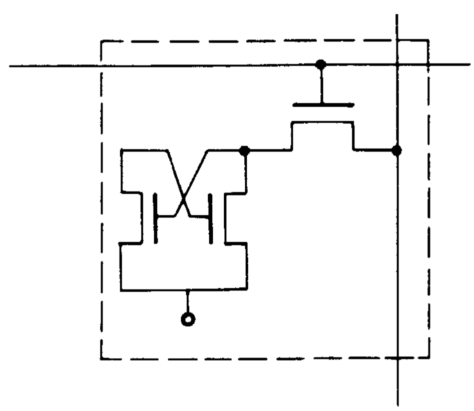

FIG. 30B

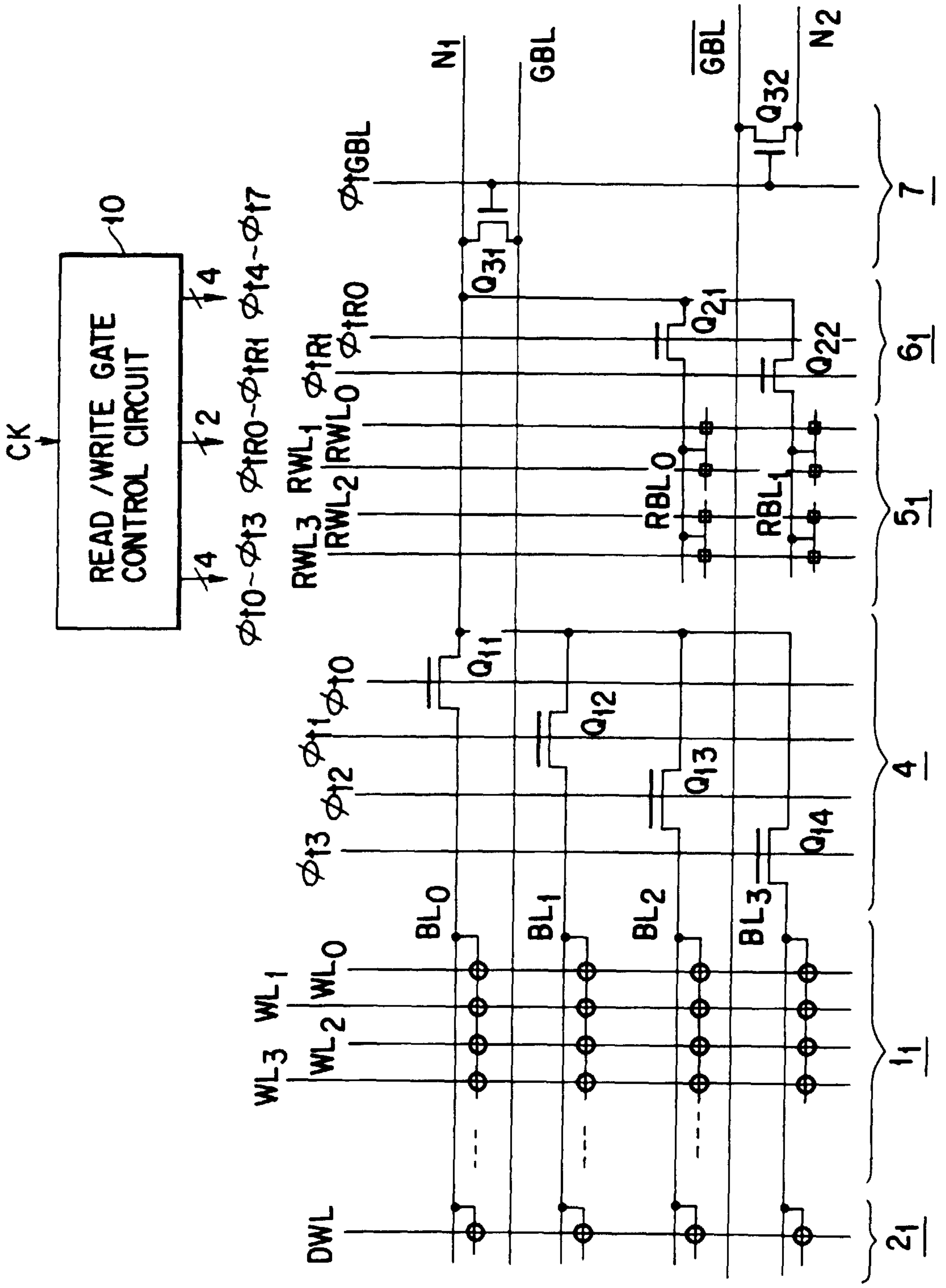
READ /WRITE GATE CONTROL CIRCUIT
10
CK
4
2
4
Φt0~Φt3
ΦtR0~ΦtR1
Φt4~Φt7
WL3
WL2
WL1
WL0
DWL
BL0
BL1
BL2
BL3
Φt3
Φt2
Φt1
Φt0
Q11
Q12
Q13
Q14
RWL3
RWL2
RWL1
RWL0
RBL0
RBL1
ΦtR1
ΦtR0
Q21
Q22
ΦtGBL
Q31
Q32
N1
GBL
GBL
N2
21
11
4
51
61
7

FIG. 31

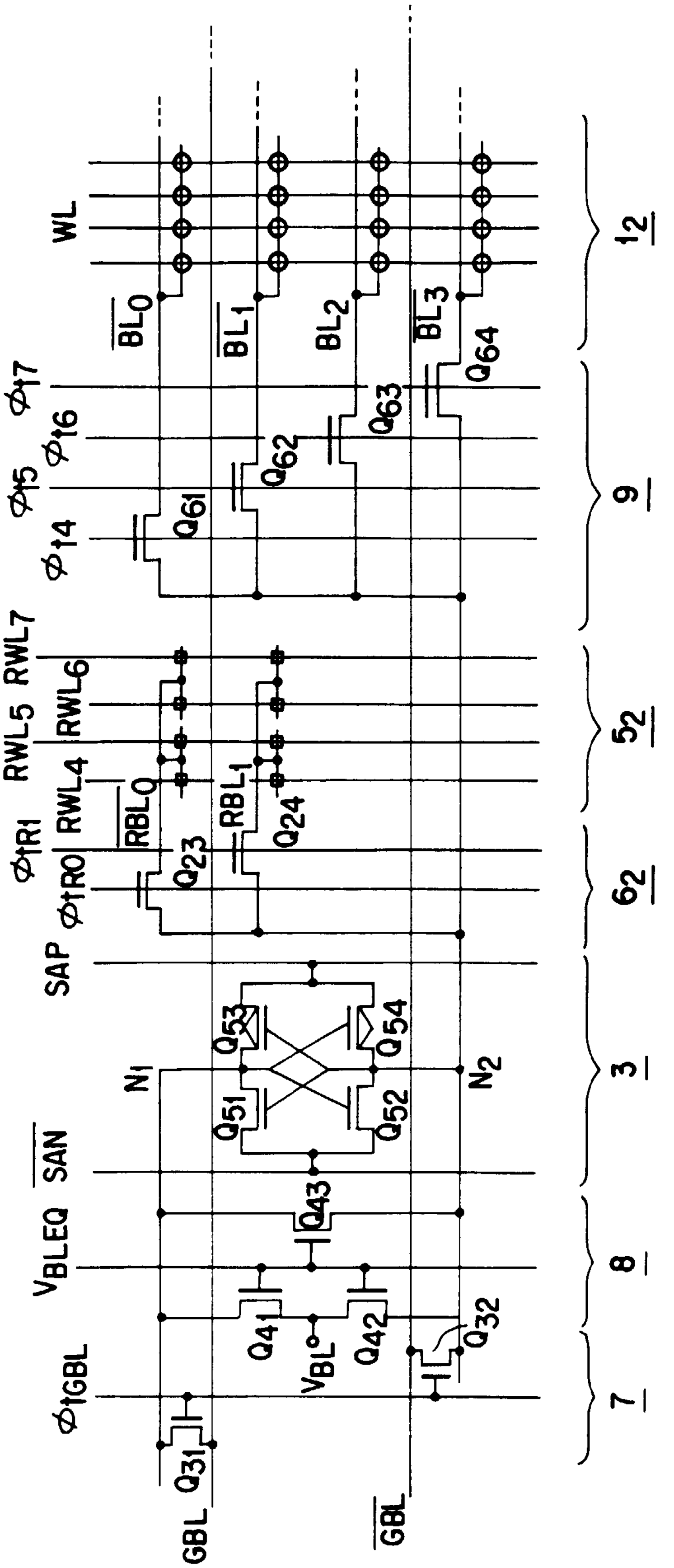

WL
$\overline{BL_0}$
$\overline{BL_1}$
$BL_2$
$\overline{BL_3}$
12
Φ14
Φ15
Φ16
Φ17
Q61
Q62
Q63
Q64
9
RWL4
RWL5
RWL6
RWL7
$\overline{RBL_0}$
$RBL_1$
52
ΦTR0
ΦTR1
Q23
Q24
62
SAP
$\overline{SAN}$
N1
N2
Q51
Q52
Q53
Q54
3
VBLEQ
Q41
Q42
Q43
VBL
8
ΦTGBL
Q31
Q32
7
GBL
$\overline{GBL}$


F I G. 32

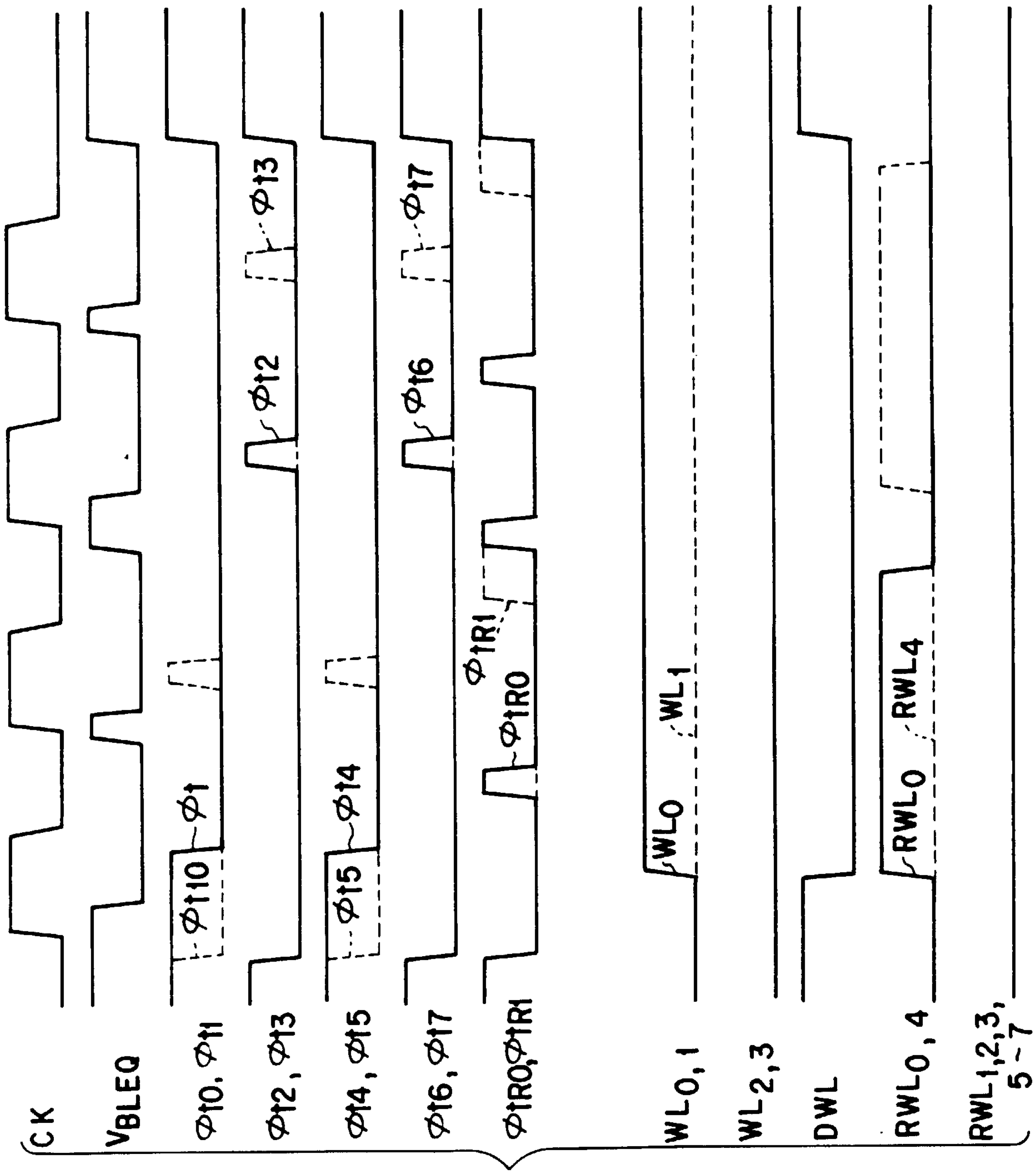
CK
VBLEQ
φt10, φt11
φt12, φt13
φt14, φt15
φt16, φt17
φtR0, φtR1
WL0, 1
WL2, 3
DWL
RWL0, 4
RWL1,2,3, 5~7
φt10
φt1
φt15
φt14
φt12
φt13
φt16
φt17
φtR0
φtR1
WL0
WL1
RWL0
RWL4

FIG. 33

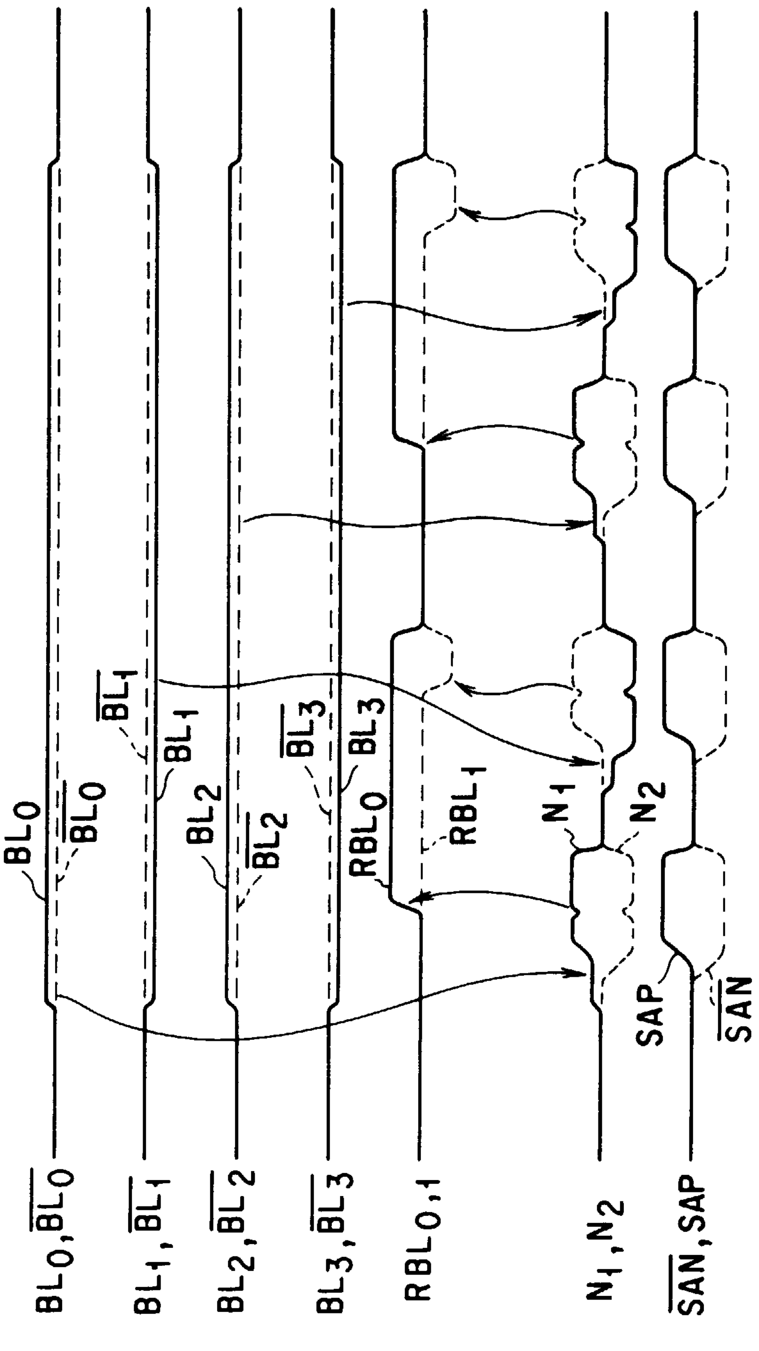
BL0, BL0
BL1, BL1
BL2, BL2
BL3, BL3
RBL0,1
N1, N2
SAN, SAP
BL0
BL0
BL1
BL1
BL2
BL2
BL3
BL3
RBL0
RBL1
N1
N2
SAP
SAN

FIG. 34

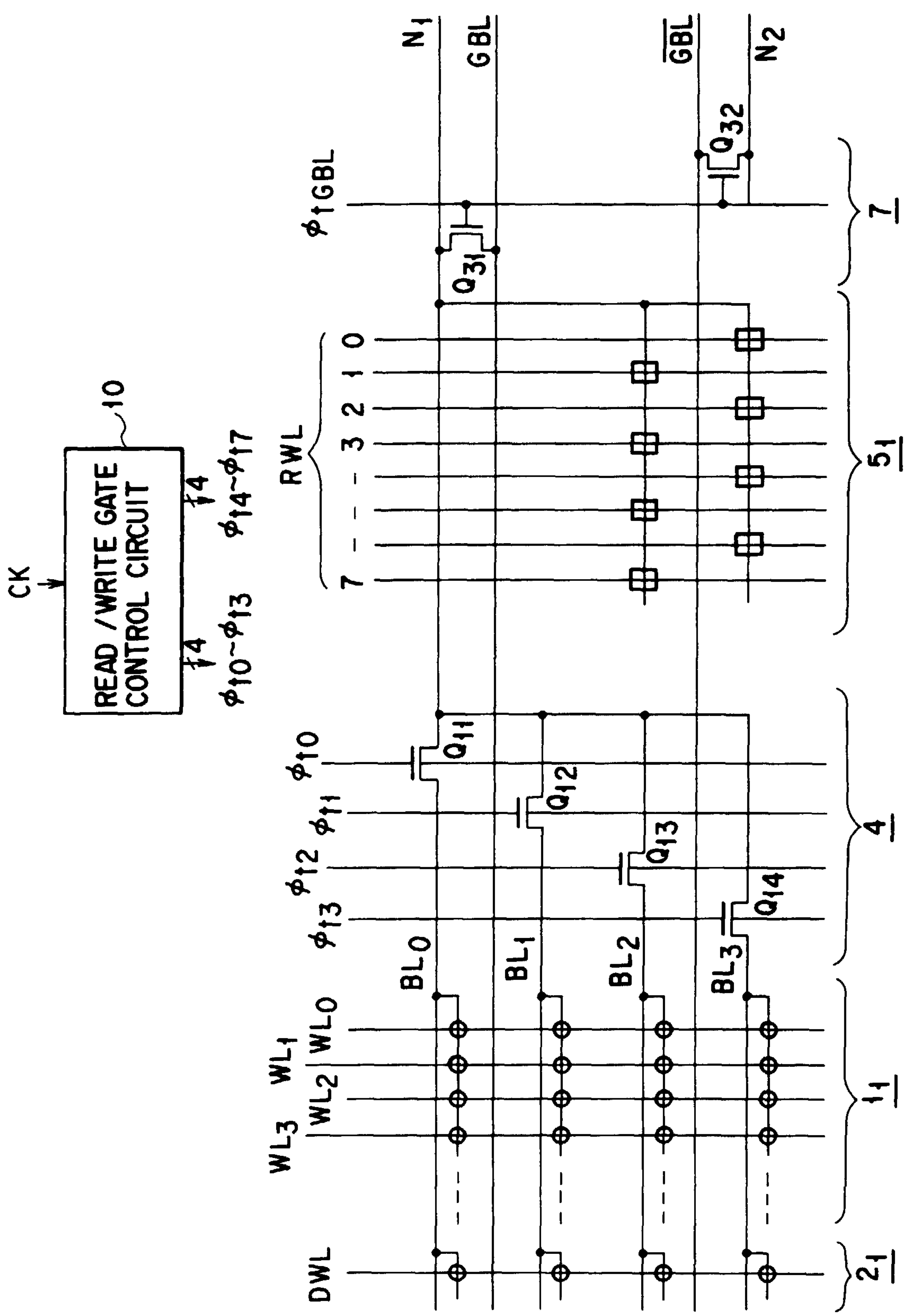
CK
READ /WRITE GATE CONTROL CIRCUIT
10
4
$\phi_{10}$~$\phi_{13}$
4
$\phi_{14}$~$\phi_{17}$
RWL
0
1
2
3
7
$\phi_{1GBL}$
$N_1$
GBL
$\overline{GBL}$
$N_2$
$Q_{31}$
$Q_{32}$
$\phi_{10}$
$\phi_{11}$
$\phi_{12}$
$\phi_{13}$
$Q_{11}$
$Q_{12}$
$Q_{13}$
$Q_{14}$
$BL_0$
$BL_1$
$BL_2$
$BL_3$
$WL_0$
$WL_1$
$WL_2$
$WL_3$
DWL
$1_1$
$2_1$
4
$5_1$
7

FIG. 35

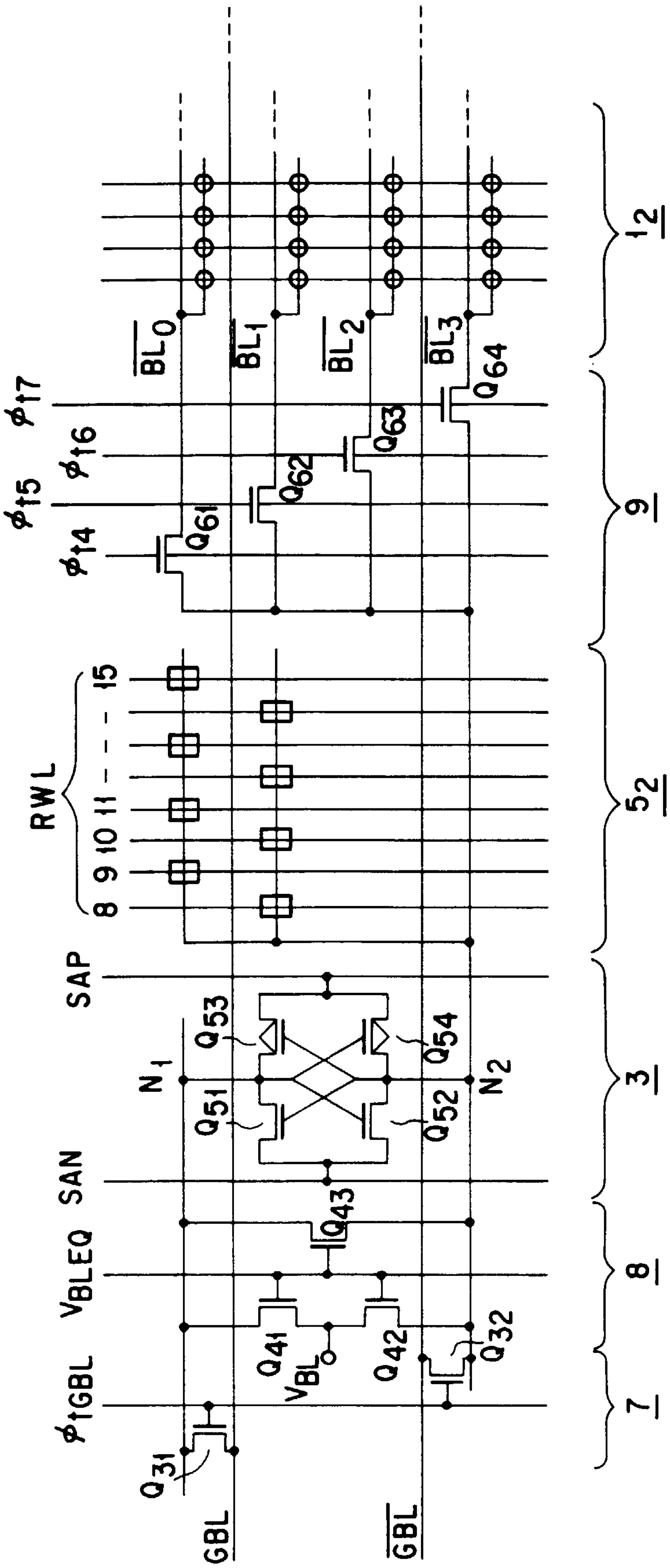
GBL
GBL
Q31
ϕtGBL
Q41
VBL
Q42
Q32
VBLEQ
Q43
SAN
Q51
Q52
N1
N2
Q53
Q54
SAP
RWL
8 9 10 11 - - - 15
ϕt4
ϕt5
ϕt6
ϕt7
Q61
Q62
Q63
Q64
BL0
BL1
BL2
BL3
7
8
3
52
9
12

FIG. 36

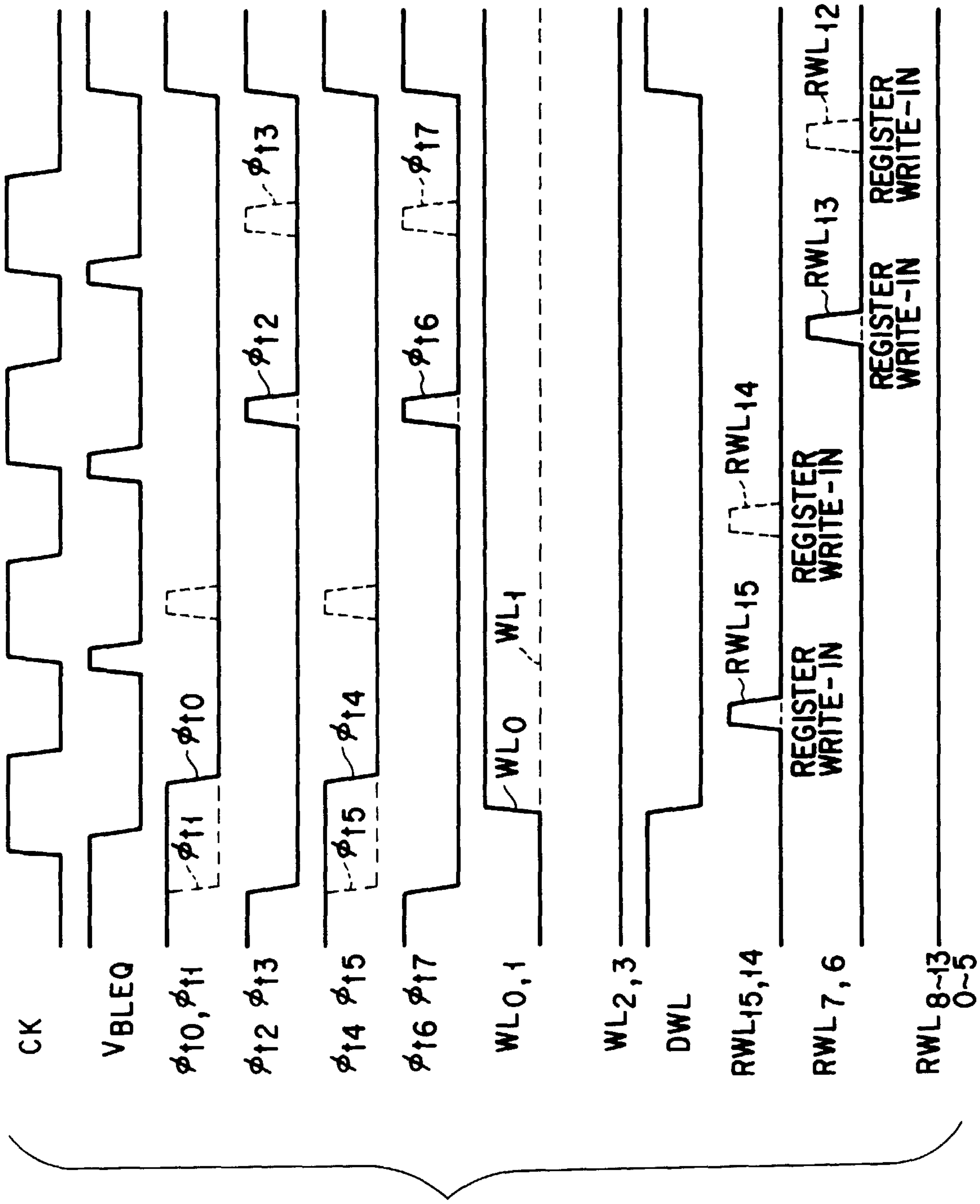
CK
VBLEQ
φt0, φt1
φt2 φt3
φt4 φt5
φt6 φt7
WL0,1
WL2,3
DWL
RWL15,14
RWL7,6
RWL8~13 0~5
φt0
φt1
φt2
φt3
φt4
φt5
φt6
φt7
WL0
WL1
RWL15
RWL14
RWL13
RWL12
REGISTER WRITE-IN
REGISTER WRITE-IN
REGISTER WRITE-IN
REGISTER WRITE-IN

FIG. 37

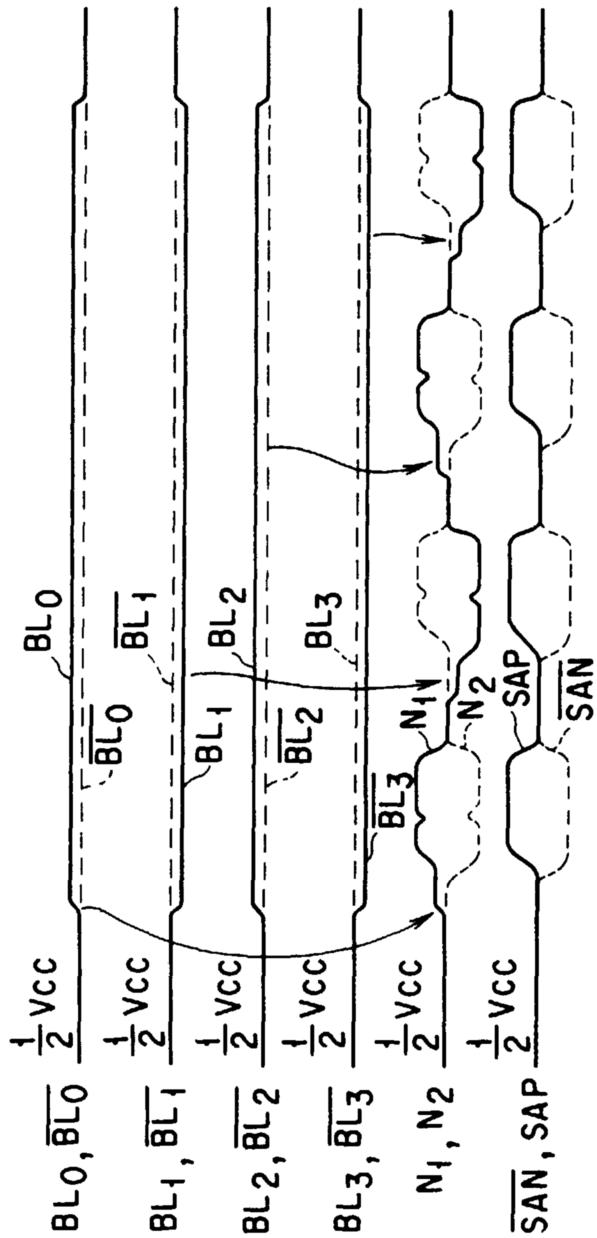
BL0, $\overline{BL0}$
BL1, $\overline{BL1}$
BL2, $\overline{BL2}$
BL3, $\overline{BL3}$
N1, N2
$\overline{SAN}$, SAP
$\frac{1}{2}$ Vcc
BL0
$\overline{BL1}$
BL2
BL3
$\overline{BL0}$
BL1
$\overline{BL2}$
$\overline{BL3}$
N1
N2
SAP
$\overline{SAN}$

FIG. 38

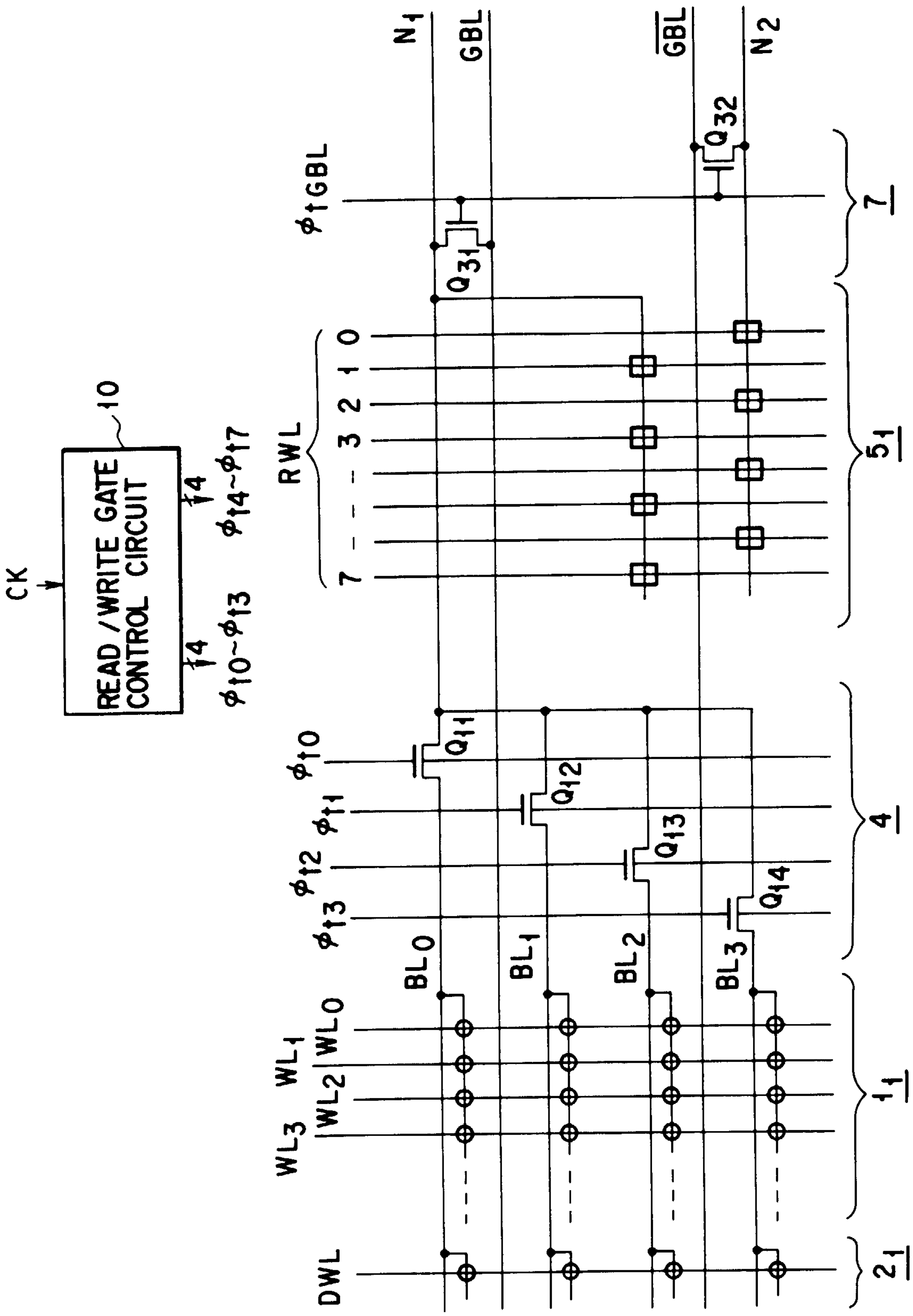
CK
READ /WRITE GATE CONTROL CIRCUIT
10
4
4
$\phi_{t0}\sim\phi_{t3}$
$\phi_{t4}\sim\phi_{t7}$
RWL
7 - - - 3 2 1 0
$\phi_{tGBL}$
$N_1$
GBL
$\overline{GBL}$
$N_2$
$Q_{31}$
$Q_{32}$
$\phi_{t0}$
$\phi_{t1}$
$\phi_{t2}$
$\phi_{t3}$
$Q_{11}$
$Q_{12}$
$Q_{13}$
$Q_{14}$
$BL_0$
$BL_1$
$BL_2$
$BL_3$
$WL_0$
$WL_1$
$WL_2$
$WL_3$
DWL
$2_1$
$1_1$
4
$5_1$
7

F I G. 39

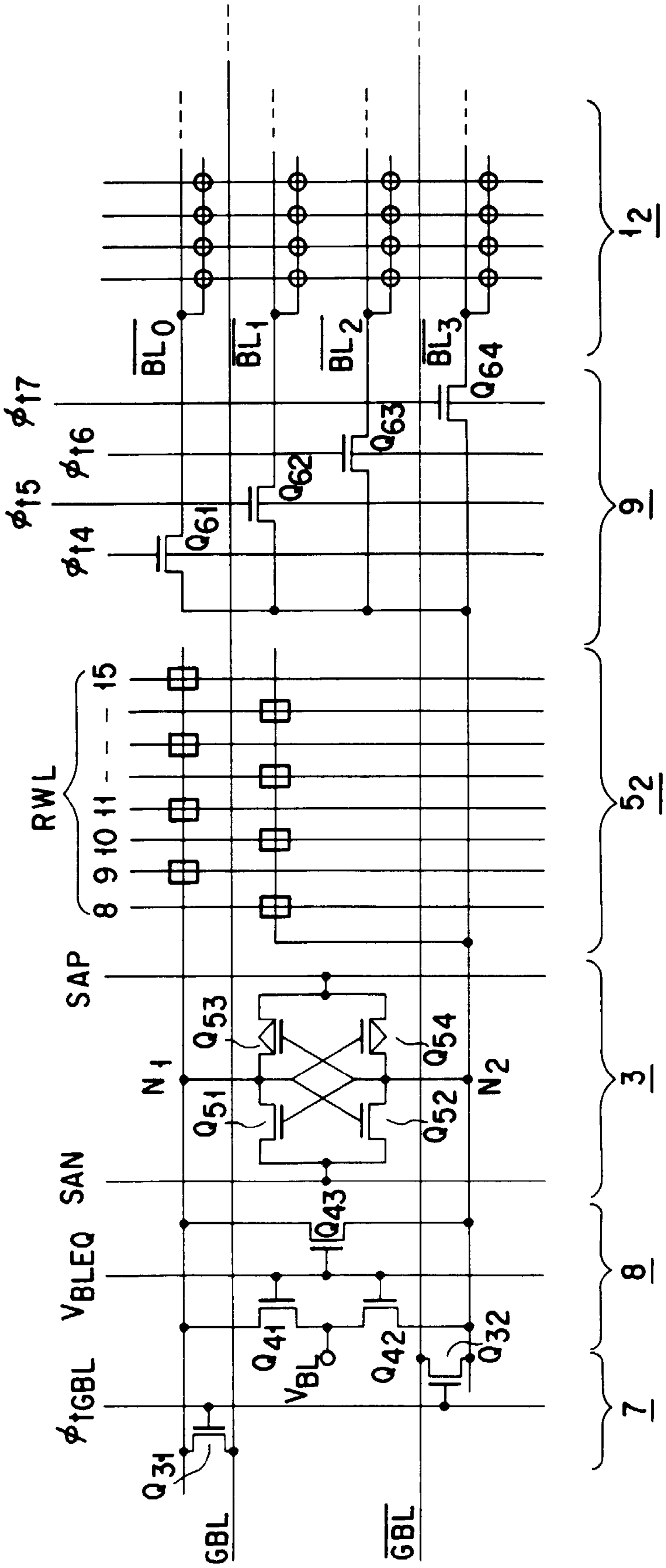
GBL
GBL
Q31
φtGBL
VBLEQ
SAN
SAP
RWL
8 9 10 11 - - - 15
φ14
φ15
φ16
φ17
Q61
Q62
Q63
Q64
BL0
BL1
BL2
BL3
Q41
Q42
Q43
Q32
VBL
Q51
Q52
Q53
Q54
N1
N2
7
8
3
52
9
12

FIG. 40

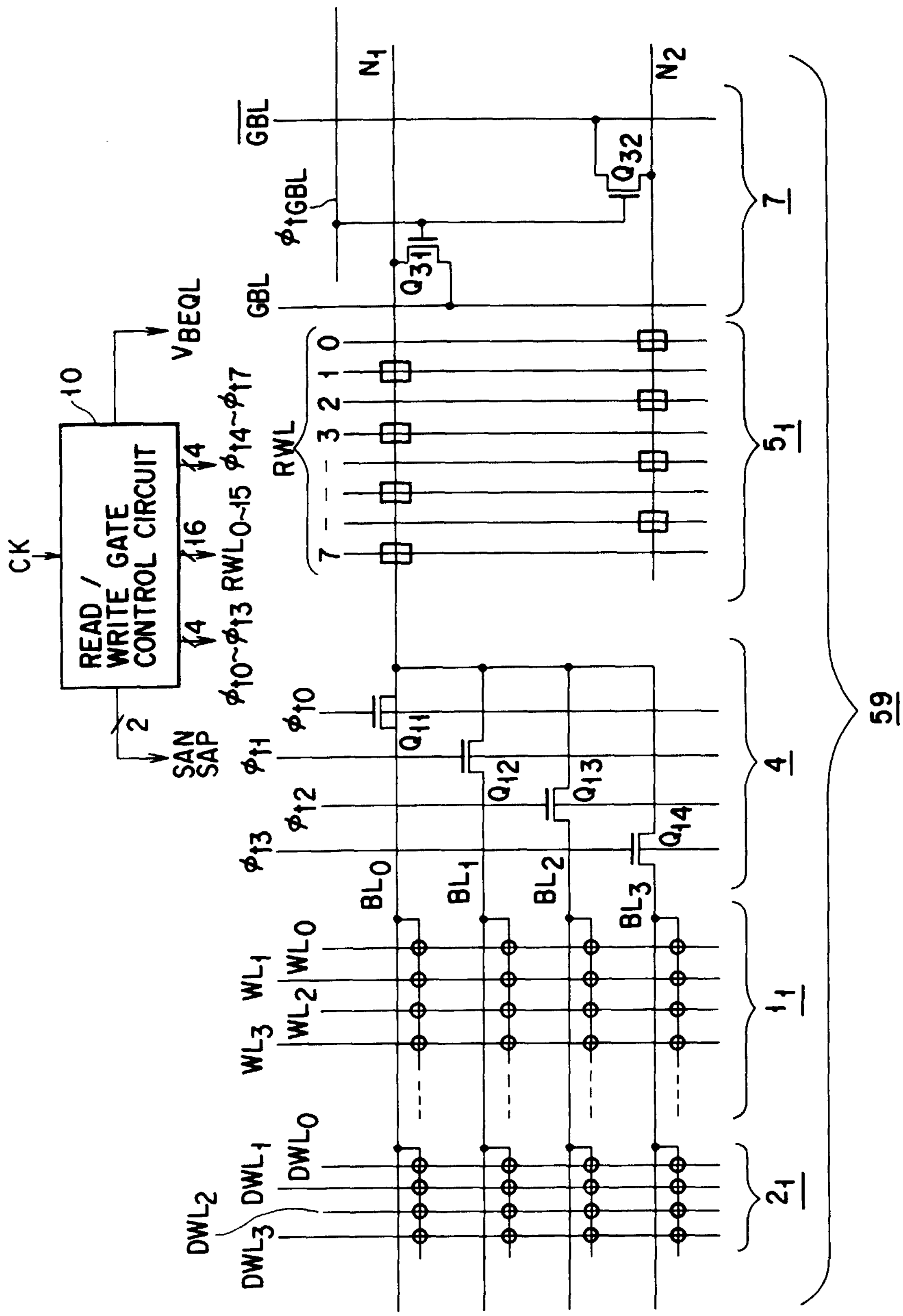
CK
READ / WRITE GATE CONTROL CIRCUIT
10
VBEQL
SAN
SAP
2
4
16
4
φ10~φ13
RWL0~15
φ14~φ17
RWL
7
3
2
1
0
GBL
φ1GBL
GBL
Q31
Q32
N1
N2
φ10
φ11
φ12
φ13
Q11
Q12
Q13
Q14
BL0
BL1
BL2
BL3
WL0
WL1
WL2
WL3
DWL0
DWL1
DWL2
DWL3
21
11
4
51
7
59

FIG. 41

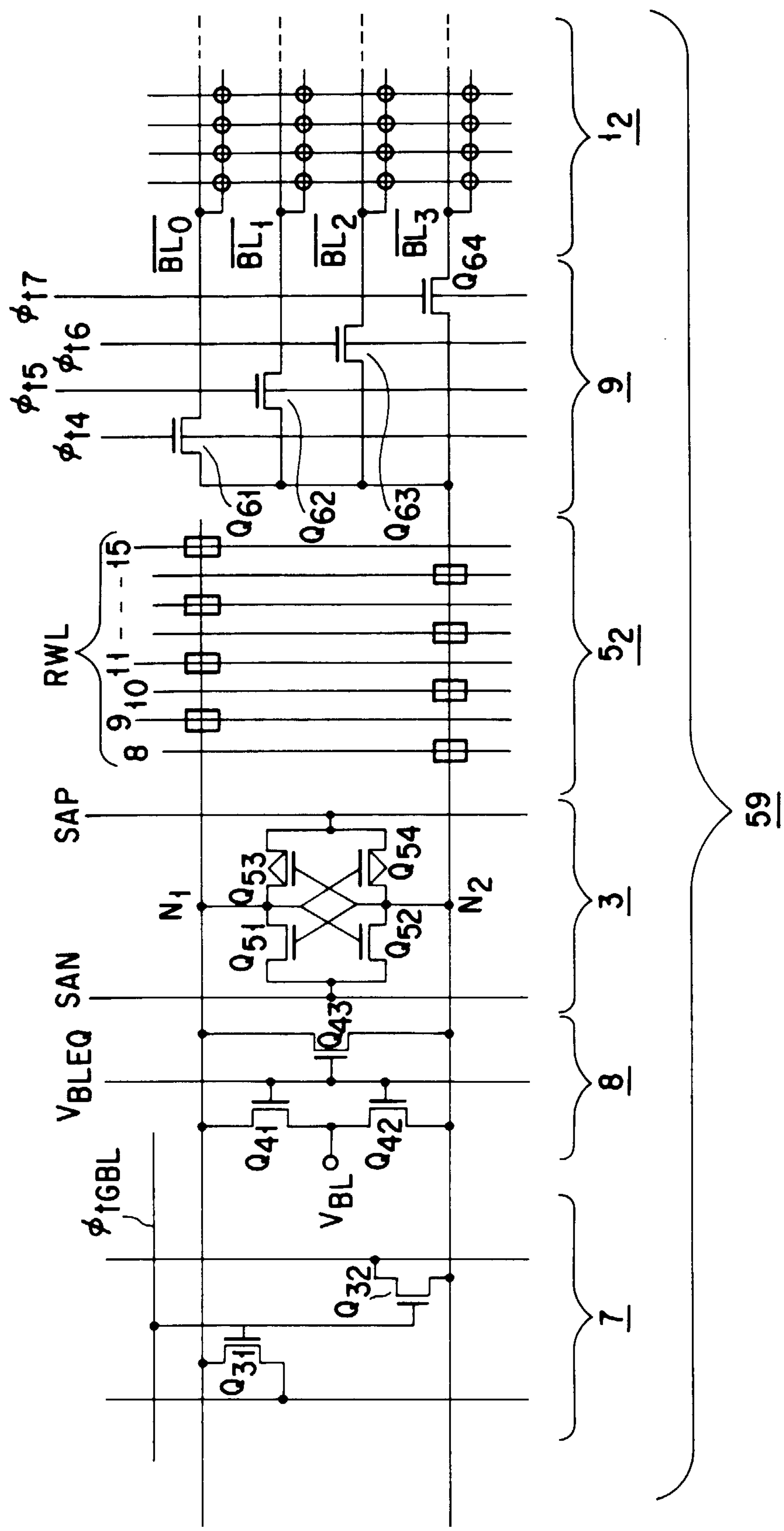

$\overline{BL_0}$
$\overline{BL_1}$
$\overline{BL_2}$
$\overline{BL_3}$
12
$\phi_{t7}$
$\phi_{t6}$
$\phi_{t5}$
$\phi_{t4}$
Q61
Q62
Q63
Q64
9
RWL
8
9
10
11
15
52
SAP
SAN
N1
N2
Q51
Q52
Q53
Q54
3
VBLEQ
Q41
Q42
Q43
VBL
8
$\phi_{tGBL}$
Q31
Q32
7
59


FIG. 42

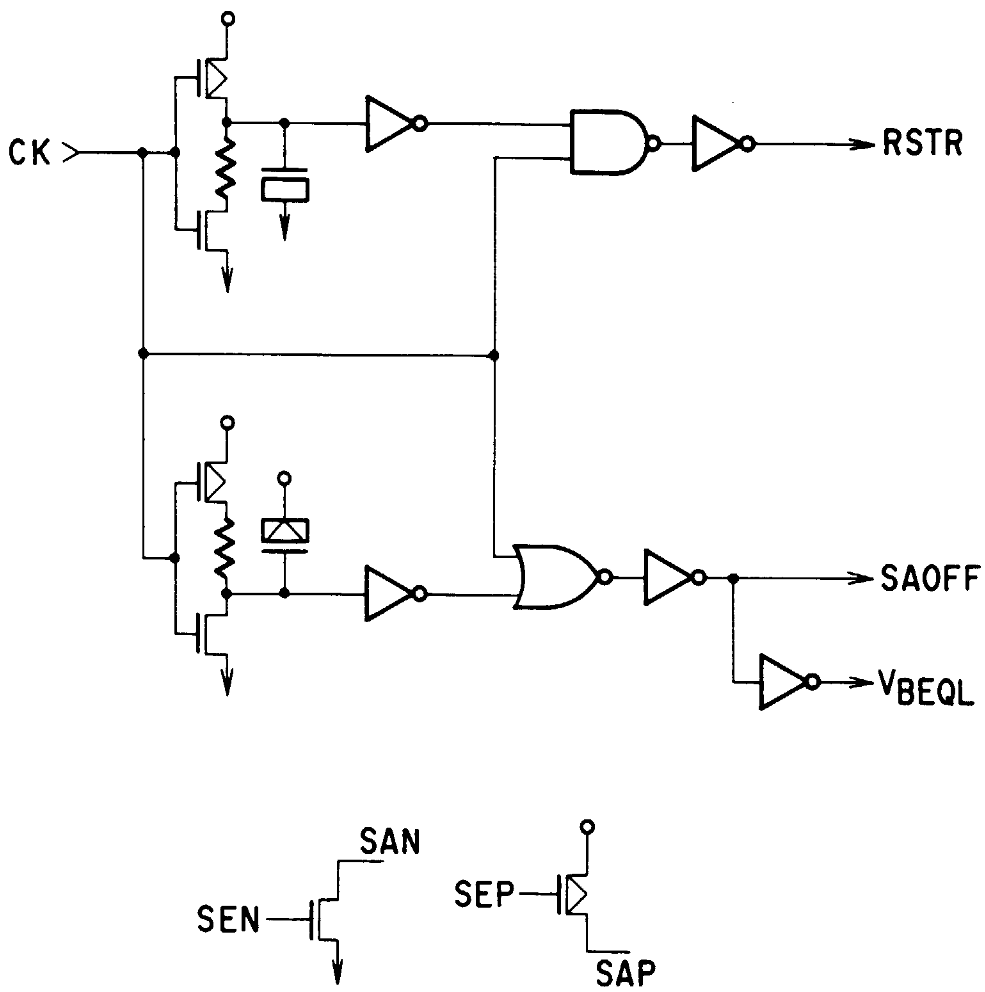


F I G. 45

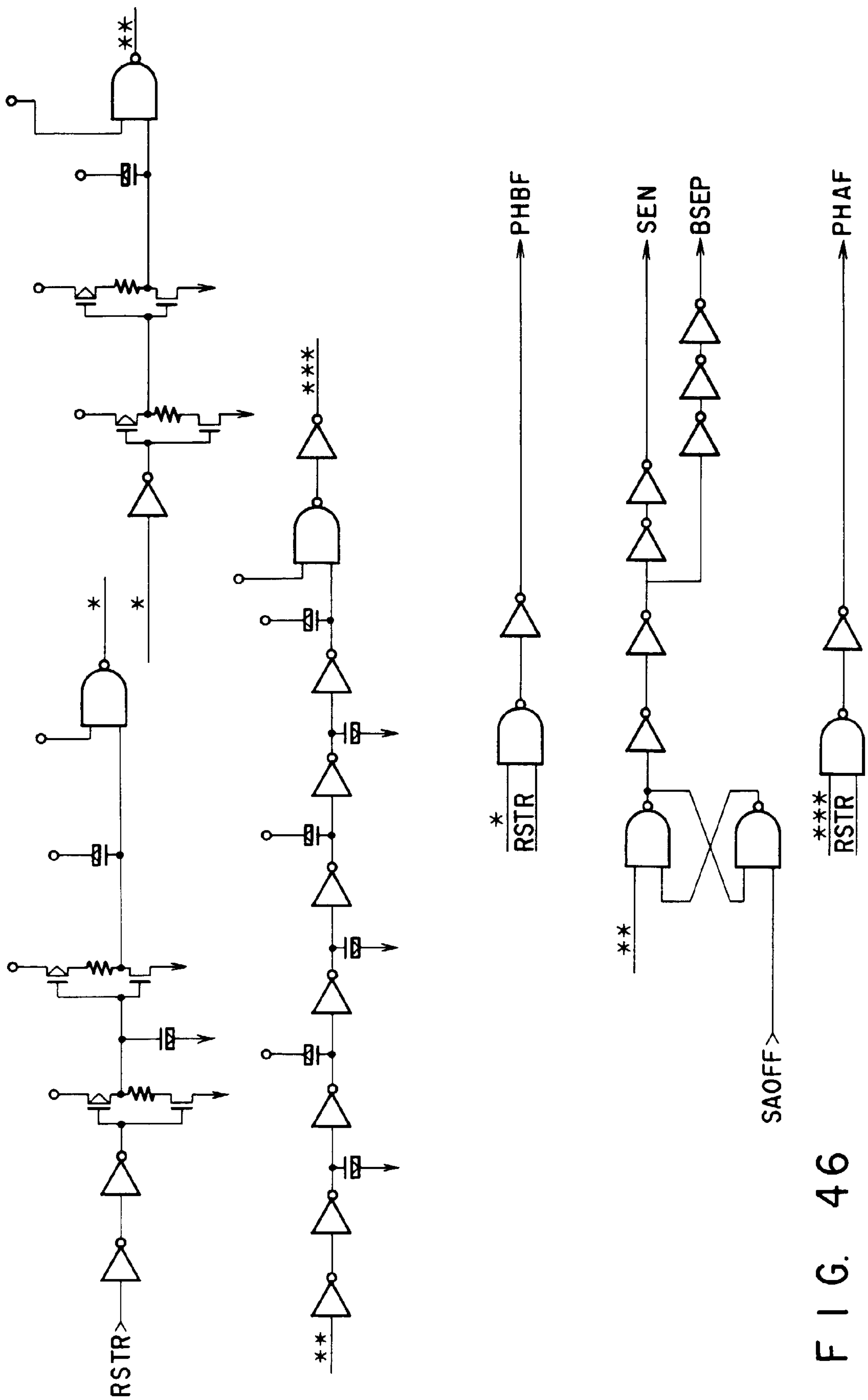


FIG. 46

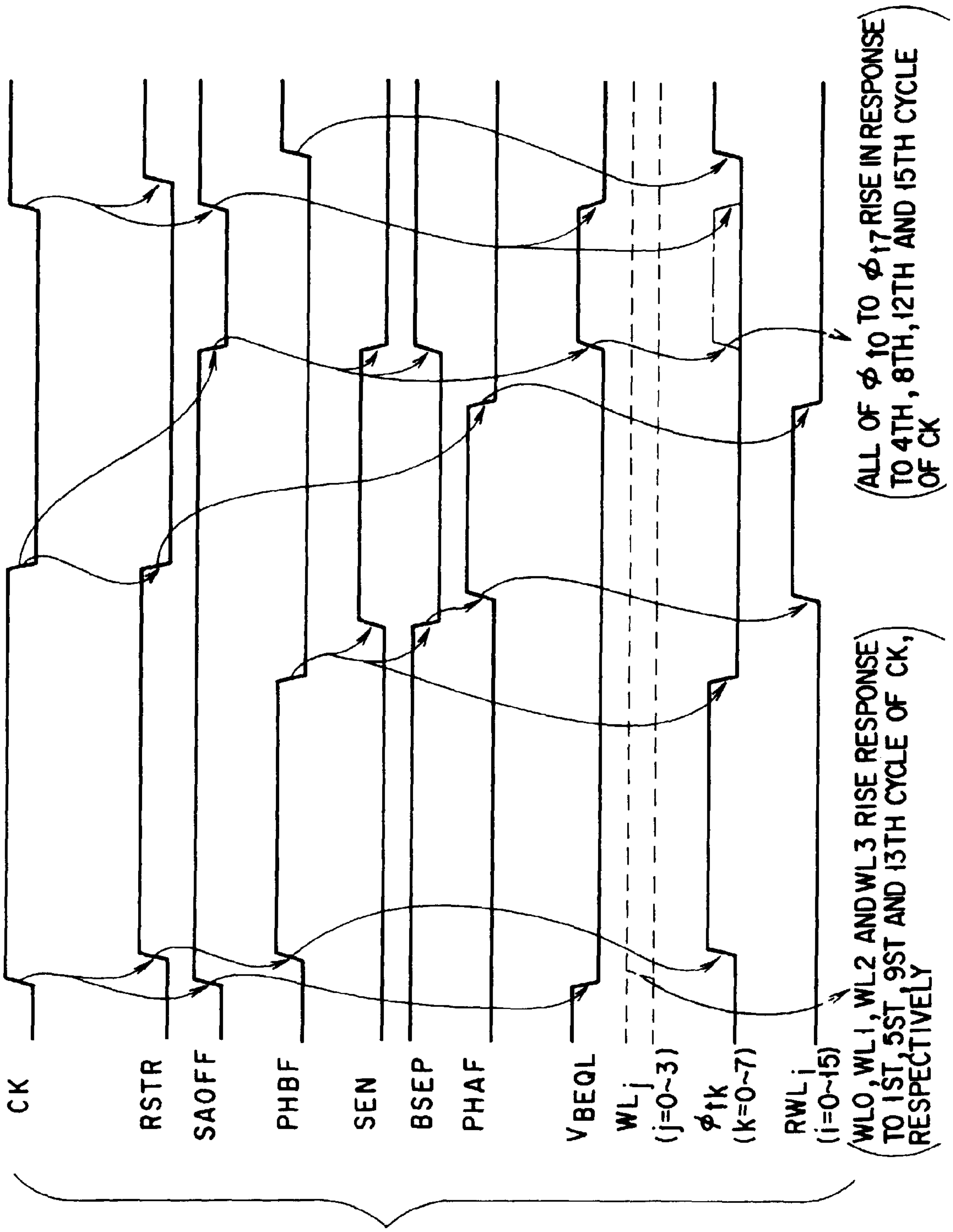
CK
RSTR
SAOFF
PHBF
SEN
BSEP
PHAF
$V_{BEQL}$
$WL_j$ (j=0~3)
$\phi_{tk}$ (k=0~7)
$RWL_i$ (i=0~15)
(WL0, WL1, WL2 AND WL3 RISE RESPONSE TO 1ST, 5ST, 9ST AND 13TH CYCLE OF CK, RESPECTIVELY)
(ALL OF $\phi_{10}$ TO $\phi_{17}$ RISE IN RESPONSE TO 4TH, 8TH, 12TH AND 15TH CYCLE OF CK)

FIG. 47

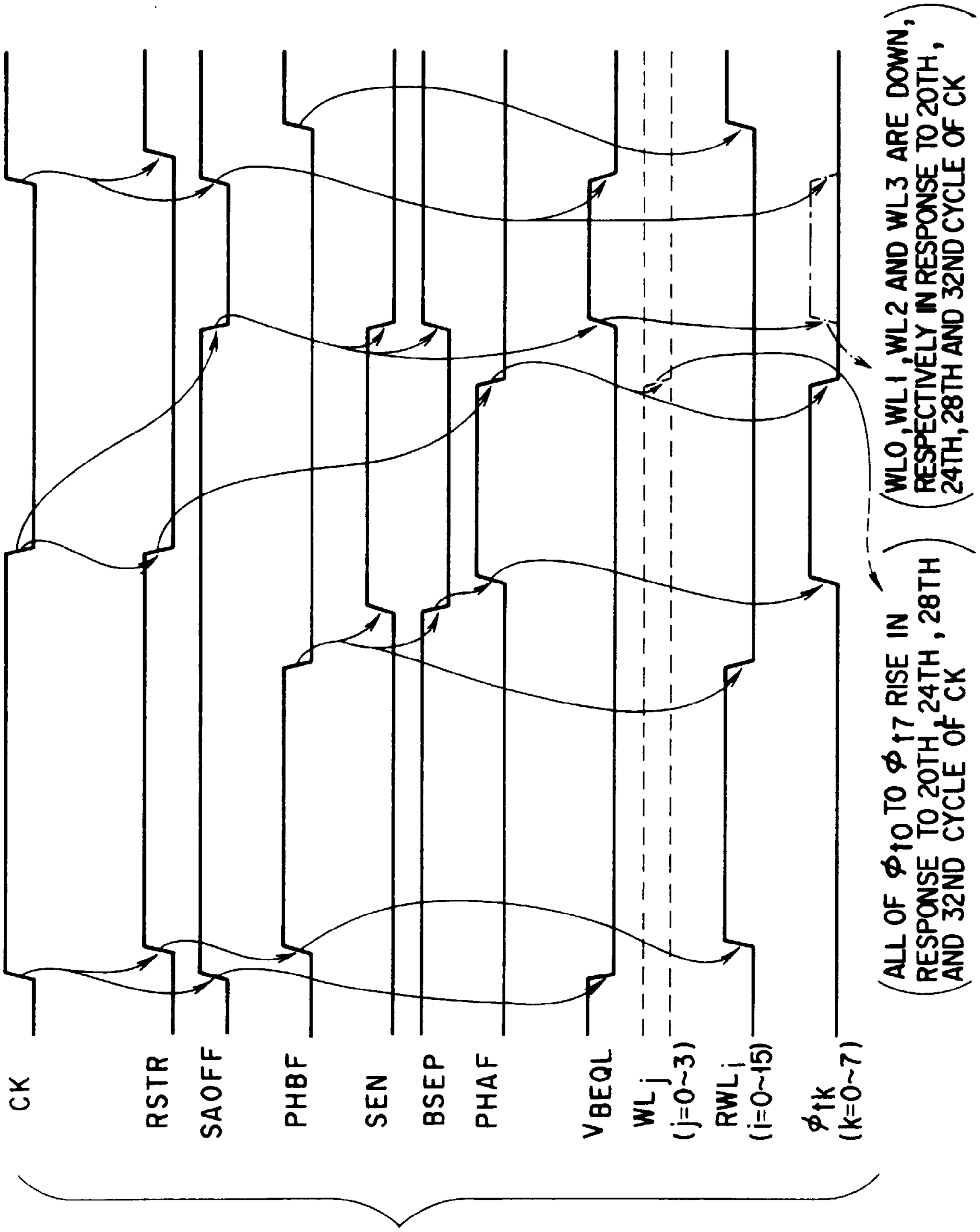
CK
RSTR
SAOFF
PHBF
SEN
BSEP
PHAF
$V_{BEQL}$
$WL_j$ (j=0~3)
$RWL_i$ (i=0~15)
$\phi_{tk}$ (k=0~7)
ALL OF $\phi_{t0}$ TO $\phi_{t7}$ RISE IN RESPONSE TO 20TH, 24TH, 28TH AND 32ND CYCLE OF CK
WL0, WL1, WL2 AND WL3 ARE DOWN, RESPECTIVELY IN RESPONSE TO 20TH, 24TH, 28TH AND 32ND CYCLE OF CK

F I G. 48

| | | 1 | 2 | 3 | 4 | 5 | 6 | 7 | 8 | 9 | 10 | 11 | 12 | 13 | 14 | 15 | 16 |
|---|---|---|---|---|---|---|---|---|---|---|---|---|---|---|---|---|---|
| CYCLE OF CK | | 1 | 2 | 3 | 4 | 5 | 6 | 7 | 8 | 9 | 10 | 11 | 12 | 13 | 14 | 15 | 16 |
| OUTPUT FROM COUNTER | 1 BIT | 0 | 1 | 0 | 1 | 0 | 1 | 0 | 1 | 0 | 1 | 0 | 1 | 0 | 1 | 0 | 1 |
| | 2 BIT | 0 | 0 | 1 | 1 | 0 | 0 | 1 | 1 | 0 | 0 | 1 | 1 | 0 | 0 | 1 | 1 |
| | 3 BIT | 0 | 0 | 0 | 0 | 1 | 1 | 1 | 1 | 0 | 0 | 0 | 0 | 1 | 1 | 1 | 1 |
| | 4 BIT | 0 | 0 | 0 | 0 | 0 | 0 | 0 | 0 | 1 | 1 | 1 | 1 | 1 | 1 | 1 | 1 |
| | 5 BIT | 0 | 0 | 0 | 0 | 0 | 0 | 0 | 0 | 0 | 0 | 0 | 0 | 0 | 0 | 0 | 0 |
| $RWL_i$ | | 0 | 1 | 2 | 3 | 4 | 5 | 6 | 7 | 8 | 9 | 10 | 11 | 12 | 13 | 14 | 15 |
| $\phi_{t0}$ | | 1 | 0 | 0 | 0 | 1 | 0 | 0 | 0 | 1 | 0 | 0 | 0 | 1 | 0 | 0 | 0 |
| $\phi_{t1}$ | | 0 | 1 | 0 | 0 | 0 | 1 | 0 | 0 | 0 | 1 | 0 | 0 | 0 | 1 | 0 | 0 |
| $\phi_{t2}$ | | 0 | 0 | 1 | 0 | 0 | 0 | 1 | 0 | 0 | 0 | 1 | 0 | 0 | 0 | 1 | 0 |
| $\phi_{t3}$ | | 0 | 0 | 0 | 1 | 0 | 0 | 0 | 1 | 0 | 0 | 0 | 1 | 0 | 0 | 0 | 1 |
| $\phi_{t4}$ | | 1 | 0 | 0 | 0 | 1 | 0 | 0 | 0 | 1 | 0 | 0 | 0 | 1 | 0 | 0 | 0 |
| $\phi_{t5}$ | | 0 | 1 | 0 | 0 | 0 | 1 | 0 | 0 | 0 | 1 | 0 | 0 | 0 | 1 | 0 | 0 |
| $\phi_{t6}$ | | 0 | 0 | 1 | 0 | 0 | 0 | 1 | 0 | 0 | 0 | 1 | 0 | 0 | 0 | 1 | 0 |
| $\phi_{t7}$ | | 0 | 0 | 0 | 1 | 0 | 0 | 0 | 1 | 0 | 0 | 0 | 1 | 0 | 0 | 0 | 1 |
| | | | | | | | | | | | | | | | | | |
| $WL_0$ | | 0→1 | 1 | 1 | 1 | 1 | 1 | 1 | 1 | 1 | 1 | 1 | 1 | 1 | 1 | 1 | 1 |
| $WL_1$ | | 0 | 0 | 0 | 0 | 1 | 1 | 1 | 1 | 1 | 1 | 1 | 1 | 1 | 1 | 1 | 1 |
| $WL_2$ | | 0 | 0 | 0 | 0 | 0 | 0 | 0 | 0 | 1 | 1 | 1 | 1 | 1 | 1 | 1 | 1 |
| $WL_3$ | | 0 | 0 | 0 | 0 | 0 | 0 | 0 | 0 | 0 | 0 | 0 | 0 | 1 | 1 | 1 | 1 |

F I G. 49

| CYCLE OF CK | | 17 | 18 | 19 | 20 | 21 | 22 | 23 | 24 | 25 | 26 | 27 | 28 | 29 | 30 | 31 | 32 |
|---|---|---|---|---|---|---|---|---|---|---|---|---|---|---|---|---|---|
| OUTPUT FROM COUNTER | 1 BIT | 0 | 1 | 0 | 1 | 0 | 1 | 0 | 1 | 0 | 1 | 0 | 1 | 0 | 1 | 0 | 1 |
| | 2 BIT | 0 | 0 | 1 | 1 | 0 | 0 | 1 | 1 | 0 | 0 | 1 | 1 | 0 | 0 | 1 | 1 |
| | 3 BIT | 0 | 0 | 0 | 0 | 1 | 1 | 1 | 1 | 0 | 0 | 0 | 0 | 1 | 1 | 1 | 1 |
| | 4 BIT | 0 | 0 | 0 | 0 | 0 | 0 | 0 | 0 | 1 | 1 | 1 | 1 | 1 | 1 | 1 | 1 |
| | 5 BIT | 1 | 1 | 1 | 1 | 1 | 1 | 1 | 1 | 1 | 1 | 1 | 1 | 1 | 1 | 1 | 1 |
| $RWL_i$ | | 15 | 14 | 13 | 12 | 11 | 10 | 9 | 8 | 7 | 6 | 5 | 4 | 3 | 2 | 1 | 0 |
| $\phi_{t0}$ | | 0 | 0 | 0 | 1 | 0 | 0 | 0 | 1 | 0 | 0 | 0 | 1 | 0 | 0 | 0 | 1 |
| $\phi_{t1}$ | | 0 | 0 | 1 | 0 | 0 | 0 | 1 | 0 | 0 | 0 | 1 | 0 | 0 | 0 | 1 | 0 |
| $\phi_{t2}$ | | 0 | 1 | 0 | 0 | 0 | 1 | 0 | 0 | 0 | 1 | 0 | 0 | 0 | 1 | 0 | 0 |
| $\phi_{t3}$ | | 1 | 0 | 0 | 0 | 1 | 0 | 0 | 0 | 1 | 0 | 0 | 0 | 1 | 0 | 0 | 0 |
| $\phi_{t4}$ | | 0 | 0 | 0 | 1 | 0 | 0 | 0 | 1 | 0 | 0 | 0 | 1 | 0 | 0 | 0 | 1 |
| $\phi_{t5}$ | | 0 | 0 | 1 | 0 | 0 | 0 | 1 | 0 | 0 | 0 | 1 | 0 | 0 | 0 | 1 | 0 |
| $\phi_{t6}$ | | 0 | 1 | 0 | 0 | 0 | 1 | 0 | 0 | 0 | 1 | 0 | 0 | 0 | 1 | 0 | 0 |
| $\phi_{t7}$ | | 1 | 0 | 0 | 0 | 1 | 0 | 0 | 0 | 1 | 0 | 0 | 0 | 1 | 0 | 0 | 0 |
| | | | | | | | | | | | | | | | | | |
| $WL_0$ | | 1 | 1 | 1 | 1 | 1 | 1 | 1 | 1 | 1 | 1 | 1 | 1 | 1 | 1 | 1 | 1→0 |
| $WL_1$ | | 1 | 1 | 1 | 1 | 1 | 1 | 1 | 1 | 1 | 1 | 1 | 1 | 0 | 0 | 0 | 0 |
| $WL_2$ | | 1 | 1 | 1 | 1 | 1 | 1 | 1 | 1 | 0 | 0 | 0 | 0 | 0 | 0 | 0 | 0 |
| $WL_3$ | | 1 | 1 | 1 | 1 | 0 | 0 | 0 | 0 | 0 | 0 | 0 | 0 | 0 | 0 | 0 | 0 |

FIG. 50